# EUROPEAN PATENT SPECIFICATION

(11) **EP 2 740 557 B1**
(45) Date of publication and mention of the grant of the patent: **23.01.2019**
(21) Application number: 12861048.2
(22) Date of filing: 02.08.2012
(51) Int. Cl.: B23K 1/00, B23K 1/20, B23K 3/06, B23K 3/08, H05K 3/24, H05K 3/34

(54) **METHOD OF MANUFACTURING A COMPONENT HAVING ELECTRODE DISSOLUTION PREVENTION LAYER**
HERSTELLUNGSVERFAHREN FÜR BAUELEMENT MIT ELEKTRODENAUFLÖSUNGSVERHINDERUNGSSCHICHT
PROCÉDÉ DE FABRICATION D'UN COMPOSANT AYANT UNE COUCHE DE PRÉVENTION DE DISSOLUTION D'ÉLECTRODE

(43) Date of publication of application: 11.06.2014
(73) Proprietor: Tanigurogumi Corporation, Nasushiobara City Tochigi 329-2921 (JP)
(72) Inventor: TANIGURO, Katsumori, Nasushiobara-shi Tochigi 329-2921 (JP); WATANABE, Genzo, Utsunomiya-shi Tochigi 320-0035 (JP)
(74) Representative: Klunker IP Patentanwälte PartG mbB
(86) International application number: PCT/JP2012/069773
(87) International publication number: WO 2014/020751

(56) References cited:
- WO-A1-2011/018861
- JP-A- H0 794 853
- JP-A- 2009 260 191
- JP-A- 2011 054 892
- JP-A- 2011 233 879

## Description

### Field of the Invention

The present invention relates to a method for manufacturing a component having an electrode corrosion preventing layer. More particularly, the invention relates to a method for manufacturing a component (such as a substrate or a mounting component) in which an electrode corrosion preventing layer is formed on electrodes of a substrate such as a printed circuit board, a wafer, or a flexible substrate or on electrodes of a mounting component such as a chip, a resistor, a capacitor, or a filter.

### Background Art

In recent years, wiring density and mounting density on substrates such as printed circuit boards, wafers, and flexible substrates (which may be hereinafter referred to as "mounting substrates") have been further improved. The mounting substrate has many electrodes for soldering electronic components. On the electrodes are formed solder (which may be hereinafter referred to as "connection solder"), such as solder bumps, to which the electronic components are soldered and solder paste. The electronic components is mounted on the mounting substrate by soldering on the connection solder.

Connection solder are in micro-size and uniform in shape, size, and the like. It is required that the connection solder be formed only at necessary portions. As a connection solder formation method satisfying such a requirement, JP1998-286936A has proposed a technique and the like for easily forming minute and uniform bumps by using a screen plate provided with openings for forming paste bumps with a paste and characterized in that it includes a rigid first metal layer, a resin-based adhesive layer, and a second metal layer, and the openings of the adhesive layer and the second layer have a smaller diameter than that of the opening of the first metal layer.

WO 2011/018861 A1 discloses a method for forming a solder on an electrode, wherein a solder precoat film is formed on the electrode. The electrode is brought into contact with a high-temperature organic fatty acid solution, so that an oxidized layer on the surface of the electrode is removed to clean the surface and a protection coat made of an organic fatty acid is formed on the cleaned surface. Then, molten solder is adhered onto the electrode. Finally, high-temperature organic fatty acid solution is sprayed onto the electrode to remove excessive solder.

Meanwhile, in an electronic component such as a connector, a QFP (Quad Flat Package), an SOP (Small Outline Package), or a BGA (Ball Grid Array), sizes of connecting terminals, such as lead terminals, can vary. To solder electronic components with connection terminals having varied sizes without any soldering failure, it is necessary to reduce the influence of size variation in the electronic components by increasing the thickness of "connection solder" formed on a mounting substrate. When a compact electronic component such as a CSP (Chip Size Package) is among electronic components mounted on a mounting substrate, the size of the connection solder for such a compact electronic component is very small and minute.

As a typical method for forming connection solder, there is known a method of directly dipping (immersing) a mounting substrate provided with copper electrodes and the like in a molten solder. When solder comes into contact with a copper electrode, the copper combines with tin contained in the solder in order to produce a Cu-Sn intermetallic compound. Producing the Cu-Sn intermetallic compound is the basis of the solder joint. However, the phenomenon for forming the connection solder is caused in a manner that the copper electrodes are corroded by the tin in the solder, which is thus sometimes called "electrode corrosion." Such electrode corrosion can reduce reliability on copper electrodes as electrical joints and thereby can deteriorate reliability on a mounting substrate.
Accordingly, it is necessary to shorten the time for dipping a mounting substrate in a molten solder in order to suppress electrode corrosion. Therefore, there has been considered a method (a dipping method) in which a spare solder layer is formed on copper electrodes on a mounting substrate and then the mounting substrate is dipped in a molten solder.

### Summary of the Invention

### The Problems Solved by the Invention

Of the methods for forming connection solder described above, the method for forming the connection solder using a screen plate has a problem of poor productivity. Further, the method for forming the connection solder by the dipping method causes a difference in electrode corrosion between a first dipping (immersing) portion and a final dipping portion, thereby causing a difference in reliability on copper electrodes between respective portions of the same substrate. Therefore, the problem of the electrode corrosion has not been able to be solved yet.

The present invention has been accomplished to solve the above problems. It is an object of the present invention to provide a method for manufacturing a component (such as a substrate or a mounting component) having "a corrosion preventing layer for electrodes" (hereinafter referred to as "electrode corrosion preventing layer"), which component allows low-cost, high-yield and highly reliable soldering .

### Problem Resolution Means

(1) To solve the above-discussed problems, a method for manufacturing a component as defined in claim 1 is provided. The method for manufacturing a component according to the present invention includes: a step of preparing a component having an electrode that is to be soldered; a step of contacting a first organic fatty acid-containing solution with the electrode; a step of adhering a first molten solder onto the electrode by contacting the first molten solder with the electrode; a step of ejecting a gas flow to the adhered first molten solder to remove an excess first molten solder in the first molten solder adhered onto the electrode; and a step of cooling the electrode from which the excess first molten solder has been removed to less than a melting point of the first molten solder, and wherein in the step of adhering the first molten solder, the first molten solder includes a component forming an electrode corrosion preventing layer made of an intermetallic compound layer on a surface of the electrode by reacting with a component included in the electrode, and the contact of the first molten solder with the electrode is performed by allowing a liquid flow of the first molten solder to collide with or spread over the electrode while moving the component.

According to the present invention, in the step of adhering a first molten solder, the first molten solder includes a component (hereinafter also referred to as "an electrode corrosion preventing layer component") forming an electrode corrosion preventing layer made of an intermetallic compound layer on a surface of the electrode by reacting with a component included in the electrode. Therefore, the electrode corrosion preventing layer, which is formed by the intermetallic compound layer, is formed on the surface of the electrode when contacting the electrode corrosion preventing layer component with the electrode.
Because the intermetallic compound layer can suppress the elution of an electrode component as an electrode corrosion preventing layer, defect and deletion of electrode based on the corrosion of electrode can be prevented.
(ii) In the step of adhering the first molten solder, while moving the component, the contacting the first molten solder with the electrode is performed by allowing first molten solder liquid flow to collide with or spread over the component. Accordingly, in either case, first molten solder is adhered uniformly on the electrode. As a result, since the electrode corrosion preventing layer is formed uniformly on the electrode, defect and deletion of the electrode can be prevented by the electrode corrosion preventing layer.
(iii) Further, the step of contacting the first organic fatty acid-containing solution with the electrode is performed before the contact of the electrode with first molten solder. Accordingly, the first organic fatty acid-containing solution serves to remove an oxide, an impurity, or the like present on the surface of the electrode. As a result, in the state in which the presence of such an oxide, impurity, or the like on the surface of the electrode has been maximally suppressed, the first molten solder can be contacted with the surface of the electrode. With the treatment as above, the electrode corrosion preventing layer can be formed on the cleaned electrode surface with a uniform thickness where the occurrence of a void or defect has been suppressed. Since the electrode corrosion preventing layer is provided in the state of maximally suppressing a void or defect, also on the solder layer provided on the electrode corrosion preventing layer, the occurrence of a void or defect can be further suppressed.
(iv) Further, step of ejecting the gas flow to remove the excess first molten solder adhered onto the electrode is performed. Accordingly, the electrode is provided with the electrode corrosion preventing layer to which the first molten solder or the first solder layer has been slightly adhered. Even when dipped in another molten solder (the second molten solder), he elution of the electrode component due to the second molten solder can be suppressed. In addition, on the electrode surface after removing the excess first molten solder by ejecting the gas flow or the fluid can be formed an organic fatty acid coating film preventing the oxidation of the electrode corrosion preventing layer. As a result, even when not treated immediately, the component can be stored or delivered in the state in which the electrode corrosion preventing layer has been provided on electrodes of the component.
(iv) The step of cooling the electrode where the excess first molten solder has been removed to less than the melting point of the first molten solder is performed. Accordingly, the electrode corrosion preventing layer formed on the surface of the electrode can be made into the electrode corrosion preventing layer having a predetermined thickness range without any crack (for example, an extent of 0.5 µm to 3 µm) for stabilization. Even when the component provided with the electrode corrosion preventing layer as seen from the above is sequentially dipped (immersed) in a solder bath to provide a connection solder on the electrode, a difference in electrode corrosion between a first dipped (immersed) portion and a lastly dipped portion can be minimized. In addition, even when the component provided with a connection solder by dipping is sequentially subjected to a step of mounting an electronic component and exposed to various heating treatments, the electrode corrosion preventing layer serves as a barrier and thus can suppress the corrosion of the electrode in solder due to the heat. As a result, regarding electrodes of individual portions of the same component, a difference in reliability among the portions can be minimized. Therefore, there can be manufactured a component that can provide a high quality connection structure enabling further improvement in the reliability of connection structure in electronic components.

(2) The method for manufacturing a component according to the present invention, the step of adhering the first molten solder is preferably performed by the second embodiment regarding contacting the first molten solder with the electrode. The first embodiment and the third embodiment are disclosed as examples, which are useful for understanding the invention.

In the first embodiment, as contacting means for contacting the first molten solder with the electrode, while moving the component in a vertical direction, the liquid flow of the first molten solder accelerated by gravity or the first molten solder liquid flow pressurized by a pump is allowed to collide with the component at an angle orthogonal or roughly orthogonal to the vertical direction.

While moving the component in the vertical direction, the liquid flow of the first molten solder accelerated by gravity or the liquid flow of the first molten solder pressurized by a pump is allowed to collide with the component at the angle orthogonal or roughly orthogonal to the vertical direction. Thus, without being decelerated by the molten solder itself retained on the electrode, the molten solder liquid flow strongly collides with the electrode from the lateral direction. This consequently allows the first molten solder to be uniformly adhered on the electrode.

In the second embodiment, as contacting means for contacting the first molten solder with the electrode, the first molten solder liquid flow is allowed to collide with the component from above the component at a predetermined angle while moving the component in a lateral direction.

While moving the component in the lateral direction, the liquid flow of the first molten solder is allowed to collide with the component from above the component at a predetermined angle. Thus, the molten solder liquid flow strongly collides with the electrode from the upper direction without being decelerated by the molten solder itself retained on the electrode. This consequently allows the first molten solder to be uniformly adhered on the electrode.

In the third embodiment, as contacting means for contacting the first molten solder with the electrode, the component is allowed to pass through a slit arranged on a liquid surface of the first molten solder while pulling up the component after immersing in a solder bath filled with the first molten solder by moving the component in a vertical direction.

While pulling up the component after immersing in a solder bath filled with the first molten solder by moving the component in the vertical direction, the component is allowed to pass through a slit arranged on a liquid surface of the first molten solder. Accordingly, due to the action of surface tension occurring when the component passes through the slit, the molten solder spreads over the entire region of the electrode. This consequently allows the first molten solder to be uniformly adhered on the electrode.
(3) The method for manufacturing a component according to the present invention, can further include a step of contacting the component with the same molten solder as or a different molten solder from the first molten solder to adhere a second molten solder onto the electrode after the step of cooling the electrode to less than the melting point of the first molten solder.

The method may further include the step of contacting the component with the same molten solder as or a different molten solder from the first molten solder to adhere the second molten solder onto the electrode after the step of cooling the electrode to less than the melting point of the first molten solder. Thus, even when the component is dipped in the bath of the second molten solder, the electrode corrosion preventing layer provided on the electrode can suppress the elution of an electrode component. This can consequently prevent the defects and deletion of the electrode due to electrode corrosion by the second molten solder. According to the present invention as above, reliability of the electrode soldered by the second solder layer formed by solidification of the second molten solder can be ensured, so that there can be manufactured a component capable of providing a high quality connection structure that can further improve the reliability of the connection structure of an electronic component upon soldering of the electronic component to a mounting substrate.
(4) The second molten solder does not preferably include a component causing an electrode corrosion preventing ability among components forming the electrode corrosion preventing layer.

The second molten solder preferably does not include the component causing the electrode corrosion preventing ability among components forming the electrode corrosion preventing layer. Thus, on the previously formed electrode corrosion preventing layer is provided the second solder layer including no component causing the electrode corrosion preventing ability. Such a second solder layer can suppress a phenomenon of a thickness increase in the electrode corrosion preventing layer occurring when a component of the electrode corrosion preventing layer is the same as a component of the second solder layer. This can consequently further improve the reliability of the electrodes included in the component soldered by the second solder layer.
(5) In the method for manufacturing a component according to the present invention, in the step of adhering the first molten solder, the contact of the first molten solder with the electrode is performed in a steam atmosphere of the organic fatty acid-containing solution.

According to the above invention, the electrode is contacted with the first molten solder in the steam atmosphere of the organic fatty acid-containing solution, so that the electrode is neither oxidized nor contaminated by impurities upon contact with the first molten solder.
(6) The first molten solder may have a viscosity of 0.002 Pa•s to 0.004 Pa•s.

The viscosity of first molten solder is in the above range, so that the first molten solder can be uniformly adhered to each electrode formed in a micropattern, allowing a uniform and stable electrode corrosion preventing layer to be formed on the electrode surface. Additionally, since first molten solder has the viscosity in the above range, the first molten solder can be easily removed. As a result, there can be obtained a component formed such that an electrode corrosion preventing layer is uniformly formed on each electrode formed in the micropattern and no extra molten solder is present.
(7)The second molten solder may have a viscosity of 0.002 Pa•s to 0.008 Pa•s.

The second molten solder having an arbitrary viscosity in the above wide range can be contacted with the component having the electrode corrosion preventing layer formed by the contact of the first molten solder with the electrode. Since such a second molten solder includes a general-purpose molten solder, soldering can be performed using a molten solder obtained by melting an inexpensive solder. Even in this case, electrode corrosion can be prevented.
(8) The first molten solder and the second molten solder may be mixed with the organic fatty acid-containing solution for use.

The first molten solder and the second molten solder may be mixed with the organic fatty acid-containing solution for use, so that oxides, impurities and the like contained in those molten solders can be removed. As a result, the viscosities of the molten solders after treatment can be arbitrarily controlled depending on the treatment conditions (such as treatment time). A molten solder with a reduced viscosity exhibits good wetting spreadability, which enables a well-balanced, symmetric solder layer to be formed on the electrode corrosion preventing layer by surface tension.
(9) The method for manufacturing a component according to the present invention can further include a step of contacting a gas or liquid of a third organic fatty acid-containing solution with the second molten solder after the step of adhering the second molten solder.

The method may further include the step of contacting a gas or liquid of the third organic fatty acid-containing solution with the second molten solder after the step of adhering the second molten solder. Thus, on the surface of the second molten solder is formed an organic fatty acid coating film that prevents oxidation and contamination. As a result, the component having the second solder layer formed thereon can be stored or distributed without immediate treatment. In addition, there can be manufactured a component capable of providing a high quality connection structure that can further improve the reliability of the connection structure of an electronic component even when subjected to the step of mounting a mounting component after storage or distribution.
(10) In the method for manufacturing a component according to the present invention, the component can be any selected from a printed circuit board, a wafer, and a flexible substrate that have microwiring patterns or any selected from a chip, a resistor, a capacitor, and a filter.
(11) A component manufactured by the method for manufacturing a component according to the present invention described above may include a plurality of electrodes, each electrode having a solder layer, between the solder layer and the electrode being formed an electrode corrosion preventing layer with a thickness of 0.5 µm to 3 µm, and a soldering form of the solder layer being a hemispherical shape or a curved surface shape symmetric with respect to a center position of the electrode.

### Efficacy of the Invention

According to the method for manufacturing a component of the present invention,
a component having an electrode corrosion preventing layer, which is manufactured by performing the low-cost, high-yield and highly reliable soldering, can be provided.

Even when the manufactured component is sequentially dipped in a solder bath to provide a connection solder on the electrode, a difference in electrode corrosion between a first dipped (immersed) portion and a lastly dipped portion can be minimized. Further, even when the component provided with a connection solder by dipping is sequentially subjected to a step of mounting an electronic component and exposed to various heating treatments, the electrode corrosion preventing layer serves as a barrier and thus can suppress the corrosion of the electrode in solder due to the heat. As a result, regarding electrodes of individual portions of the same component, a difference in reliability among the portions can be minimized. Therefore, there can be manufactured a component that can provide a high quality connection structure enabling further improvement in the reliability of connection structure in electronic components.

### Brief Descriptions of the Drawings

An embodiment of the invention is shown in Figs. 4(A) to 4(F). The other embodiments are to be understood as examples for understanding the invention.
Fig. 1 is a flow chart illustrating an example of a method for manufacturing a component according to the present invention.
Figs. 2(A) and (B) are a surface photograph and a cross-sectional photograph depicting an example of the component, (A) is a photomicrograph depicting a component surface on a BGA side and (B) is an electron micrograph depicting a cross-section of the component.
Figs. 3(A) to 3(F) are schematic cross-sectional views depicting an example of an embodiment in which, while moving the component in a lateral direction, a liquid flow of a first molten solder is allowed to collide with the component from above the component at a predetermined angle, and which embodiment includes step (E) of ejecting a gas or liquid of an organic fatty acid-containing solution.
Figs. 4(A) to 4(F) are schematic cross-sectional views depicting another example of the embodiment in which, while moving the component in the lateral direction, the liquid flow of the first molten solder is allowed to collide with the component from above the component at a predetermined angle, and which embodiment includes step (E) of ejecting an inert gas or gas in a gaseous atmosphere of the organic fatty acid-containing solution.
Fig. 5 is a schematic cross-sectional view depicting an embodiment in which, while moving the component in a vertical direction, a liquid flow of the first molten solder accelerated by gravity is allowed to collide with the component from the lateral direction.
Fig. 6 is a schematic cross-sectional view depicting an embodiment in which, while moving the component in the vertical direction, a first molten solder liquid flow pressurized by a pump is allowed to collide with the component from the lateral direction.
Figs. 7(A) to 7(C) are cross-sectional views depicting an embodiment in which the component is moved in the vertical direction to immerse in a solder bath filled with the first molten solder and then pull up, the component being allowed to pass through a slit arranged on a liquid surface of the first molten solder while being pulled up.
Figs. 8 (A) and (B) are schematic cross-sectional views depicting an example of a component in which an electrode corrosion preventing layer is provided on electrodes and a first solder layer is provided on the electrode corrosion preventing layer.
Figs. 9(A) to 9(D) are electron micrographs of component cross-sections before and after adhesion of the first molten solder, (A) and (B) depict an example before the adhesion and (C) and (D) depict an example after the adhesion.
Figs. 10(A) and (B) are photomicrographs of a conventional example (A, B) obtained by contacting the liquid flow of a molten solder to a component while moving the component in the lateral direction.
Fig. 11 is a schematic view depicting a first embodiment in which a component having an electrode corrosion preventing layer formed on electrodes is immersed in a bath of a second molten solder.
Fig. 12 is a schematic view depicting a second embodiment in which a component having an electrode corrosion preventing layer formed on electrodes is immersed in a bath of the second molten solder where an organic fatty acid-containing solution is located in an upper layer.
Fig. 13 is a schematic cross-sectional view depicting an example of a component having a solder layer provided on an electrode corrosion preventing layer.
Figs. 14(A) and (B) are illustrative views of cross-sectional shapes of a solder layer provided on an electrode corrosion preventing layer, (A) is an example of a cross-sectional shape of a solder layer provided to cover an electrode provided on a substrate and (B) is an example of a cross-sectional shape of a solder layer provided on an electrode embedded in a substrate.
Figs. 15(A) and (B) are illustrative views of planar shapes of a solder layer provided on an electrode corrosion preventing layer, (A) is an example of a planar shape of a solder layer provided on a circular electrode and (B) is an example of a planar shape of a solder layer provided on a rectangular electrode.
Fig. 16 is a scanning tunneling micrograph depicting an example of a shape of a solder layer provided on an electrode corrosion preventing layer.
Figs. 17(A) to 17(C) are scanning tunneling micrographs depicting an example of cross-sectional shapes of the solder layer provided on the electrode corrosion preventing layer.
Fig. 18(A) is a perspective view and Fig. 18(B) a cross-sectional view depicting an example of a manufactured component.
Figs. 19(A) and (B) are perspective views and depicting other manufactured component examples.
Fig. 20 is a graph depicting amounts of oxygen in a depth direction of a solder layer.
Figs. 21 are examples of the occurrence form of microvoids after heating a soldered copper electrode portion, in which (A) and (B) are the results of a Comparative Example and (C) and (D) are results of an Example.
Figs. 22(A) and (B) are electron micrographs depicting a cross-sectional shape where an electrode corrosion preventing layer, a solder layer, and an organic fatty acid coated film are provided in this order on micro copper electrodes of a substrate, and element mapping images of the cross-sectional shape.
Fig. 23 is a photograph depicting a conventional example in which a solder layer has been provided on electrodes.
Figs. 24(A) to 24(D) are a plan view depicting electrode patterns before soldering treatment, cross-sectional views and of the electrode patterns, and a cross-sectional view of the electrode.

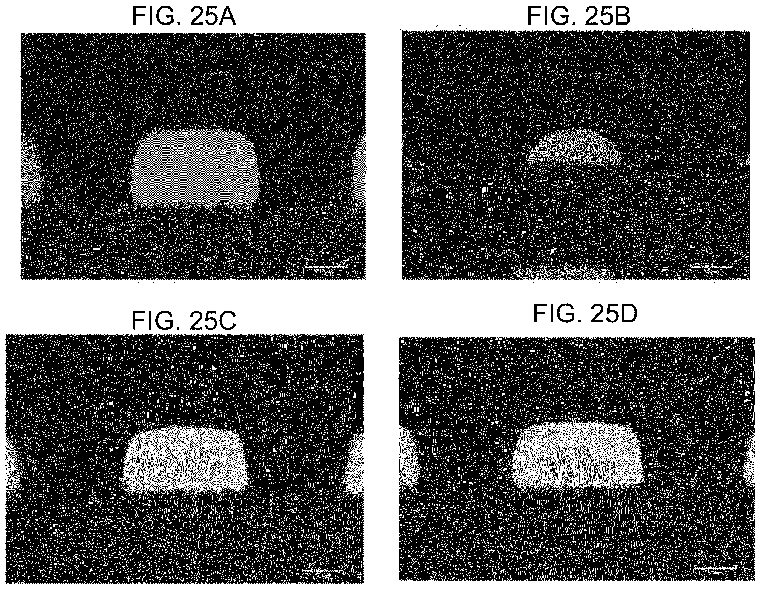

Figs. 25(A) to 25(D) are cross-sectional views of electrodes depicting examples of cases without performing a two-stage soldering treatment, (A) is a cross-sectional view of an electrode treated with a molten solder including no nickel for 5 seconds, (B) is a cross-sectional view of an electrode treated with the molten solder including no nickel for 60 seconds, (C) is a cross-sectional view of an electrode treated with a molten solder including 0.01% by mass of nickel for 5 seconds, and (D) is a cross-sectional view of an electrode treated with the molten solder including 0.01% by mass of nickel for 60 seconds.

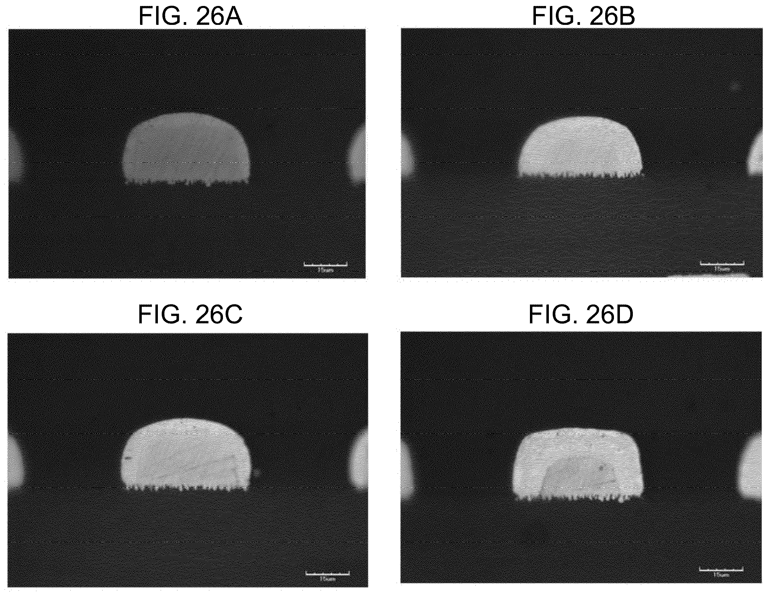

Figs. 26(A) to 26(D) are cross-sectional views of electrodes depicting examples of cases without performing the two-stage soldering treatment, (A) is a cross-sectional view of an electrode treated with a molten solder including 0.03% by mass of nickel for 5 seconds, (B) is a cross-sectional view of an electrode treated with the molten solder including 0.03% by mass of nickel for 60 seconds, (C) is a cross-sectional view of an electrode treated with a molten solder including 0.05% by mass of nickel for 5 seconds, and (D) is a cross-sectional view of an electrode treated with the molten solder including 0.05% by mass of nickel for 60 seconds.
Figs. 27(A) and (B) are cross-sectional views of electrodes depicting examples of cases without performing the two-stage soldering treatment, (A) is cross-sectional view of an electrode treated with a molten solder including 0.1% by mass of nickel for 5 seconds and (B) is a cross-sectional view of an electrode treated with the molten solder including 0.1% by mass of nickel for 60 seconds.

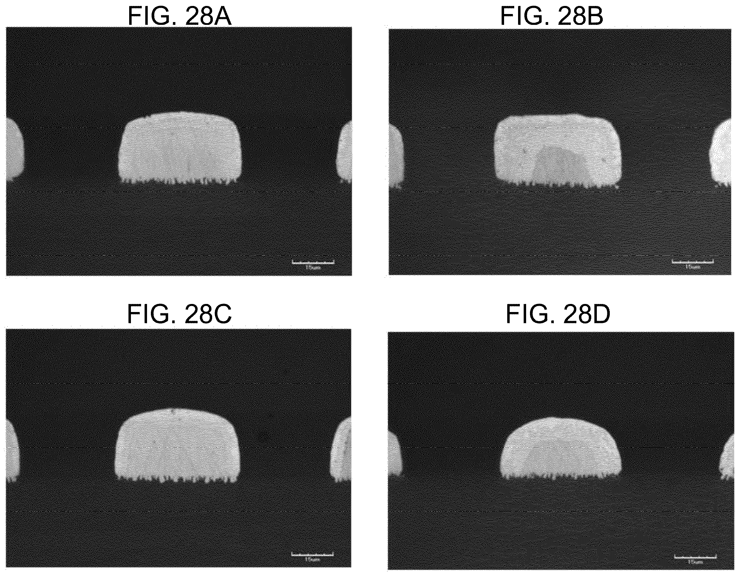

Figs. 28(A) to 28(D) are cross-sectional views of electrodes depicting examples of cases performing the two-stage soldering treatment, (A) is a cross-sectional view of an electrode treated with a molten solder including no nickel for 3 seconds and then treated with a molten solder including 0.01% by mass of nickel for 5 seconds, (B) is a cross-sectional view of an electrode treated with a molten solder including no nickel for 3 seconds and then treated with a molten solder including 0.01% by mass of nickel for 60 seconds, (C) is a cross-sectional view of an electrode treated with a molten solder including no nickel for 3 seconds and then treated with a molten solder including 0.03% by mass of nickel for 5 seconds, and (D) is a cross-sectional view of an electrode treated with a molten solder including no nickel for 3 seconds and then treated with a molten solder including 0.03% by mass of nickel for 60 seconds.

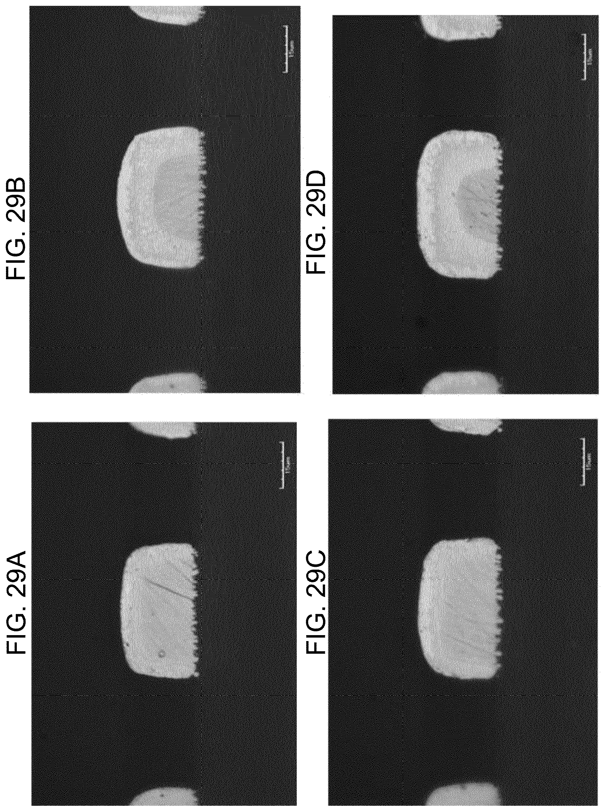

Figs. 29(A) to 29(D) are cross-sectional views of electrodes depicting examples of cases performing the two-stage soldering treatment, (A) is a cross-sectional view of an electrode treated with a molten solder including no nickel for 3 seconds and then treated with a molten solder including 0.05% by mass of nickel for 5 seconds, (B) is a cross-sectional view of an electrode treated with a molten solder including no nickel for 3 seconds and then treated with the molten solder including 0.05% by mass of nickel for 60 seconds, (C) is a cross-sectional view of an electrode treated with a molten solder including no nickel for 3 seconds and then treated with a molten solder including 0.1% by mass of nickel for 5 seconds, and (D) is a cross-sectional view of an electrode treated with a molten solder including no nickel for 3 seconds and then treated with the molten solder including 0.1% by mass of nickel for 60 seconds.

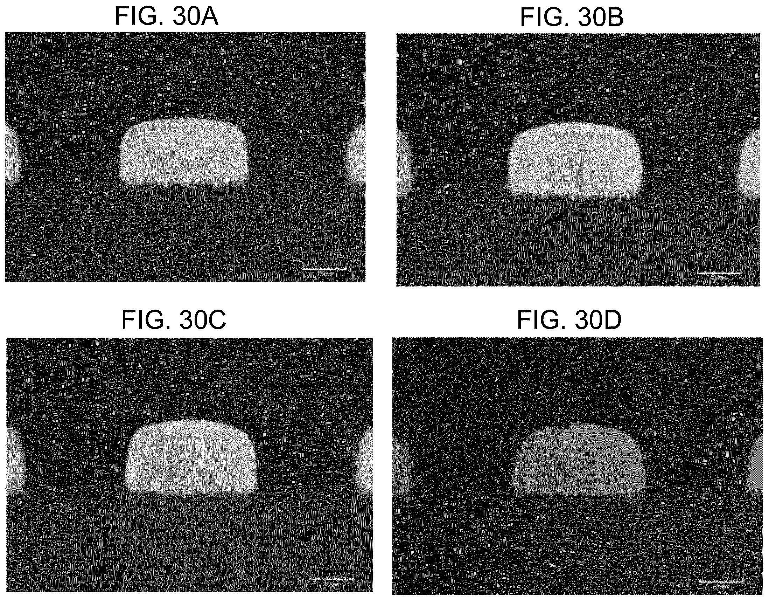

Figs. 30(A) to 30(D) are cross-sectional views of electrodes depicting examples of cases performing the two-stage soldering treatment, (A) is a cross-sectional view of an electrode treated with a molten solder including 0.1% by mass of nickel for 3 seconds and then treated with a molten solder including 0.01% by mass of nickel for 5 seconds, (B) is a cross-sectional view of an electrode treated with the molten solder including 0.1% by mass of nickel for 3 seconds and then treated with the molten solder including 0.01% by mass of nickel for 60 seconds, (C) is a cross-sectional view of an electrode treated with a molten solder including 0.1% by mass of nickel for 3 seconds and then treated with a molten solder including 0.03% by mass of nickel for 5 seconds, and (D) is a cross-sectional view of an electrode treated with a molten solder including 0.1% by mass of nickel for 3 seconds and then treated with the molten solder including 0.03% by mass of nickel for 60 seconds.
Figs. 31 are cross-sectional views of electrodes depicting examples of cases performing the two-stage soldering treatment, in which (A) is a cross-sectional view of an electrode treated with a molten solder including 0.1% by mass of nickel for 3 seconds and then treated with a molten solder including 0.05% by mass of nickel for 5 seconds, and (B) is a cross-sectional view of an electrode treated with a molten solder including 0.1% by mass of nickel for 3 seconds and then treated with a molten solder including 0.05% by mass of nickel for 60 seconds .
Figs. 32(A) and (B) are cross-sectional views of electrodes depicting examples of cases performing the two-stage soldering treatment, in which (A) is a cross-sectional view of an electrode treated with a molten solder including 0.1% by mass of nickel for 3 seconds and then treated with a molten solder including no nickel for 5 seconds, and (B) is a cross-sectional view of an electrode treated with a molten solder including 0.1% by mass of nickel for 3 seconds and then treated with the molten solder including no nickel for 60 seconds.

### Embodiments of the Invention

Hereinafter, a description will be given of a method according to the present invention with reference to the drawings. In the present application, the term "present invention" can be translated into "embodiment of the present application". In addition, the term "electrode corrosion preventing layer" means a layer functioning to suppress the corrosion of a part or all of components forming an electrode (a state in which electrode component(s) is(are) diffused and eluted) due to solder.

### [Method for Manufacturing Component]

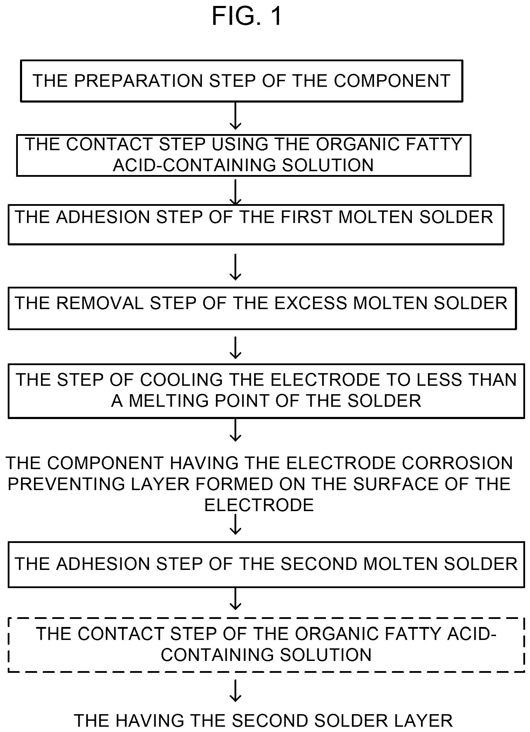

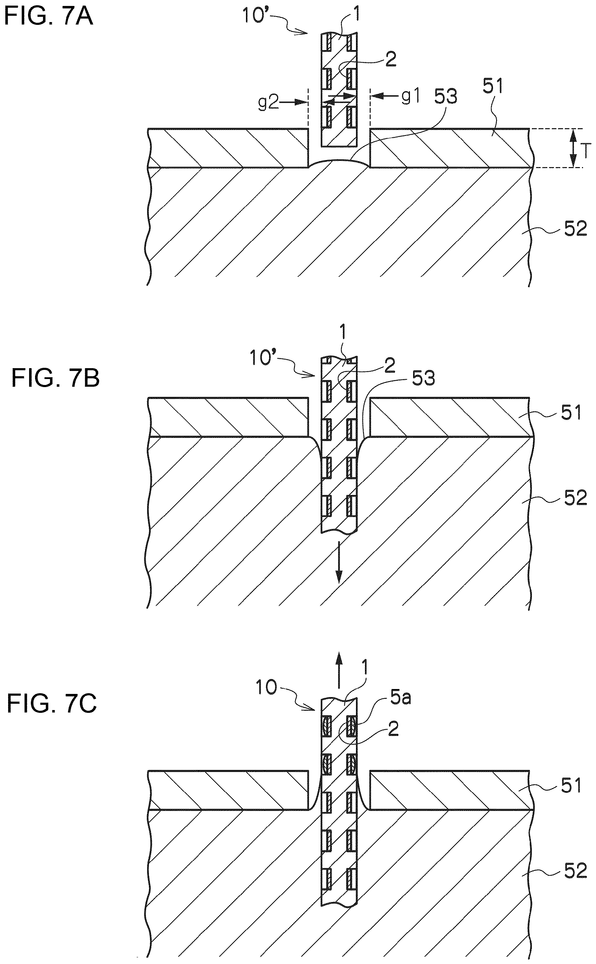

A method for producing component 10 includes, as shown in FIGs. 1 to 7(C), a step of preparing component 10' having electrode 2 that is to be soldered, a step of contacting first organic fatty acid-containing solution 3a to electrode 2, a step of contacting first molten solder 5a to electrode 2 to adhere first molten solder 5a onto electrode 2, a step of ejecting fluid 6a or gas flow 14 to the adhered first molten solder 5a to remove an excess first molten solder 5a of first molten solder 5a adhered onto electrode 2, and a step of cooling electrode 2 from which the excess first molten solder 5a has been removed to less than a melting point of first molten solder 5a. In addition, the method therefor is characterized in that, in the step of adhering first molten solder 5a, first molten solder 5a includes a component for forming electrode corrosion preventing layer 4 made of an intermetallic compound layer on a surface of electrode 2 by reacting with a component included in electrode 2 and the contact of first molten solder 5a to electrode 2 is performed by allowing a liquid flow of first molten solder 5a to collide with or spread over electrode 2 while moving component 10'.

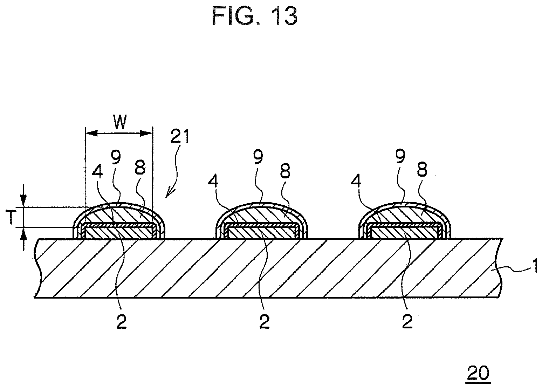

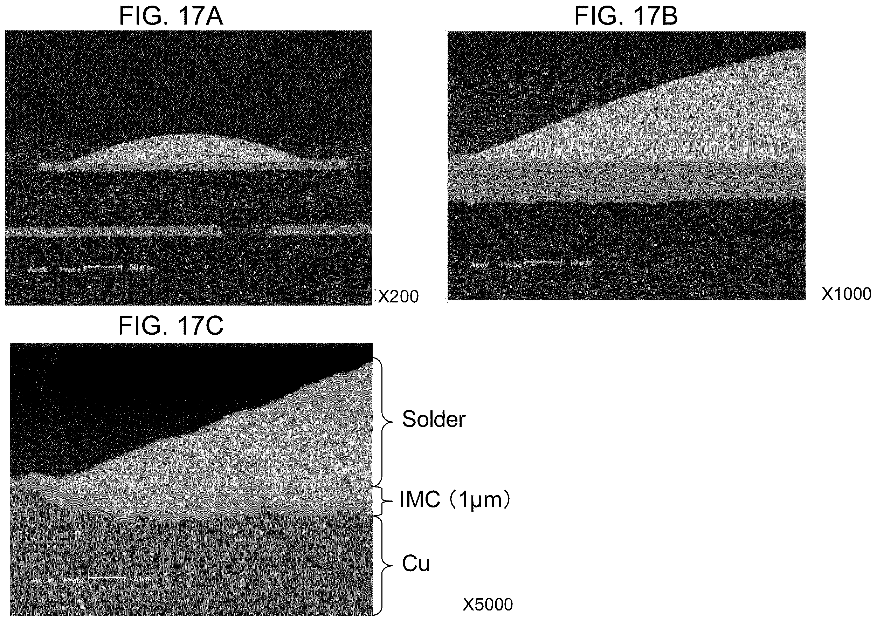

The method for manufacturing component 10 thus performed provides the following advantageous effects (i) to (v). Additionally, the liquid flow of the first molten solder is also represented by reference numeral "5a", and, in this case, is referred to as "first molten solder liquid flow 5a".
(i) In the step of adhering first molten solder 5a, first molten solder 5a includes a component (electrode corrosion preventing layer-forming component) that forms electrode corrosion preventing layer 4 made of an intermetallic compound layer on the surface of electrode 2 by reacting with a component included in electrode 2. Accordingly, upon the contact, the component included in first molten solder 5a reacts with the component included in electrode 2 to form electrode corrosion preventing layer 4 made of the intermetallic compound layer on the surface of electrode 2. The intermetallic compound layer, as electrode corrosion preventing layer 4, can suppress the elution of the electrode component and therefore can prevent defect and deletion of electrode 2 due to the corrosion of electrode 2.
(ii) Additionally, in the step of adhering first molten solder 5a, while moving component 10', the adhesion is performed by allowing first molten solder liquid flow 5a to collide with or spread over component 10'. Accordingly, in either case, first molten solder 5a is adhered uniformly on electrode 2. As a result, since electrode corrosion preventing layer 4 is formed uniformly on electrode 2, defect and deletion of electrode 2 can be prevented by electrode corrosion preventing layer 4.
(iii) The method includes the step of contacting first organic fatty acid-containing solution 3a with electrode 2 before the contact of electrode 2 with first molten solder 5a. Accordingly, the first organic fatty acid-containing solution 3a serves to remove an oxide, an impurity, or the like present on the surface of electrode 2. As a result, in the state in which the presence of such an oxide, impurity, or the like on the surface of electrode 2 has been maximally suppressed, first molten solder 5a can be contacted to the surface of electrode 2. With the treatment as above, electrode corrosion preventing layer 4 can be formed on the cleaned electrode surface with a uniform thickness where the occurrence of a void or defect has been suppressed. Since electrode corrosion preventing layer 4 is provided in the state of maximally suppressing a void or defect, also on solder layer 8 (see FIGs. 13, 17(A) to (C), and the like) provided on electrode corrosion preventing layer 4, the occurrence of a void or defect can be further suppressed.
(iv) The method includes the step of ejecting gas flow 14 or fluid 6a to remove the excess first molten solder 5a adhered onto electrode 2. Accordingly, electrode 2 is provided with electrode corrosion preventing layer 4 to which first molten solder 5a or first solder layer 5 has been slightly adhered. Even when dipped in another molten solder (second molten solder 16) after that, electrode 2 provided with electrode corrosion preventing layer 4 can suppress the elution of the electrode component due to second molten solder 16. In addition, on the electrode surface after removing the excess first molten solder 5a by ejecting gas flow 14 or fluid 6a can be formed organic fatty acid coating film 6 preventing the oxidation of electrode corrosion preventing layer 4. As a result, even when not treated immediately, the component can be stored or delivered in the state in which electrode corrosion preventing layer 4 has been provided on electrodes of the component.
(v) The method includes the step of cooling electrode 2 where the excess first molten solder 5a has been removed to less than the melting point of first molten solder 5a. Accordingly, electrode corrosion preventing layer 4 formed on the surface of electrode 2 can be made into electrode corrosion preventing layer 4 having a predetermined thickness range without any crack (for example, an extent of 0.5 to 3 µm) for stabilization. Even when component 10 provided with electrode corrosion preventing layer 4 thus formed is sequentially dipped (immersed) in a solder bath to provide a connection solder (solder layer 8 for bonding an electronic component; see Figs. 13, 17, and the like) on electrode 2, a difference in electrode corrosion between a first dipped (immersed) portion and a lastly dipped portion can be minimized. In addition, even when component 20 provided with a connection solder (which is defined the same as solder layer, and the same shall apply hereinafter) by dipping is sequentially subjected to a step of mounting an electronic component and exposed to various heating treatments, the electrode corrosion preventing layer serves as a barrier and thus can suppress the corrosion of the electrode in solder due to the heat. As a result, regarding electrodes of individual portions of the same component, a difference in reliability among the portions can be minimized. Therefore, there can be manufactured a component that can provide a high quality connection structure enabling further improvement in the reliability of connection structure in electronic components.

Hereinafter, the individual steps providing the above-described advantageous effects will be described in detail.

### <Preparation Step>

The preparation step is a step of preparing component 10' having electrode 2 that is to be soldered, as shown in FIGs. 1, 2(A) and (B), 3(A), 4(A), 9(A) and (B), and FIGs. 24 (A) to (D).

### (Component)

Component 10' is not particularly limited as long as it is a component where electrode 2 has been provided in an arbitrary shape on substrate 1. Examples of component 10' include substrates (also referred to as "mounting substrates") such as a printed circuit board, a wafer, and a flexible substrate, and electronic components such as connectors, QFP (Quad Flat Package), SOP (Small Outline Package), BGA (Ball Grid Array), LGA (Land Grid Array), semiconductor chips, chip resistors, chip capacitors, and jumper lead wires. In addition, examples thereof also include known substrates and electronic components other than those exemplified herein, as well as novel substrates and electronic components that will be developed in the future.

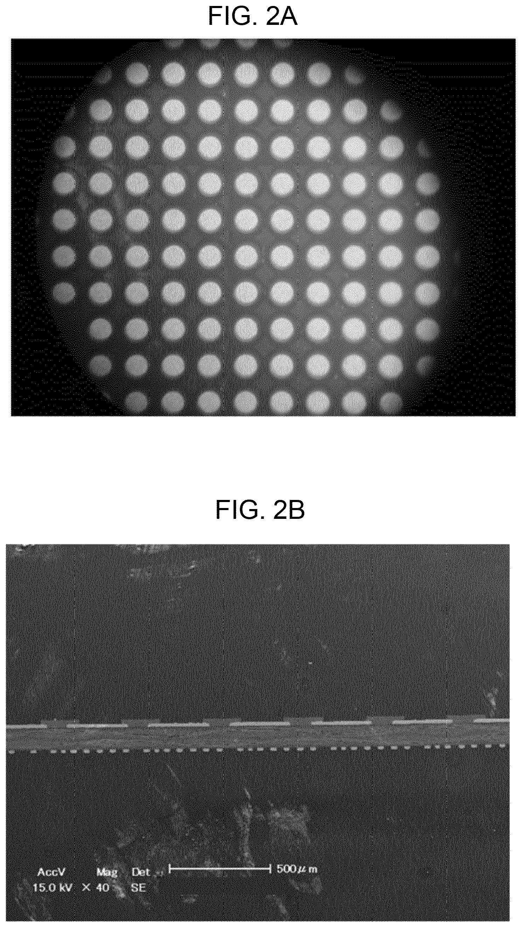

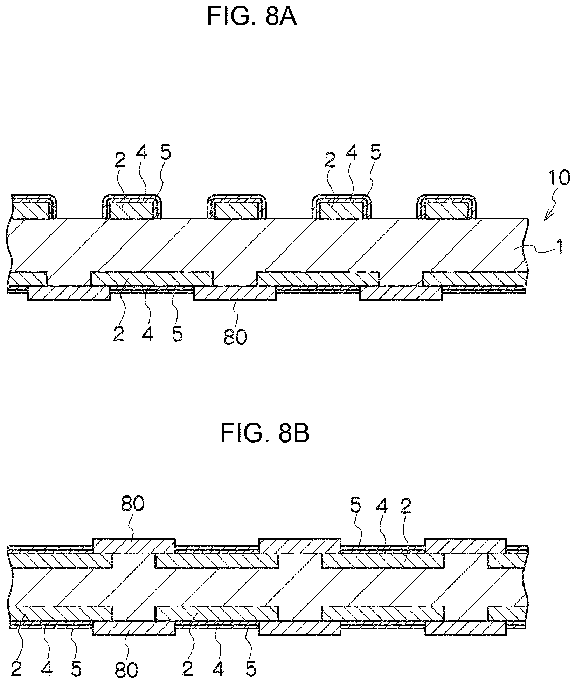

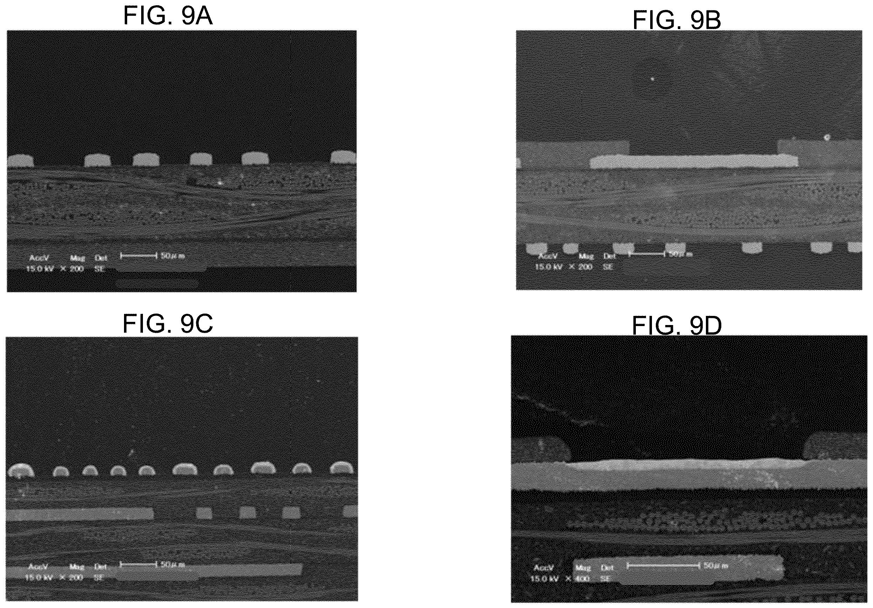

Specific examples of component 10' include components shown in FIGs. 2(A) and (B), FIGs. 9 (A) and (B), FIGs. 24(A) to (D), and the like. The component 10' has electrode 2 on both sides thereof. In an electrode configuration on a BGA side, electrode patterns are formed using insulation film 80, as shown in FIG. 8(B) and FIG. 9(B), in which electrode 2 is provided at the bottom of a recess in an opening portion of insulation film 80. On the other hand, in an electrode configuration on a wiring pattern side, as shown in FIG. 8(A) and FIG. 9(A), electrodes 2 are provide in a protruding manner on substrate 1. In the present invention, in both such different electrode configurations, electrode corrosion preventing layer 4 can be uniformly formed, and additionally, second solder layer 8 can be formed on electrode corrosion preventing layer 4. First solder layer 5 is actually adhered with a thin thickness on electrode corrosion preventing layer 4 from which excess first molten solder 5a has been removed. In the present specification, according to need, the first solder layer 5 is omitted, also in the drawings, or explained. In addition, insulation film 80 can be translated into a solder resist film.

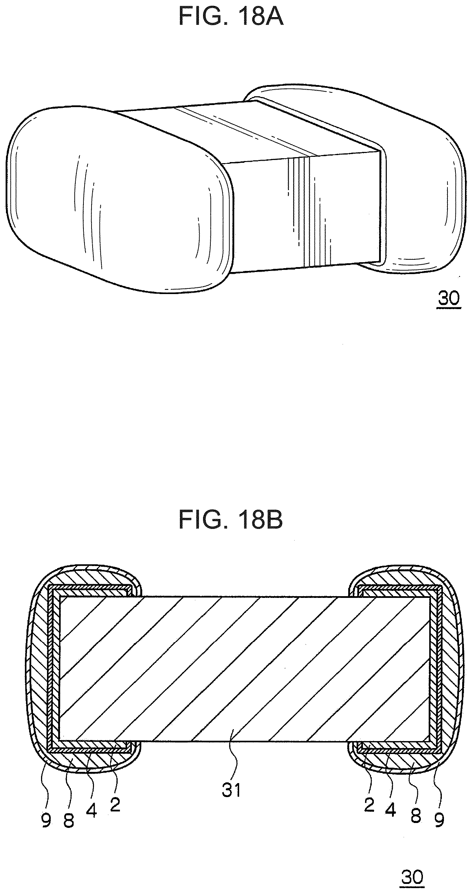

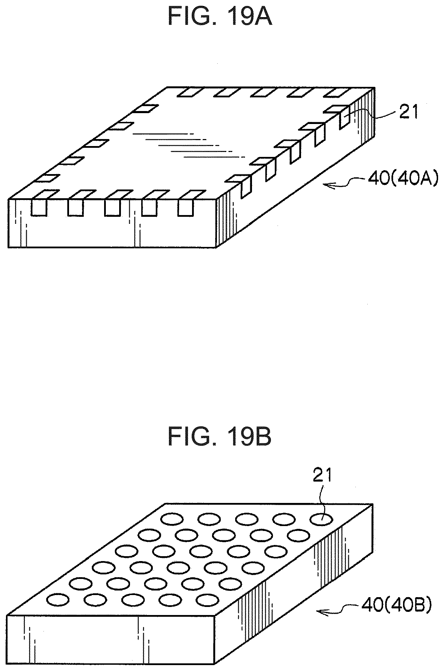

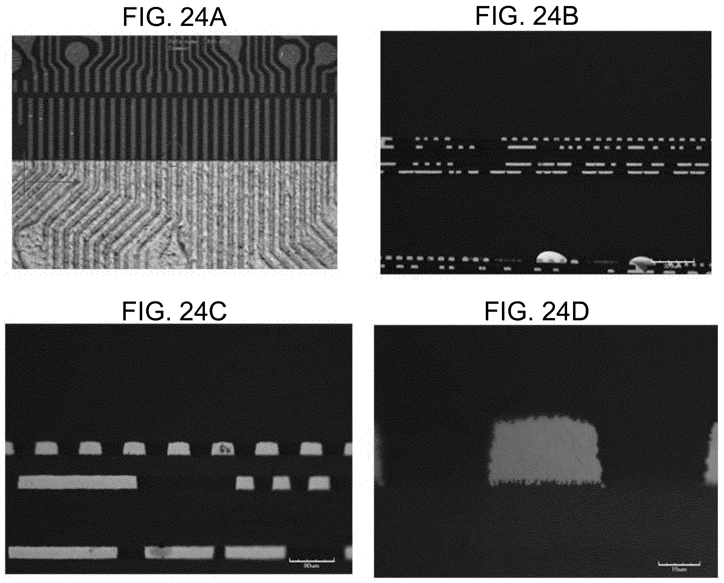

This component 10' finally becomes component 10 including electrodes 2 provided with electrode corrosion preventing layer 4 and second solder layer 8, and the second solder layer 8 is electrically connected to a component as a mounted object. When component 10' is a substrate, as shown in FIGs. 2(A) and (B), FIGs. 24(A) to 24(D), and the like, electrode corrosion preventing layer 4 and second solder layer 8 are provided on electrodes 2 provided on the substrate, and an electronic component as mentioned above is mounted by connecting to the second solder layer 8. In this case, preferably, also on the electronic component are provided electrode corrosion preventing layer 4 and second solder layer 8. On the other hand, when component 10' is an electronic component, as shown in FIGs. 18(A) and (B), FIGs. 19(A) and (B), and the like, electrode corrosion preventing layer 4 and second solder layer 8 are provided on electrodes 2 provided on the electronic component, and the substrate mentioned above connects the second solder layer 8 for mounting. Preferably, also on the substrate in this case are provided electrode corrosion preventing layer 4 and second solder layer 8.

### (Electrode)

Electrode 2 is provided in various manners on component 10'. The kind of electrode 2 is also not particularly limited, but an intended one is conductive electrode 2 including a metal component that is to be corroded by reacting with tin included in first molten solder 5a. Examples of the metal component to be corroded by reacting with tin include Cu, Ag, Au, Pd, Rh, Zn, Sn, Ni, Co, Bi, and the like. Electrode 2 is composed of one or two or more selected from such metal components. In addition, solder wettability and corrosion are inextricably associated with each other. The term "solder wettability" means a phenomenon in which one or two or more of such metal components easily react with tin included in first molten solder 5a and, as the resulting tin compound, wettingly spread. Meanwhile, the term "corrosion" means a phenomenon in which one or two or more of the metal components react with tin included in first molten solder 5a to result in a tin compound, leading to the thinning of electrode 2. Electrode corrosion preventing layer 4, which will be described later, is a layer preventing such corrosion to prevent the reduction of reliability of electrode 2.

Specific examples of electrode 2 include a copper electrode, a copper alloy electrode, a silver electrode, a silver alloy electrode, a gold electrode, a gold alloy electrode, a palladium electrode, a palladium alloy electrode, an aluminum electrode, an aluminum alloy electrode, and the like. When these alloy components include one or two or more metal components selected from Cu, Ag, Au, Pd, Rh, Zn, Sn, Ni, Co, Bi, and the like mentioned above, there occurs the phenomenon in which such a contained component reacts with tin included in first molten solder 5a to result in a tin compound, which causes the thinning of electrode 2.

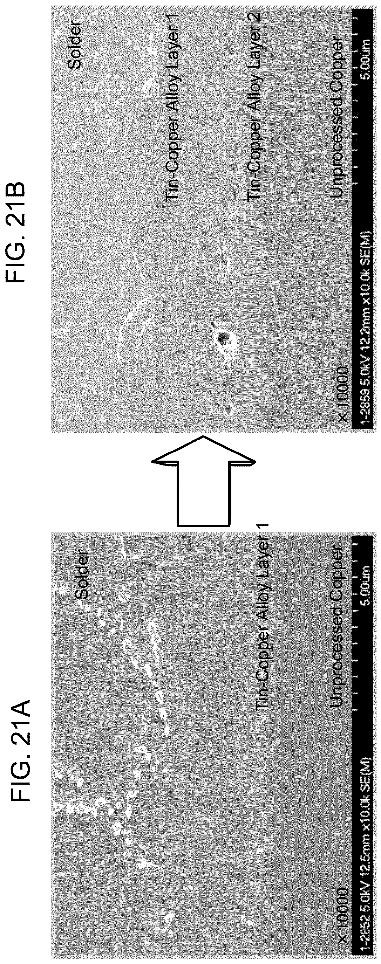

For example, when electrode 2 is a copper electrode or a copper alloy electrode, a copper component and tin included in first molten solder react to easily form a Cu-Sn compound (for example, see FIGs. 21(A) to (D)). As a result, the copper component forming electrode 2 is reduced (electrode corrosion), resulting in the thinning of electrode 2. Similarly, also when any one or two or more of Cu, Ag, Au, Pd, Rh, Zn, Sn, Ni, Co, and Bi are included as a component(s) forming electrode 2 such as a silver electrode, a silver alloy electrode, a gold electrode, a gold alloy electrode, a palladium electrode, a palladium alloy electrode, an aluminum electrode, or an aluminum alloy electrode, the one or two or more components (M) and tin (Sn) in first molten solder react to easily form an M-Sn compound. As a result, the component(s) M forming electrode 2 is (are) reduced, resulting in the thinning of electrode 2.

The shape and size of electrode 2 are not particularly limited. However, for example, in the case of electrode patterns provided on a mounting substrate, as shown in FIGs. 2(A) and (B), 9(A) and (B), 24(A) to (D), and the like, for example, there may be exemplified electrode 2 of a narrow width pattern or a micro round pattern having a pattern width or pattern diameter of 5 µm or more or 10 µm or more and 500 µm or less. In addition, for example, as shown in FIGs. 18(A) and (B), in the case of an electrode provided in an electronic component, depending on the kind of the electronic component, there can be exemplified a large electrode with a size of approximately a few hundred µm to a few mm.

In addition, the thickness of electrode 2 is also not particularly limited but an example of the thickness thereof may be, for example, approximately 5 to 30 µm. The size and outline shape of substrate 1 provided with electrode 2 are also not particularly limited and the present invention can be applied to various kinds of substrates. The method for manufacturing component 10 according to the present invention is a method for forming electrode corrosion preventing layer 4 that can suppress the elution of an electrode component on a surface of such an electrode 2.

### <Contact Step>

The contact step is a step provided between the above-described preparation step and an adhesion step below-described. The contact step is, as shown in FIG. 1, FIG. 3(B), and FIG. 4(B), a step of contacting a gas or a liquid of first organic fatty acid-containing solution 3a with electrode 2 before the contact of electrode 2 with first molten solder 5a.

### (Contact Manner)

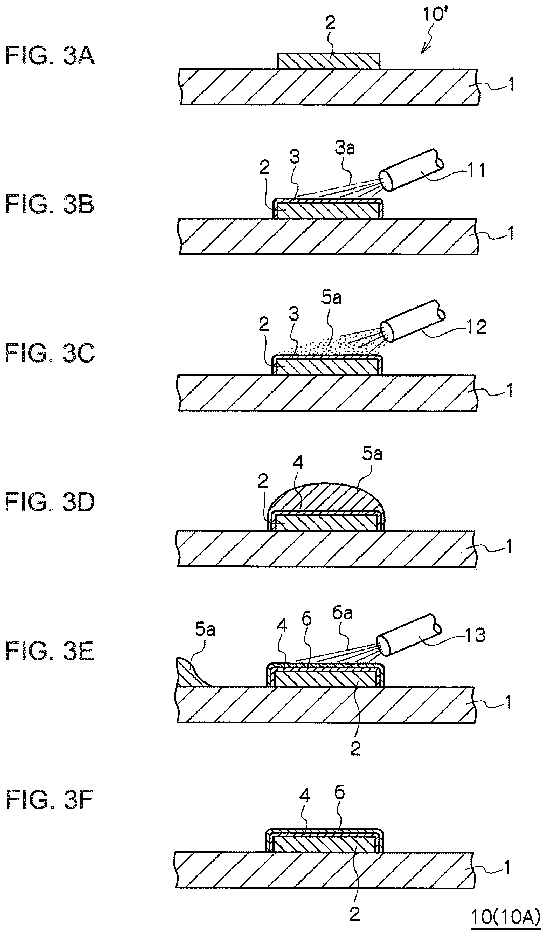

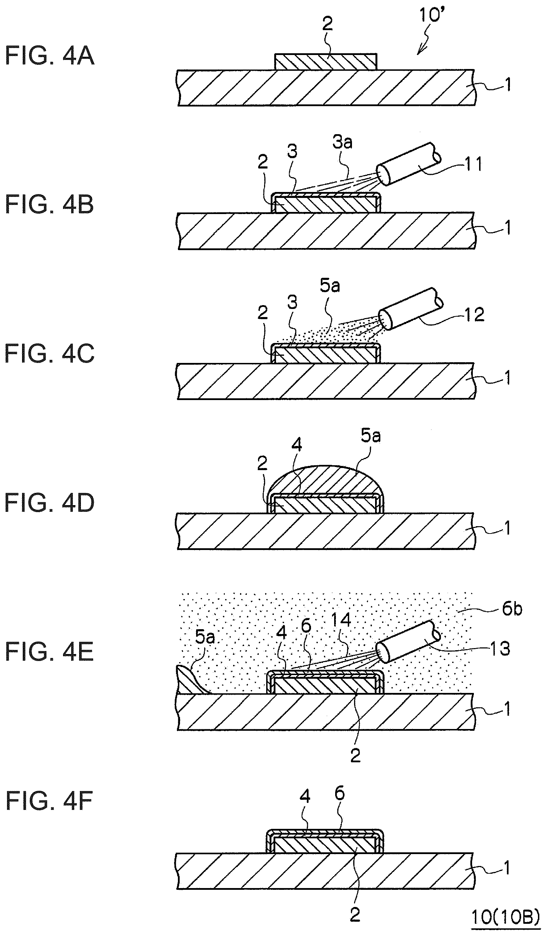

In the contact of first organic fatty acid-containing solution 3a with electrode 2, the solution may be contacted as gas (or referred to as steam) or as liquid. When contacted as gas, the contact may be performed by exposing electrode 2 to a steam atmosphere of the organic fatty acid-containing solution. Alternatively, as shown in FIG. 3(B) and FIG. 4(B), the contact may be performed by ejecting a gas of first organic fatty acid-containing solution 3a from nozzle 11. In addition, when first organic fatty acid-containing solution 3a is contacted as liquid, the contact may be performed by dipping (immersing) electrode 2 in a bath of first organic fatty acid-containing solution 3a or may be performed by ejecting a liquid of first organic fatty acid-containing solution 3a from nozzle 11, as shown in FIG. 3(B) and FIG. 4(B).

### (Organic Fatty Acid-Containing Solution)

First organic fatty acid-containing solution 3a is preferably a solution containing an organic fatty acid having 12 to 20 carbon atoms. Although even an organic fatty acid having 11 or less carbon atoms can also be used, such an organic fatty acid is water-absorbent and not very preferable. In addition, organic fatty acids having 21 or more carbon atoms are problems such as high melting point, poor permeability, and handling difficulty. Atypical preferable one is palmitic acid having 16 carbon atoms. As an organic fatty acid to be used, it is particularly preferable to use only palmitic acid having 16 carbon atoms, and according to need, an organic fatty acid having 12 to 20 carbon atoms, such as stearic acid having 18 carbon atoms, may also be included.

Preferably, first organic fatty acid-containing solution 3a to be used includes 5 to 25% by mass of organic fatty acid and ester synthetic oil for the rest. By using such a first organic fatty acid-containing solution 3a, the first organic fatty acid-containing solution 3a selectively takes in oxides, impurities such as a flux component, or the like present on the surface of electrode 2 to allow the cleaning of the surface of electrode 2. The kind of electrode intended to be used is not particularly limited, and the cleaning can be similarly performed on various kinds of electrodes such as a common copper electrode, a gold-plated copper electrode, a silver-plated copper electrode, a gold electrode, a silver electrode, or other electrodes as mentioned above. As the organic fatty acid, it is particularly preferable to use palmitic acid having 16 carbon atoms, and preferably, first organic fatty acid-containing solution 3a includes the palmitic acid in an amount of around 10% by mass (for example, 5 to 15% by mass). In addition, first organic fatty acid-containing solution 3a does not include additives, such as metal salts, for example, nickel salt and cobalt salt, and antioxidants.

When the concentration of the organic fatty acid is less than 5% by mass, the effect of selectively taking in and purifying oxides and impurities such as a flux component present on the surface of electrode 2 is slightly low, and control at low concentration may become troublesome. On the other hand, when the concentration of the organic fatty acid exceeds 25% by mass, there occur problems such as an increase in the viscosity of first organic fatty acid-containing solution 3a and the occurrence of fuming and odor in a high temperature range exceeding 280°C, for example. Accordingly, the organic fatty acid content is preferably 5 to 20% by mass, and particularly when using only palmitic acid having 16 carbon atoms, the organic fatty acid content is preferably around 10% by mass (for example, 5 to 15% by mass).

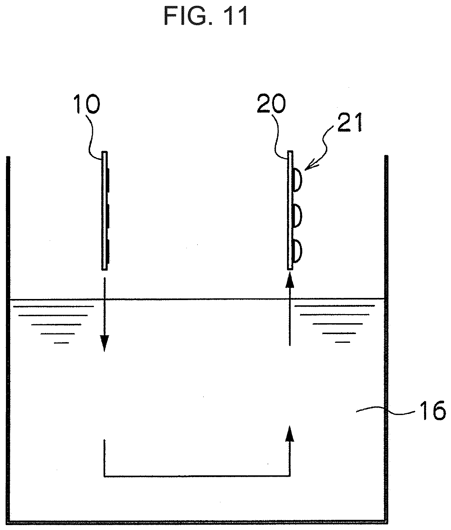

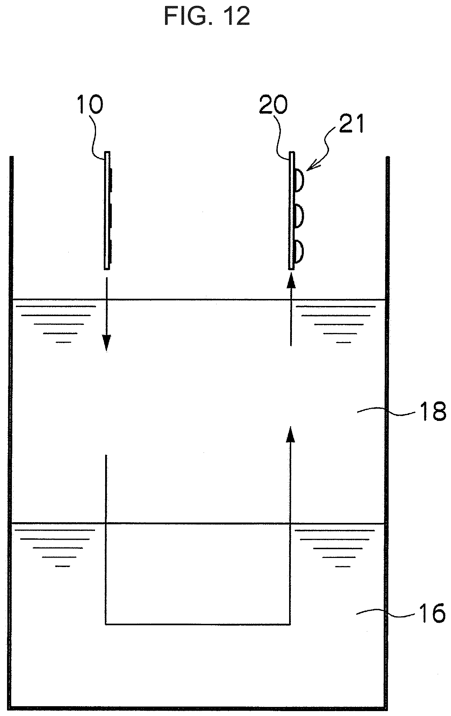

By contacting electrode 2 with a gas or liquid of such a first organic fatty acid-containing solution 3a, oxides, impurities, and the like present on the surface of electrode 2 included in component 10' can be removed and cleaned. Furthermore, on the surface of electrode 2 is formed coating film 3 (see FIG. 3(B) and FIG. 4(B)) of the organic fatty acid forming first organic fatty acid-containing solution 3a. The coating film 3 has an advantage that it can clean the surface of electrode 2 and furthermore can suppress the oxidation of the surface of electrode 2 to maximally suppress the production of an oxide coating film and the adhesion of impurities. As a result, in a state in which the presence of such oxides, impurities, and the like on the surface of the electrode has been minimized, first molten solder 5a can be contacted to the surface of electrode 2 (see FIG. 3(C), FIG. 4(C), and FIGs. 5 to 7(C)). Through the contact step as above, electrode corrosion preventing layer 4 can be formed with a uniform thickness without any defect or the like on the cleaned surface of electrode 2 (see FIG. 3(D), FIG. 4(D), and FIGs. 5 to 7(C)). Electrode corrosion preventing layer 4 is provided in the state in which the occurrence of voids and the occurrence of defects have been suppressed. Therefore, in the sequential step (see FIGs. 11 and 12), the occurrence of voids and the occurrence of defects can be further suppressed also on solder layer 8 (see FIG. 13) provided by contacting second molten solder 16 onto electrode corrosion preventing layer 4.

The temperature of the gas or liquid of first organic fatty acid-containing solution 3a is not particularly limited. However, preferably, the temperature is set to a relatively high level for the contact. Such a temperature is, for example, preferably in a range of 50 to 280°C. If the temperature exceeds 280°C, fume or odor may occur.

### <Adhesion Step>

The adhesion step is a step of contacting first molten solder 5a with electrode 2 to adhere first molten solder 5a onto electrode 2, as shown in FIGs. 1, 2, 3(C), 4(C), and FIGs. 5 to 7(C). The adhesion step can be translated into a step of adhering first molten solder 5a on electrode 2 to form electrode corrosion preventing layer 4 on the surface of electrode 2. The means for contacting first molten solder 5a with electrode 2 is not limited and various contacting means may be mentioned. As such a contacting means, any of the following first to third embodiments can be preferably mentioned.

The contacting means of the following first to third embodiments allow for good soldering to the electrode configuration on the wiring pattern side (the configuration in which electrodes 2 are protruding on substrate 1) as shown in FIG. 8(A) and FIG. 9(A) and also allow for good soldering to the electrode configuration on the BGA side (the configuration in which the electrode patterns are formed by insulation film 80 and electrodes 2 are provided at the bottom of the recess in the opening portion of the insulation film 80) shown in FIG. 8(B) and FIG. 9(B). Meanwhile, with a conventional soldering means, soldering to the electrode configuration on the wiring pattern side was able to be performed with good yield, but not in soldering to the BGA-side electrode configuration.

### (First Embodiment)

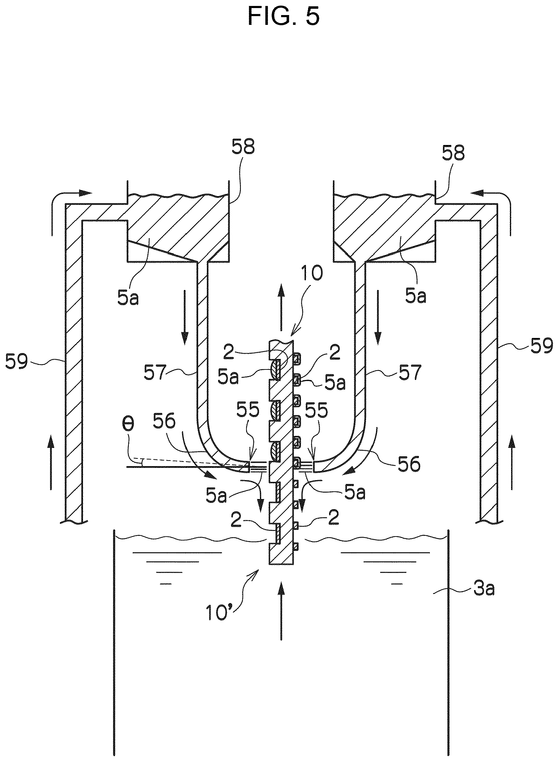

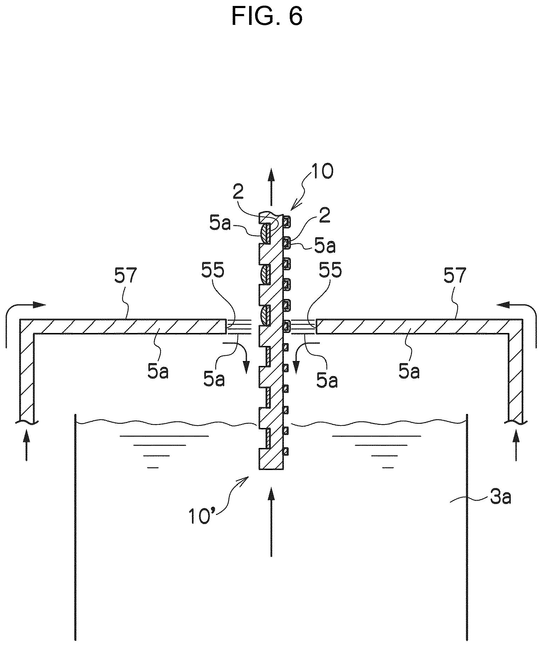

The first embodiment is a contact means that collides first molten solder liquid flow 5a with component 10', as shown in FIGs. 5 and 6.

In an example of FIG. 5, while moving component 10' in a vertical direction, first molten solder liquid flow 5a accelerated by gravity is allowed to collide with component 10' at an angle *θ* orthogonal or roughly orthogonal to the vertical direction. This example is characterized in that molten solder liquid flow 5a collides with electrode 2 from a lateral direction, whereby molten solder liquid flow 5a is contacted fully with the entire surface of electrode 2 and thus electrode corrosion preventing layer 4 can be uniformly formed on electrode 2.

In this example, component 10' moves in an upper or a lower direction (which can also be referred to as vertical direction). As shown in FIG. 5, component 10' may be moved in the upper direction or may be moved in the lower direction, although not shown in the drawing. It is preferable to collide first molten solder liquid flow 5a while moving component 10' in the upper direction, whereby, first molten solder liquid flow 5a can be effectively collided with component 10' after having been immersed in the organic fatty acid-containing solution in a lower bath.

Regarding first molten solder liquid flow 5a, for example as shown in FIG. 5, molten solder liquid flow 5a drawn up by a pump (not shown) passes through pipe 59 into storage bath 58 provided in an upper position and falls freely from storage bath 58 and descends with acceleration by a self weight thereof and gravity in pipe 57. The descended molten solder liquid flow 5a is accelerated up to an arbitrary speed and changes its direction at direction-changing portion 56 with as minimum deceleration as possible. Then, the molten solder liquid flow 5a is vigorously ejected out of nozzle tip 55 to component 10' to collide with component 10'.

As molten solder liquid flow 5a, there may be used a liquid flow of various kinds of molten solders that will be described later. For example, a lead-free solder having a density of approximately 7.3 g/cm³ or the like may be used.

The speed of molten solder liquid flow 5a at nozzle tip 55 and the pressure of molten solder liquid flow 5a colliding with electrode 2 can be adjusted by arbitrarily designing the density of molten solder liquid flow 5a to be used, the height (distance) from nozzle tip 55 to storage bath 58, the pipe shape, and the like. Regarding the pipe shape, there may be mentioned a diameter of pipe 57 allowing for vertical dropping, a degree of curving of direction-changing portion 56, a diameter of nozzle tip 55, and the like. In addition, based on these elements, the speed and pressure of molten solder liquid flow 5a can also be obtained by calculation. For example, in a case of using the lead-free solder with the density of approximately 7.3 g/cm³ and setting the height from nozzle tip 55 to storage bath 58 to, for example, 500 nm or 1000 mm, the speed and pressure of molten solder liquid flow 5a vertically descended from the storage bath 58 can be calculated. For example, as the height becomes, for example, 500 mm, 1000 mm, 1500 mm, or more, the acceleration of molten solder liquid flow 5a is increased, thus allowing molten solder liquid flow 5a to vigorously collide with electrode 2.

First molten solder liquid flow 5a collides with component 10' at the angle *θ* orthogonal or roughly orthogonal to the vertical direction. As used herein, the term "orthogonal" means 90°. The term "roughly orthogonal" means not being strictly limited to 90° but "colliding from a lateral direction". Accordingly, the words "being collided at the angle *θ* orthogonal or roughly orthogonal to the vertical direction" may be translated into the words "being collided from a lateral direction". In this case, the lateral direction may be translated into a horizontal direction.

Molten solder liquid flow 5a may be, as described above, collided horizontally from the lateral direction or may be applied diagonally from an upper direction by a predetermined angle *θ*. The angle *θ* is an angle formed upward from a horizontal line set to 0°. In the example shown in FIG. 5, nozzle tip 55 is provided in a manner that nozzle tip 55 is slightly descends from a horizontal position, so that molten solder liquid flow 5a collides with electrode 2 at the angle *θ*. The angle θ is adjusted by the stream, speed, collision pressure, and the like of molten solder liquid flow 5a and not particularly limited. An example of the angle *θ* is 3° or more and 60° or less, and preferably 30° or less. By colliding with electrode 2 at an angle of the preferable range, without excessive deceleration of the speed of molten solder liquid flow 5a, molten solder liquid flow 5a can be collided with electrode 2 at a desired collision pressure. As a result, molten solder liquid flow 5a can be fully contacted with the entire surface of electrode 2, allowing electrode corrosion preventing layer 4 to be uniformly formed on electrode 2.

The straight line distance from nozzle tip 55 to electrode 2 that is to be collided is not particularly limited but usually may be a distance of approximately 20 to 60 mm. In addition, the shape of nozzle tip 55 is also not particularly limited but preferably changed depending on the shape of the electrode to be collided and the size of the component. Usually, preferably, nozzle tip 55 that has been narrowed down is used.

In an example of FIG. 6, while moving component 10' in the vertical direction, first molten solder liquid flow 5a pressurized by a pump is collided with component 10' from the lateral direction at the angle *θ* (omitted in FIG. 6; see FIG. 5) orthogonal or roughly orthogonal to the vertical direction. This example also is characterized in that molten solder liquid flow 5a collides with electrode 2 from the lateral direction, whereby molten solder liquid flow 5a is fully contacted with the entire surface of electrode 2, allowing electrode corrosion preventing layer 4 to be uniformly formed on electrode 2. As used herein, the words such as "while moving in the vertical direction", "orthogonal", "roughly orthogonal", and "being collided from the lateral direction" are defined as the same as those described with reference to FIG. 5.

Regarding first molten solder liquid flow 5a, for example as shown in FIG. 6, molten solder liquid flow 5a sent at a predetermined pressure by a pump passes through pipe 57 and is vigorously ejected out of nozzle tip 55 to component 10' to collide with component 10'. The pressure at which molten solder liquid flow 5a from nozzle tip 55 collides with electrode 2 can be arbitrarily adjusted by a pump pressure. As the pump pressure is increased, molten solder liquid flow 5a can be vigorously collided with electrode 2. In this embodiment, since the collision pressure can be adjusted by the pump pressure, the liquid flow may be applied horizontally from the lateral direction, as shown in FIG. 6. Alternatively, as shown in FIG. 5, the liquid flow may be applied diagonally from an upper direction by a predetermined angle *θ*.

In the first embodiment shown in FIGs. 5 and 6, molten solder liquid flow 5a is collided from the lateral direction (horizontal direction) while moving component 10' in the upper direction (vertical direction). By doing this, the step of removing an excess solder, which will be described later, can be performed immediately after that, which is thus convenient. Depending on the means for removing an excess solder after that, component 10' may be moved in the lower direction.

The collision pressure at which first molten solder liquid flow 5a collides with electrode 2 is arbitrarily set such that molten solder liquid flow 5a fully contacts with the entire surface of electrode 2 to allow electrode corrosion preventing layer 4 to be uniformly on electrode 2. Accordingly, the collision pressure is not particularly limited. However, for example, in the example of FIG. 5, first molten solder liquid flow 5a is collided with electrode 2 by the self weight thereof and a gravity acceleration, preferably at a pressure of 0.5 to 4.0 Pa. In addition, in the example of FIG. 6 also, for example, similarly, first molten solder liquid flow 5a may be collided with electrode 2 at the pressure of 0.5 to 4.0 Pa by the pump.

The contacting means of the first embodiment allows molten solder liquid flow 5a to be fully contacted with the entire surface of electrode 2 to allow for the uniform formation of electrode corrosion preventing layer 4 on electrode 2 in both the electrode configuration on the wiring pattern side and the electrode configuration on the BGA side.

### (Second Embodiment)

In the second embodiment, as shown in FIG. 3(C) and FIG. 4(C), while moving component 10' in a lateral direction, first molten solder liquid flow 5a is allowed to collide with the electrode 2 from above component 10' at a predetermined angle for adhesion. In this adhesion means, first molten solder liquid flow 5a strongly collides with electrode 2 from above, without deceleration of the speed of molten solder liquid flow 5a itself retained on electrode 2. As a result, as shown in FIG. 3(D) and FIG. 4(D), electrode corrosion preventing layer 4 can be uniformly formed on electrode 2 by fully contacting molten solder liquid flow 5a with the entire surface of electrode 2.

The collision at that time is performed by spraying heated and molten first molten solder liquid flow 5a from a tip of nozzle 12 to electrode 2. The sprayed first molten solder is swollen on electrode 2. Pressure of ejection from the nozzle tip applied when colliding first molten solder liquid flow 5a with component 10' is also arbitrarily adjusted, as in the manner mentioned above, such that first molten solder liquid flow 5a is contacted fully with the entire surface of electrode 2 to allow electrode corrosion preventing layer 4 to be uniformly formed on electrode 2. Accordingly, the ejection pressure is not particularly limited. However, similarly to the above-mentioned collision pressure, for example, the ejection pressure in FIG. 3(C) and FIG. 4(C) is preferably 0.5 to 4.0 Pa.

The ejection angle of first molten solder liquid flow 5a is arbitrarily set depending on the speed of component 10' moving laterally, the ejection pressure, and the amount of ejection. As an example of the ejection angle thereof, for example, preferred is 20 to 85° against a surface of component 10'. By ejecting first molten solder liquid flow 5a to the component surface at the ejection angle to collide therewith, molten solder liquid flow 5a can be fully contacted with the entire surface of electrode 2, with the result that electrode corrosion preventing layer 4 can be uniformly formed on electrode 2.

The direction of a tip opening of nozzle 12 is not particularly limited and may be the same as or opposite to the direction in which component 10' moves, but is preferably opposite thereto. Regarding the opposite direction, in the examples of FIG. 3(C) and FIG. 4(C) in which the tip of nozzle 12 is directed to the left, preferably, component 10' is moved in a right direction,. By moving component 10' such that the component is directed to a direction opposite to a direction of the tip of nozzle 12, namely to the tip of nozzle 12, molten solder liquid flow 5a can be fully contacted with the entire surface of electrode 2, with the result that electrode corrosion preventing layer 4 can be uniformly formed on electrode 2.

The contacting means of the second embodiment allows molten solder liquid flow 5a to be fully contacted with the entire surface of electrode 2 to allow for the uniform formation of electrode corrosion preventing layer 4 on electrode 2 in both the electrode configuration on the wiring pattern side and the electrode configuration on the BGA side.

### (Third Embodiment)

In the third embodiment, as shown in FIG. 7, while pulling up component 10' after having immersed in solder bath 52 filled with first molten solder 5a by moving component 10' in the vertical direction, component 10' is allowed to pass through slit 51 arranged on liquid surface 53 of first molten solder 5a for adhesion. In this method, since component 10' passes through slit 51 arranged on liquid surface 53 (referred to also as surface) of first molten solder 5a, due to the action of surface tension occurring when the component passes through slit 51, molten solder 5a spreads over the entire region of electrode 2. As a result, first molten solder 5a can be uniformly adhered onto electrode 2.

First molten solder 5a is molten at a predetermined temperature, which will be described later. Slit 51 is arranged such that it is placed on first molten solder 5a. In the arranged slit 51, a predetermined space is opened. The space is arbitrarily adjusted according to the thickness size of component 10' passing through slit 51. Specifically, as shown in FIG. 7(A), gaps g1 and g2 from the surface of component 10' to ends of slit 51 are preferably in a range of 0.1 to 5 mm. Accordingly, when the thickness of component 10' is thick, the opening size of slit 51 is increased such that gaps g1 and g2 on both sides are set in the above range, whereas when the thickness of component 10' is thin, the opening size of slit 51 is reduced such that gaps g1 and g2 on both sides are set in the above range.

In the third embodiment, first, as shown in FIG. 7(B), component 10' is immersed in solder bath 52. At that time, first molten solder 5a is not sufficiently adhered on electrode 2. After that, when the immersed component 10' is pulled up through slit 51, first molten solder 5a is drawn up by surface tension in narrow gaps g1 and g2 between component 10' and slit 51, as shown in FIG. 7(C). First molten solder 5a drawn up by the surface tension is fully contacted with the entire surface of electrode 2 in both the electrode configuration on the wiring pattern side and the electrode configuration on the BGA side, allowing electrode corrosion preventing layer 4 to be uniformly formed on electrode 2. If gaps g1 and g2 exceed 5 mm, particularly soldering onto electrode 2 on the BGA side is not sufficient. On the other hand, if gaps g1 and g2 are below 0.1 mm, the slit opening is narrow relative to the width of component 10'. Therefore, extremely careful attention needs to be paid to the pulling up of component 10', which tends to make it difficult to manufacture component 10.

### (First Molten Solder)

First molten solder 5a used in the above-described first to third embodiments is a heated and molten liquid flow, which is a solder fluidized to an extent allowing it to collide with or spread over component 10' by dropping or ejection. The heating temperature is arbitrarily selected depending on the electrode composition and the solder composition, but usually, a favorable temperature is set in a range of approximately 150 to 300°C.

In the present invention, when electrode 2 is a copper electrode or a copper alloy electrode, it is preferable to use a molten lead-free solder including at least tin as a main component and nickel as an accessory component. In addition, it is preferable to use a low-melting point molten solder including at least nickel as an accessory component in a tin-bismuth based solder. Such a molten lead-free solder may arbitrarily further include one or two or more selected from copper, germanium, and phosphorus, as an accessory component(s). Furthermore, silver may also be included. However, the present invention provides an advantage of enabling uniform soldering without including expensive silver, which is generally referred to as improving wettability. In addition, as described above, in a case of using an electrode other than a copper electrode or copper alloy electrode, a molten solder having a composition corresponding to the electrode component is arbitrarily selected and used.

Examples of solder forming first molten solder 51 include an Sn-Ni based solder, an Sn-Cu-Ni based solder, an Sn-Ge-Ni based solder, an Sn-P-Ni based solder, an Sn-Cu-Ge-Ni based solder, an Sn-Cu-Ge-P-Ni based solder, an Sn-Ag-Cu-Ni based solder, an Sn-Zn-Al-Ni based solder, an Sn-Ag-Cu-Ge-Ni based solder, an Sn-Sb-Ni based solder, and the like. In addition, examples of the low melting point solder include an Sn-Bi-Ni based solder, an Sn-Bi-Zn-Ni based solder, an Sn-Bi-Ag-In-Ni based solder, and the like.

With the treatment described above, electrode corrosion preventing layer 4 can be formed on the surface of electrode 2 that has already been cleaned by the first organic fatty acid-containing solution. In electrode corrosion preventing layer 4, defects or the like are maximally suppressed, and the layer is formed with a uniform thickness. Regarding the thickness of the layer, a thickness of the thinnest part is at least 0.5 µm or more and a thickness of the thickest part is 3 µm or less. An average thickness of the entire electrode corrosion preventing layer including the thinnest part and the thickest part is 1 to 2 µm.

Hereinafter, a description will be given of preferable embodiments in which electrode 2 is a copper electrode or a copper alloy electrode, although an electrode composed of other component(s) can also be arbitrarily used from the same viewpoint.

The various solders mentioned above can be used regardless of whether electrode 2 is a copper electrode or a copper alloy electrode, and in either case, the efficacy of the present invention can be achieved. Particularly preferable solders to be applicable are the above-mentioned solder alloys, such as a quinary solder alloy of Sn-Ni-Ag-Cu-Ge, a quaternary solder alloy of Sn-Ni-Cu-Ge, a ternary solder alloy of Sn-Ni-Cu, and a ternary solder alloy of Sn-Ni-Ge. The quinary solder of Sn-Ni-Ag-Cu-Ge is, for example, a solder alloy consisting of 0.01 to 0.5% by mass of nickel, 2 to 4% by mass of silver, 0.1 to 1% by mass of copper, 0.001 to 0.02% by mass of germanium, and tin for the rest. The quaternary solder of Sn-Ni-Cu-Ge is, for example, a solder alloy consisting of 0.01 to 0.5% by mass of nickel, 0.1 to 1% by mass of copper, 0.001 to 0.02% by mass of germanium, and tin for the rest. The ternary solder alloy of Sn-Ni-Cu is, for example, a solder alloy consisting of 0.01 to 0.5% by mass of nickel, 0.1 to 1% by mass of copper, and tin for the rest. Molten solder 5a made of any of these solder alloys is preferable to form a Cu-Ni-Sn intermetallic compound 4 (see FIG. 21(B)) that can suppress stably the corrosion of copper electrode as electrode corrosion preventing layer 4. A particularly preferable composition for forming such a Cu-Ni-Sn intermetallic compound 4 is a solder alloy including 0.01 to 0.1% by mass of nickel. In a case of soldering with such a solder alloy, the solder alloy is preferably used as first molten solder 5a set at a temperature of 240 to 260°C.

In addition, a so-called low melting point solder including bismuth can lower the heating temperature of first molten solder 5a. Thus, by adjusting the component composition thereof, for example, soldering temperature can be lowered down to near 150°C. The solder composition including bismuth also includes preferably 0.01 to 0.5% by mass of nickel, and more preferably 0.01 to 0.1% by mass of nickel, similarly to the above. By doing this, the solder can be used as a first molten solder 5a of low temperature type that can easily form the Cu-Ni-Sn intermetallic compound layer 4 as the electrode corrosion preventing layer.

In addition, other components such as zinc, copper, germanium, and antimony may be also added according to need. In any case, the solder composition includes preferably 0.01 to 0.5% by mass of nickel, and more preferably 0.01 to 0.1% by mass of nickel.

First molten solder 5a having such a composition is a lead-free solder containing no lead and essentially includes nickel in the above amount. Thus, as shown in FIG. 21(B), the nickel included in first molten solder 5a combines with the copper of copper electrode 2 and furthermore the tin of first molten solder 5a also combines therewith, whereby Cu-Ni-Sn intermetallic compound layer 4 can be easily formed on the surface of copper electrode 2. The formed Cu-Ni-Sn intermetallic compound layer 4 serves as electrode corrosion preventing layer 4 of copper electrode 2 to serve to prevent defect and deletion of copper electrode 2. Accordingly, electrode 2 having the Cu-Ni-Sn intermetallic compound layer 4 can be easily resistant against a treatment that can be said hard for copper electrode 2, as in a case of feeding in a dipping step in a later process in which component 10 with electrode 2 having the Cu-Ni-Sn intermetallic compound layer 4 formed thereon is dipped in a solder bath. Therefore, even when a low-cost solder dipping step is applied, the difference in electrode corrosion between a first dipped (immersed) portion and a lastly dipped portion can be further suppressed, so that the difference in reliability of electrode 2 between the individual portions of the same component 10 can be maximally suppressed. As a result, there can be provided component 10 with high yield and high reliability. Furthermore, mounting of an electronic component or the like on component 10 can be performed at low cost with high reliability.

In addition, as shown in FIGs. 11 and 12, component 20 in which solder layer 8 has been provided in the dipping step is sequentially subjected to a plurality of heating treatments (reflow furnace) in a mounting step of mounting an electronic component on the solder layer 8. Regardless of the length of time it takes to perform the heating treatments, electrode corrosion preventing layer 4 can suppress the corrosion of electrode 2 due to the heating treatments and can maintain the reliability of component mounting at soldered joints. In addition, as described above, solder layer 8 provided on electrode corrosion preventing layer 4 can further suppress the occurrence of voids and the occurrence of defects and therefore can maintain the reliability of component mounting at the soldered joints.

A nickel content included in first molten solder 5a affects on the thickness of Cu-Ni-Sn intermetallic compound layer 4, as shown in Examples described later. Specifically, when the nickel content is in a range of 0.01% by mass or more and 0.5% by mass or less (preferably 0.1% by mass or less), there can be produced a Cu-Ni-Sn intermetallic compound layer 4 having a roughly uniform thickness of approximately 1 µm or more and 3 µm. The Cu-Ni-Sn intermetallic compound layer 4 having a thickness in the above range can suppress copper in copper electrode 2 from being molten in first molten solder 5a to be corroded.

When the nickel content is 0.01% by mass, the thickness of Cu-Ni-Sn intermetallic compound layer 4 is approximately 1 to 1.5 µm. When the nickel content is, for example, 0.1% by mass, the thickness of Cu-Ni-Sn intermetallic compound layer 4 is approximately 2 µm, and when the nickel content is 0.5% by mass, the thickness of Cu-Ni-Sn intermetallic compound layer 4 is approximately 3 µm.

If the nickel content is below 0.01% by mass, the thickness of Cu-Ni-Sn intermetallic compound layer 4 results in below 1 µm, so that a portion of electrode 2 may not be covered by the Cu-Ni-Sn intermetallic compound layer 4, which may facilitate the corrosion of copper to start from the portion. If the nickel content exceeds 0.5% by mass, the thickness of hard Cu-Ni-Sn intermetallic compound layer 4 becomes thicker, exceeding 3 µm, which can cause a crack in the Cu-Ni-Sn intermetallic compound layer 4. As a result, the corrosion of copper can easily start from the cracked portion.

The preferable nickel content is 0.01 to 0.1% by mass. First molten solder 5a having a nickel content in the above range can further suppress the occurrence of a crack in Cu-Ni-Sn intermetallic compound layer 4 than in the case of a nickel content of 0.1 to 0.5% by mass and can form a smooth and uniform electrode corrosion preventing layer 4 having an average thickness of 1 to 2 µm. In addition, when the nickel content is more than 0.1% by mass, produced Cu-Ni-Sn intermetallic compound layer 4 also tends to be thicker. As a result, the produced Cu-Ni-Sn intermetallic compound layer 4 takes in the copper component in electrode 2, with the result that the copper included in electrode 2 tends to be corroded.

The temperature of first molten solder 5a can be any as long as it is a temperature exceeding a melting point thereof. The temperature can be arbitrarily set according to the kind of first molten solder 5a to be used. Usually, the solder is heated preferably to a temperature range of 20 to 100°C higher than the melting point of first molten solder 5a. Any of the above-mentioned various solders is heated to a temperature in the above range to be prepared as the liquid flow of first molten solder 5a, and then collided with or spread over electrode 2, as in the first to third embodiments described above.

For example, in a case of using a quinary solder of Sn-Ni-Ag-Cu-Ge, a quaternary solder of Sn-Ni-Cu-Ge, a ternary solder alloy of Sn-Ni-Cu, or the like having a melting point of around 217°C, which will be described in Examples below, solder temperature is preferably set to around 250°C. If the solder temperature is not equal to or higher than a temperature that is 20°C higher than the melting point (a case of being less than a 20°C higher temperature), the adhesion of solder obtained by collision or the like of molten solder liquid flow 5a to electrode 2 can be insufficient. On the other hand, if the solder temperature is not equal to or lower than a temperature 100°C higher than the melting point (a case of exceeding a 100°C higher temperature), the temperature is too high and thereby the thickness of electrode corrosion preventing layer 4 tens to be thick, with the result that the electrode component can be corroded.

The time of contact between electrode 2 and first molten solder 5a needs to be a time enough to form at least electrode corrosion preventing layer 4, and furthermore, preferably is a time of such an extent that electrode corrosion preventing layer 4 does not become excessively thick. Such a time varies depending on the kind of solder and the temperature of solder and so it cannot be said definitely. However, the preferable contact time is usually a time allowing the thickness of electrode corrosion preventing layer 4 to be in a range of 0.5 to 3 µm, and more preferably a time allowing an average thickness of electrode corrosion preventing layer 4 to be in a range of 1 to 2 µm. The time allowing the thickness of electrode corrosion preventing layer 4 to be in the range of 0.5 to 3 µm, for example, is a time ranging from 1 to 45 seconds, preferably 1 to 20 seconds, and more preferably 1 to 10 seconds. By performing soldering in such a time range, electrode corrosion preventing layer 4 is easily formed in the range of 0.5 to 3 µm. If the time is too short, electrode corrosion preventing layer 4 having an intended thickness cannot be formed and the produced layer can have a defect, whereby the electrode component may elute from the defect upon contact with the second molten solder. On the other hand, if the time is too long, electrode corrosion preventing layer 4 becomes too thick and brittle, which can cause a crack. Then, upon contact with the second molten solder, the electrode component can elute from the crack. In addition, if the time is too long, the thickness of electrode corrosion preventing layer 4 tends to be thick, with the result that the electrode component can be corroded. First molten solder liquid flow 5a is a solder composition including at least nickel. Therefore, even in the above range, the effect of electrode corrosion preventing layer 4 formed on the electrode can suppress the dissolution of the electrode component and thereby dissolution of electrode 2.

### (Adhesion Atmosphere)

In the adhesion means of the first to third embodiments above-described, an atmosphere upon contact of molten solder liquid flow 5a with electrode 2 is not particularly limited. However, since an excess first molten solder 5a is removed by any of various means after the adhesion, atmosphere temperature needs to be maintained at a temperature at which the molten state of first molder solder 5a can be maintained as it is (a temperature of 240 to 260°C in the above example using the solder with the melting point of around 217°C) during treatments in both steps: "the step of adhering the first molten solder" and "the step of removing an excess solder". Such an atmosphere temperature is, specifically, preferably a temperature that is the same as or close to a temperature corresponding to the kind of first molten solder 5a to be soldered.

In the first embodiment shown in FIGs. 5 and 6 and in the second embodiment shown in FIGs. 3(C) and 4(C), the term "atmosphere means both an atmosphere used when first molten solder liquid flow 5a collides with electrode 2 and then, an atmosphere in which an excess solder adhered to electrode 2 is removed. In addition, in the third embodiment shown in FIGs. 7(A) to (C), the term "atmosphere" means both an atmosphere used after component 10' has been pulled up from first molten solder bath 52 and then, an atmosphere in which an excess solder adhered to electrode 2 is removed.

The temperature of the atmosphere and the temperature of molten solder 5a may be the same and there is practically no problem. However, the atmosphere temperature is preferably set slightly higher than the temperature of first molten solder 5a. For example, the atmosphere temperature is set to preferably 2 to 10°C higher, and more preferably 2 to 5°C higher than a liquid flow temperature of first molten solder 5a. By setting the atmosphere temperature in the above temperature range, the liquid flow of first molten solder 5a after colliding with or spreading over the surface of electrode 2 is allowed to be uniformly flown on the surface of electrode 2. Particularly when using molten solder 5a purified with the organic fatty acid-containing solution, first molten solder 5a can be spread to every corner of the electrode surface, the electrode sides, and the like. In addition, an amount of an excess solder left on electrode corrosion preventing layer 4 can be minimized. As a result, electrode corrosion preventing layer 4 with a uniform thickness without any crack can be formed uniformly on the electrode. If the atmosphere temperature is lower than the liquid flow temperature of first molten solder 5a, the fluidity of first molten solder 5a may be reduced. On the other hand, if the atmosphere temperature is set to a level exceeding 10°C, the temperature is too high, which can cause heat damage to the substrate.

The atmosphere may be any of an air atmosphere, an inert atmosphere such as nitrogen, and a steam atmosphere of organic fatty acid-containing solution, or a mixture atmosphere of two or more thereof. Among them, preferred is an atmosphere including a steam of organic fatty acid-containing solution. For example, preferred is a steam atmosphere of organic fatty acid-containing solution or an atmosphere of a mixture of air or an inert gas and a steam of organic fatty acid-containing solution. By using the steam atmosphere of organic fatty acid-containing solution, electrode 2 is neither oxidized nor contaminated with any impurity upon contact with first molten solder liquid flow 5a. In addition, also in the subsequent step for removing an excess solder, neither oxidation nor contamination by any impurity occurs on electrode 2 having electrode corrosion preventing layer 4 formed thereon.

Preferably, the atmosphere is filled with the steam of organic fatty acid-containing solution, the mixture gas thereof, or the like and is in a pressurized state. Pressure in the atmosphere is not particularly limited but preferably around 0.1 Pa. Particularly, since the atmosphere is in the state of being pressurized in the above range by the steam of organic fatty acid-containing solution, electrode 2 of component 10' is neither oxidized nor contaminated by any impurity. The steam of organic fatty acid-containing solution may be supplied by any means. For example, as shown in FIGs. 5 and 6, the steam may be a steam of the organic fatty acid-containing solution evaporating from an underlying bath containing organic fatty acid-containing solution 3a, or may be a steam generated by another steam generator (not shown) and supplied through a pipe or the like.

In this case, the organic fatty acid-containing solution to be used is preferably a solution containing an organic fatty acid having 12 to 20 carbon atoms, similarly to first organic fatty acid-containing solution 3a described above. As a typical one, preferred is palmitic acid having 16 carbon atoms. As the organic fatty acid, it is particularly preferable to use only palmitic acid having 16 carbon atoms, and according to need, an organic fatty acid having 12 to 20 carbon atoms, such as stearic acid having 18 carbon atoms, may also be included. Then, a preferable organic fatty acid-containing solution to be used is a solution including 5 to 25% by mass of palmitic acid and an ester synthetic oil for the rest. By heating such an organic fatty acid-containing solution to use as a steam generating source, the generated steam selectively takes in oxides and impurities such as a flux component present on the surface of electrode 2, allowing the cleaning of the surface of electrode 2. Particularly, preferred is a steam atmosphere of an organic fatty acid-containing solution including around 10% by mass (for example, 5 to 15% by mass) of palmitic acid having 16 carbon atoms. In addition, the organic fatty acid-containing solution does not include additives such as metal salts, for example nickel salt and cobalt salt, and antioxidants. Upper and lower limits of concentration of the organic fatty acid are the same as those mentioned regarding first organic fatty acid-containing solution 3a described above, and thus a description thereof will be omitted here.

### (Purification Treatment)

Preferably, first molten solder 5a is subjected to purification treatment. Specifically, a solution including 5 to 25% by mass of an organic fatty acid having 12 to 20 carbon atoms is heated to 180 to 280°C, and the heated solution is contacted with first molten solder 5a to strongly stir and mix. By doing this, first molten solder 5a before purification treatment, contaminated with an oxide, a flux component, or the like, can be cleaned, whereby there can be obtained first molten solder 5a from which the oxide, the flux component, and the like have been removed. After that, the mixture solution including first molten solder 5a subjected to the removal of the oxide, flux component, and the like is introduced in an organic fatty acid-containing solution storage bath. Then, the purified first molten solder 5a separated with a specific gravity difference in the organic fatty acid-containing solution storage bath is returned to a lead-free solder liquid storage bath from the bottom of the organic fatty acid-containing solution storage bath by a pump. Performing such a purification treatment can suppress a time-related increase in copper concentration and impurity concentration in first molten solder 5a used as a liquid flow, as well as can inhibit entry of oxides and impurities such as a flux residue into the lead-free solder liquid storage bath. As a result, a time-related composition change in first molten solder 5a in the lead-free solder liquid storage bath can be suppressed, so that stable first molten solder 5a with high bonding reliability can be used.

In the purified first molten solder 5a, inclusion of oxides and impurities such as a flux residue affecting bonding quality of electrode 2 is maximally inhibited. As a result, a lot-to-lot variation in the quality of bonding of electrode 2 and an electronic component can be significantly reduced, which can contribute to time-related quality stability.

In addition, there has been obtained a result that first molten solder 5a purified with organic fatty acid-containing solution is inferior in wettability to a molten solder not purified therewith. Specifically, as can be seen also from the results of a solder wettability test (meniscograph) obtained in Examples and a Comparative Example described below, the purified first molten solder 5a had a zero cross time of 0.4 seconds, whereas the unpurified molten solder had a zero cross time of 5 seconds.

Additionally, there has been obtained a result that a first molten solder 5a purified with organic fatty acid-containing solution has a significantly small viscosity as compared to a molten solder not purified with organic fatty acid-containing solution. Specifically, as can be seen also from the results obtained in the Examples and the Comparative Example described below, the purified first molten solder 5a had a viscosity of 0.002 to 0.004 Pa•s in a molten state thereof, whereas the unpurified molten solder had a viscosity of 0.005 to 0.008 Pa•s in a molten state thereof, where there was a significant difference of approximately two-fold therebetween. In addition, the molten solders used in the below-described Examples and Comparative Examples all had the melting point of approximately 217°C, and the above-mentioned viscosity ranges are results obtained in the temperature range of at least 240 to 260°C. The viscosities were measured by an oscillating plate viscometer.

The above-described characteristic difference between the purified first molten solder 5a and the unpurified molten solder means that the liquid flow of first molten solder 5a spreads uniformly with good solder wettability to every corner on electrode 2. Particularly, by contacting (spraying or immersing) organic fatty acid-containing solution 3a to be used for purification with electrode 2 (see FIG. 3(B) and FIG. 4(B)) before collision of first molten solder 5a to the surface of electrode 2, the organic fatty acid-containing solution 3a cleans the surface of electrode 2 in such a manner that removes oxides, impurities, and the like present thereon. Onto the electrode surface thus cleaned, first molten solder 5a having a viscosity in the above range (0.002 to 0.004 Pa•s) similarly purified with the organic fatty acid-containing solution is allowed to collide and adhere, whereby first molten solder 5a can be uniformly equally wettingly spread with good solder-wettability on the electrode surface. As a result, a nickel component and a tin component included in first molten solder 5a combine with a component included in electrode 2, such as a copper component, to allow a Cu-Ni-Sn intermetallic compound layer as electrode corrosion preventing layer 4 to be formed onto every corner of the electrode surface.

On the other hand, when the unpurified molten solder is collided and adhered onto the cleaned electrode surface, due to the high viscosity of 0.005 to 0.008 Pa•s in the molten state thereof, it does not wettingly spread with good wettability as described above. Thus, first molten solder 5a does not uniformly wettingly spread on the electrode surface, so that electrode corrosion preventing layer 4 cannot be formed onto every corner of the electrode surface. These results show that collision and adhesion of first molten solder 5a purified with an organic fatty acid-containing solution onto the electrode surface cleaned with the organic fatty acid-containing solution provides a significant advantageous effect, also from the viewpoint of the formation of electrode corrosion preventing layer 4.

The organic fatty acid included in the organic fatty acid-containing solution to be used for purification is preferably the same one as that included in first organic fatty acid-containing solution 3a used in the above-described contact step. Ingredients, contents, and the like of the organic fatty acid-containing solution to be used are the same as those in the above-described first organic fatty acid-containing solution and thus descriptions thereof will be omitted here.

The temperature of the organic fatty acid-containing solution to be used for purification is determined depending on the melting point of first molten solder 5a to be purified. The organic fatty acid-containing solution and first molten solder 5a are strongly stirred together to be contacted with each other in a high temperature range no less than at least the melting point of first molten solder 5a (as an example, 240 to 260°C in solder having the melting point of around 217°C). In addition, an upper limit temperature of the organic fatty acid-containing solution is approximately 280°C from the viewpoint of a fuming problem and energy saving, and desirably, is in a range of from a temperature no less than the melting point of first molten solder 5a to be purified to 260°C. For example, a solder alloy including 0.01 to 0.1% by mass of nickel, 0.1 to 4% by mass of silver, 0.1 to 1% by mass of copper, 0.001 to 0.01% by mass of germanium, and tin for the rest has the melting point of around 217°C and is used as first molten solder 5a at a temperature of 240 to 260°C. Accordingly, the temperature of the organic fatty acid-containing solution is also preferably, the same as that, approximately 240 to 260°C.

### <Removal Step>

The removal step is a step performed in all of the above-described first to third embodiments, which is a step for removing an excess solder adhered by collision or spreading of first molten solder liquid flow 5a. Specifically, as shown in FIGs. 1, 2(A) and (B), 3(E) and FIG. 4(E), it is a step of ejecting gas flow 14 or fluid 6a to adhered first molten solder 5a to remove an excess solder thereof, Gas flow 14 or fluid 6a may be an inert gas or air in an atmosphere containing a gas (or referred to as steam; the same shall apply hereinafter) or liquid of a second organic fatty acid-containing solution, a fluid including a gas or liquid of the second organic fatty acid-containing solution, or an inert gas or air. Hereinafter, a description will be given with reference to the examples of the second embodiment of FIGs. 3 to 4(C).

### (Ejection Treatment)

The ejection treatment is not particularly limited as long as excess molten solder can be removed, and an ejection fluid used for the removal may be a gas or a liquid. Ejection may be, for example if described by the examples of the second embodiment, performed by ejection of fluid 6a including a gas or liquid of organic fatty acid-containing solution, as shown in FIG. 3(E), or performed by ejection of gas 14 such as an inert gas or air in atmosphere 6b containing a gas or liquid of organic fatty acid-containing solution, as shown in FIG. 4(E). Although not shown in the drawings, the ejection treatment may be performed by ejection of only a gas flow of an inert gas, air or the like in a case in which adhesion treatment has been done with first molten solder 5a purified with organic fatty acid-containing solution or in a case in which, after the adhesion treatment of first molten solder 5a not purified with organic fatty acid-containing solution, a gas or liquid of the organic fatty acid-containing solution has been adhered to first molten solder 5a.

When the adhesion treatment has been done with first molten solder 5a purified with an organic fatty acid-containing solution, ejection treatment may be performed, as shown in FIGs. 3(E) and 4(E), by ejecting fluid 6a containing a gas or liquid of the organic fatty acid-containing solution or ejecting gas 14 such as an inert gas or air in atmosphere 6b containing the gas or liquid of the organic fatty acid-containing solution. Additionally, also when first molten solder 5a not purified with organic fatty acid-containing solution has been adhered and then a gas or liquid of an organic fatty acid-containing solution has been adhered to first molten solder 5a, ejection treatment may be performed by ejecting fluid 6a containing a gas or liquid of the organic fatty acid-containing solution or ejecting gas 14 such as an inert gas or air in atmosphere 6b containing the gas or liquid of the organic fatty acid-containing solution.

This allows the removal of first molten solder 5a and simultaneously the formation of coating film 6 that prevents oxidation of electrode corrosion preventing layer 4 and solder adhered onto electrode corrosion preventing layer 4. As a result, storage or distribution in the state in which electrode corrosion preventing layer 4 has been provided on electrodes 2 can be carried out without any problem. Even when solder layer 8 (see FIG. 13) is provided a desired thickness on electrode 2 by dipping the component in another molten solder (second molten solder 16; see FIGs. 11 and 12) after storage or distribution, solder layer 8 can be formed with good solder wettability.

Specifically, when performing the ejection treatment by the ejection of fluid 6a including the gas or liquid of an organic fatty acid-containing solution, a steam or liquid of the organic fatty acid-containing solution is ejected from nozzle 13 to first molten solder 5a adhered in a swollen form on electrode 2, as shown in FIG. 3(E). In the organic fatty acid-containing solution used at that time, some amount of an inert gas such as nitrogen gas, air, or the like may be mixed. On the other hand, water or water vapor is not mixed from the viewpoint of the oxidation of electrode corrosion preventing layer 4 and solder and compatibility with the organic fatty acid-containing solution. In addition, when the ejection treatment is performed by the ejection of gas 14 such as an inert gas or air in atmosphere 6b containing a gas or liquid of an organic fatty acid-containing solution, in a steam atmosphere or liquid atmosphere (in liquid) of the organic fatty acid-containing solution, gas 14, such as an inert gas (including rare gas), for example, nitrogen gas or argon gas, or air is ejected from nozzle 13 to first molten solder 5a adhered in a swollen form on electrode 2, as shown in FIG. 4(E). In addition, also in the case in which the adhesion treatment has been done with first molten solder 5a purified with organic fatty acid-containing solution or in the case in which after the adhesion treatment of first molten solder 5a not purified with organic fatty acid-containing solution, a gas or liquid of organic fatty acid-containing solution has been adhered to first molten solder 5a, gas 14, such as an inert gas (including rare gas), for example, nitrogen gas or argon gas, or air is ejected from nozzle 13 to first molten solder 5a adhered in a swollen form on electrode 2, as shown in FIG. 4(E).

The gas to be ejected to remove excess first molten solder 5a is not particularly limited, but preferably, nitrogen, argon, air, a steam of organic fatty acid-containing solution, or a mixture gas of two or more thereof may be used. In addition, the liquid to be ejected is preferably organic fatty acid-containing solution. Such a gas or liquid is ejected preferably at a temperature that does not cause cooling and solidification of excess first molten solder 5a upon ejection.

The temperature varies depending on the melting point of first molten solder 5a or the like, but is, usually, preferably equal to or higher than a temperature 20°C higher than the melting point of first molten solder 5a. If the temperature is not equal to or higher than the temperature 20°C higher than the melting point of first molten solder 5a, namely below the temperature 20°C higher than the melting point of first molten solder 5a, first molten solder 5a to be removed by ejection of gas or liquid may solidify and cannot be removed. For example, in cases of a quinary solder, a quaternary solder, or a ternary solder used in Examples described below, the melting point thereof is around 217°C, so that the temperature of a gas or liquid to be ejected is preferably 240°C or higher.

When the temperature of gas or liquid to be ejected is too high, there occurs a problem that the heat damages substrate 1. Accordingly, without unlimitedly setting the temperature to high, it is preferable to eject the gas or liquid in a range equal to or lower than a temperature 100°C higher than the melting point of first molten solder 5a to be used. For example, in the cases of the quinary solder, the quaternary solder, or the ternary solder used in Examples described below, the melting point thereof is around 217°C, so that an upper limit of the temperature of the gas or liquid to be ejected is approximately 310°C at maximum, preferably no more than 300°C, and more preferably no more than 260°C.

A flow rate and a spraying time of fluid 6a (FIG. 3(E)) or gas 14 (FIG. 4(E) sprayed from nozzle 13 are arbitrarily set in consideration of the kind of first molten solder 5a, the thickness of coating film 6, and the like. In addition, the shape of nozzle 13 and conditions including a spraying angle are also arbitrarily applied or set in consideration of the kind of first molten solder 5a, the thickness of coating film 6, and the like. The spraying angle is not particularly limited. However, a virtual angle between a center axis of nozzle 13 and the surface of substrate 1 is preferably set, for example, in a range of 30 to 45°. An atmosphere temperature during treatment in the removal step is maintained at a temperature allowing the molten state of first molten solder 5a to be maintained as it is. Such a temperature varies depending on the kind of first molten solder 5a to be used. However, in the above example using molten solder 5a having the melting point of around 217°C, the atmosphere temperature needs to be maintained at 240 to 260°C.

In this manner, an excess portion of first molten solder 5a adhered to electrode corrosion preventing layer 4 on electrode 2 is blown off to be removed. As a result, as shown in FIGs. 8(A) and (B) and FIGs. 9(C) and (D), there can be obtained intermediate component 10 where electrode corrosion preventing layer 4 has been provided on electrode 2 and thin first solder layer 5 has remained adhered on electrode corrosion preventing layer 4. The reason for the use of the term "intermediate" is that, after the component is stored or distributed as it is, second solder layer 8 is provided to be formed into mounting substrate 20 or the like, as shown in FIGs. 13 to 15(D). In addition, the words "excess first molten solder 5a" mean first molten solder 5a that is to be blown off and do not include first molten solder 5a remained adhered on electrode corrosion preventing layer 4.

Intermediate component 10 shown in FIGs. 8(A) and (B) and FIGs. 9(C) and 9(D) has electrode 2 on both sides thereof. In the electrode configuration on the BGA side, electrode patterns are formed, for example, by insulation film 80 having a thickness of approximately 10 to 30□m, and electrodes 2 each are provided at the bottom of a recess in an opening portion of insulating film 80, as shown on a lower surface of FIG. 8(A), on both surfaces of FIG. 8(B), and in FIG. 9(D). On the other hand, in the electrode configuration on the wiring pattern side, electrodes 2 each are provided in a protruding manner on substrate 1, as shown on an upper surface of FIG. 8(A) and in FIG. 9(C). Through the above-described individual treatments, electrode corrosion preventing layer 4 can be uniformly formed in both of the different electrode configurations as above, and finally, as shown in FIGs. 13 to 15(B), second solder layer 8 can be formed on electrode corrosion preventing layer 4. First solder layer 5 is, as shown in FIGs. 8(A) and (B), actually adhered with a thin thickness on electrode corrosion preventing layer 4 from which excess first molten solder 5a has been removed. FIGs. 9(A) and 9(B) depict an example before the adhesion.

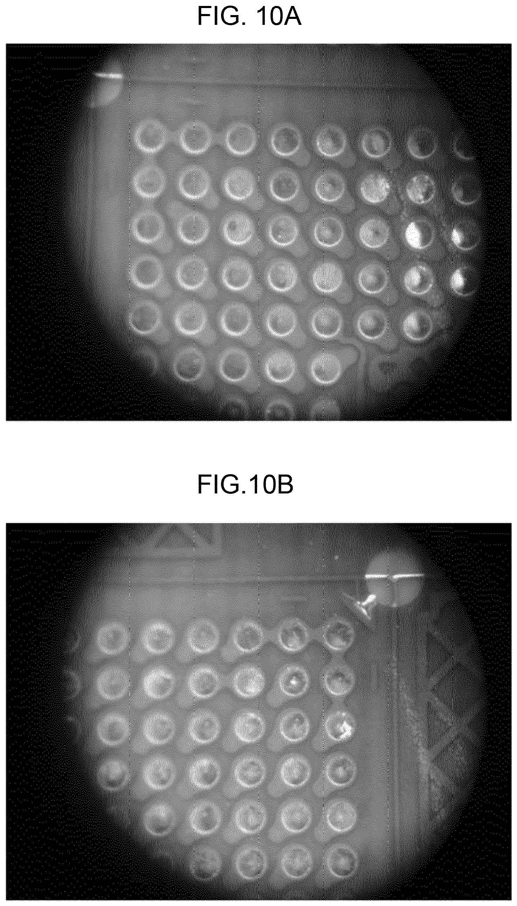

Now, a conventional example will be described with reference to examples of photomicrographs of FIGs. 10(A) and (B). There was used a component, as shown in FIG. 8(A), in which, on an upper surface of substrate 1 were arranged wiring patterns including protruding electrodes 2, and on a lower surface of substrate 1 were arranged BGA-side patterns including electrodes 2 provided at the bottoms of recesses (the depth is, for example, approximately 10 to 30µm) in opening portions of insulation film 80. The component was subjected to solder treatment by a conventional jet flow soldering method that applies a jet flow of molten solder from upper and lower directions while moving the component laterally. The photomicrograph of FIG. 10(A) depicts a soldered state of the BGA-side pattern electrodes provided on the lower surface of substrate 1. On the other hand, there was used a component having an upside-down structure of FIG. 8(A), in which on the upper surface of substrate 1 were arranged BGA-side patterns including electrodes 2 provided at the bottoms of recesses in opening portions of insulation film 80 and on the lower surface of substrate 1 were arranged wiring patterns including protruding electrodes 2. The component was subjected to soldering treatment by the conventional jet flow soldering method that applies a jet flow of molten solder from upper and lower directions while moving the component laterally. The photomicrograph of FIG. 10(B) depicts a soldered state of the BGA-side pattern electrodes provided on the upper surface of substrate 1.

As obvious from the results of FIGs. 10(A) and (B), when the BGA-side patterns were on the upper surface (FIG. 10(B)), the soldering was relatively good, whereas when it was on the lower surface (FIG. 10(A)), the soldering was insufficient and red color of the copper electrodes was observed. These results imply that, for the BGA-side patterns having a structure where molten solder can hardly enter the recesses, the conventional jet flow method performing soldering with a jet flow of solder from the lower direction is insufficient.

Meanwhile, in the step of adhering first molten solder 5a, as described in the first to third embodiments, the adhesion is performed by allowing first molten solder liquid flow 5a to collide with or spread over component 10' while moving component 10'. Accordingly, in either case, first molten solder 5a can be uniformly adhered onto electrode 2. As a result, electrode corrosion preventing layer 4 is uniformly formed on electrode 2, so that defect and deletion of electrode 2 can be prevented by electrode corrosion preventing layer 4.

### (Gas or Liquid of Organic Fatty Acid-Containing Solution)

When excess first molten solder 5a is removed using fluid 6a containing a gas or liquid of organic fatty acid-containing solution as shown in FIG. 3(E), a content of the gas or liquid of organic fatty acid-containing solution in the fluid 6a is preferably 3 to 20% by volume with respect to a total amount of the fluid 6a. By setting the content thereof in the above range, coating film 6 of organic fatty acid can be formed on electrode corrosion preventing layer 4 or on first molten solder 5a remained adhered on electrode corrosion preventing layer 4. The coating film 6 is a so-called coating of oil component and too thin to easily estimate the thickness thereof. Providing the coating film 6 gives an advantage that maximally prevents an oxide or the like from being formed on electrode corrosion preventing layer 4 or first molten solder 5a remained adhered on electrode corrosion preventing layer 4 even during a transfer to the sequential next step or even when distributed as it is. In addition, also upon contact with second molten solder 16 after that, the coating film 6 gives an advantage that maximally prevents the formation of an oxide or the like due to heat or the like caused by the contact on electrode corrosion preventing layer 4 or on first molten solder 5a remained adhered on electrode corrosion preventing layer 4.

When the content thereof was below 3% by volume, there were cases of poor soldering of second molten solder 16 onto electrode corrosion preventing layer 4 or first molten solder 5a remained adhered on electrode corrosion preventing layer 4. The reason for that seems to be due to that the thickness of the coating film 6 was too thin, resulting in the formation of an oxide. On the other hand, when the content thereof exceeded 20% by volume, the resulting effect was the same as that of the film of 20% by volume.

When excess first molten solder 5a is removed by ejecting fluid 6a of an organic fatty acid-containing solution, the organic fatty acid-containing solution to be used is preferably the same one as the solution used in the contact step described above (FIG. 3(B)). That is, it is preferable to use an organic fatty acid-containing solution containing 5 to 25% by mass of an organic fatty acid having 12 to 20 carbon atoms. Particularly preferred is an organic fatty acid-containing solution containing 5 to 15% by mass of palmitic acid having 16 carbon atoms, and according to need, an organic fatty acid having 12 to 20 carbon atoms, for example, stearic acid having 18 carbon atoms may also be included. In addition, the organic fatty acid-containing solution does not usually include additives such as metal salts, for example, nickel salt and cobalt salt, and an antioxidant, but may include such an additive as long as the efficacy of the present invention is not impaired.

The organic fatty acid-containing solution is preferably heated at the same temperature or roughly the same temperature as that of first molten solder 5a, and for example, the organic fatty acid-containing solution is heated to 180 to 280°C for use. When first molten solder 5a is provided, for example, similarly to the above, by ejecting in the range of 240 to 260°C, it is preferable to eject an organic fatty acid-containing solution having the same temperature of 240 to 260°C as that of first molten solder 5a to remove excess first molten solder 5a. In addition, the spray-ejected organic fatty acid-containing solution and first molten solder 5a removed together with the organic fatty acid-containing solution are separated by a specific gravity difference. First molten solder 5a sunken to the bottom of the organic fatty acid-containing solution can be taken out to be separates from the organic fatty acid-containing solution. The separated first molten solder 5a and the organic fatty acid-containing solution can be reused.

Similarly to the above, as the organic fatty acid included in the organic fatty acid-containing solution, there may be used an organic fatty acid having 11 or less carbon atoms. However, such an organic fatty acid is water absorbent and thus not very preferable when used in the above-mentioned high temperature range of 180 to 280°C. In addition, organic fatty acids having 21 or more carbon atoms have problems such as high melting point, poor permeability, and handling difficulty, and also reduce the anti-rust effect of coating film 6 deposited on the surface of first molten solder 5a. Preferably, palmitic acid having 16 carbon atoms is used, and particularly preferably, the palmitic acid alone is used. Then, according to need, an organic fatty acid having 12 to 20 carbon atoms, for example stearic acid having 18 carbon atoms, may also be included.

When the removal step as above is performed by ejection of only a gas flow of an inert gas, air, or the like, it is the case of adhesion treatment performed using first molten solder 5a purified with organic fatty acid-containing solution or the case of performing the adhesion treatment of first molten solder 5a not purified with organic fatty acid-containing solution and then adhering a gas or liquid of organic fatty acid-containing solution to first molten solder 5a. The organic fatty acid-containing solution to be used at that time is also the same one as that described above.

### <Cooling Step>

The cooling step is a step of cooling electrode 2 from which excess first molten solder 5a has been removed to less than the melting point of first molten solder 5a. By the cooling step, electrode corrosion preventing layer 4 formed on the surface of electrode 2 can be formed in a predetermined range of thickness without any crack, allowing the stabilization of electrode corrosion preventing ability of each portion. Electrode corrosion preventing layer 4 thus formed can prevent the corrosion of an electrode component occurring in conventional soldering when an electronic component is soldered onto a mounting substrate and thereby can significantly enhance the reliability of electrode 2 on a copper land or the like of the mounting substrate.

### (Cooling Conditions)

The temperature for cooling in the cooling step is set based on the melting point of first molten solder 5a used. For example, when the used first molten solder 5a is a quinary solder, a quaternary solder, or a ternary solder used in Examples described below, the melting point of the solder is around 217°C. Accordingly, the cooling temperature is preferably set to a temperature less than the melting point thereof. A lower limit of the cooling temperature is not particularly limited and may be set in a normal temperature range of approximately 20 to 50°C. Cooling in the above range allows electrode corrosion preventing layer 4 to be further stabilized.

The manner for cooling is desirably rapid cooling, and it is undesirable to cool slowly as letting it stand to cool. Rapid cooling can suppress a component (such as Sn) included in electrode corrosion preventing layer 4 provided on electrode 2 from combining with an electrode component (such as Cu) to cause corrosion. If cooling is done slowly as letting it stand to cool, a component (such as Sn) included in electrode corrosion preventing layer 4 continues to combine with an electrode component (such as Cu), resulting in the corrosion of the electrode component.

As an example of the rapid cooling, the time it takes from the contact of electrode 2 with first molten solder 5a to cooling after removing adhered first molten solder 5a is preferably 30 seconds or less. By rapidly cooling in the range, the above-described advantageous effects can be obtained.

As a rapid cooling means, contacting of a component that is to be subjected to the cooling step with an atmosphere below the melting point can facilitate rapid cooling. Particularly, it is preferable to contact the component with an atmosphere having a temperature 40°C or more lower than the melting point. The contact with such an atmosphere may be performed in a gas or liquid. Alternatively, a gas may be sprayed or a liquid may be spayed.

Particularly, in the case of first molten solder 5a purified with an organic fatty acid-containing solution, impurities and oxides in first molten solder 5a has been removed, and thus, there are advantages of high purity and facilitated rapid cooling. Meanwhile, in a case of slow cooling, dendrite may occur.

### (Electrode Corrosion Preventing Layer)

Electrode corrosion preventing layer 4 is a layer formed by a cooling treatment under the above-described conditions and preferably a layer made of a nickel-containing intermetallic compound having a thickness of 0.5 to 3 µm provided on electrode 2. To stabilize the elution preventing ability of the electrode corrosion preventing layer, electrode corrosion preventing layer 4 is preferably formed with a uniform thickness where defects or the like have been suppressed. For this uniformization, the cooling step is necessary. Setting the thickness of electrode corrosion preventing layer 4 in the above range by the cooling step can suppress a component (such as Sn) included in electrode corrosion preventing layer 4 provided on electrode 2 from combining with an electrode component (such as Cu) to cause corrosion. If the above-described cooling step is omitted, it is impossible in many cases to form at least an electrode corrosion preventing layer 4 with a thickness of 0.5 µm or more where defects or the like have been suppressed.

If the thickness of electrode corrosion preventing layer 4 is too thick, a fracture or a crack can occur in the electrode corrosion preventing layer itself. Accordingly, the thickness of a thickest part of the layer is preferably 3µm or less. Particularly preferably, a thinnest part of electrode corrosion preventing layer 4 is 0.5 µm or more and the thickest part thereof is 3 µm, as well as an average thickness of the entire electrode corrosion preventing layer 4 is 1 to 2 µm. The thickness of the layer was calculated based on results obtained at 100 measurement points from the results of cross-sectional observations using a scanning electron microscope and a transmission electron microscope.

In the present invention, as a preferable embodiment, there may be mentioned a case in which electrode 2 is made of copper or a copper alloy and first molten solder 5a includes at least tin as a main component and nickel as an accessory component, as well as includes, as an arbitrary component(s), one or two or more selected from silver, copper, zinc, bismuth, antimony, and germanium. In this case, a Cu-Ni-Sn intermetallic compound layer that is to be produced as electrode corrosion preventing layer 4 is preferably cooled to a temperature less than approximately 217°C, the melting point of first molten solder 5a. By the cooling step as above, a minimum thickness of the Cu-Ni-Sn intermetallic compound layer can be 0.5 µm or more and an average thickness thereof can be in the range of 1 to 2 µm. In this manner, a Cu-Ni-Sn intermetallic compound layer having neither crack nor brittleness can be uniformly formed on electrode 2, allowing the prevention of defects and deletion of electrode 2 due to the corrosion of electrode 2.

### <Step of Adhering Second Molten Solder>

This adhesion step is a step in which, after the step of cooling electrode 2 to less than the melting point of first molten solder 5a, component 10 having electrode corrosion preventing layer 4 formed on electrode 2 is contacted with the same molten solder as or a different molten solder from (referred to as "second molten solder") the above-described first molten solder 5a, and then second molten solder 16 is adhered onto electrode 2 to provide second solder layer 8.

### (Second Molten Solder)

Second molten solder 16 is not particularly limited and can be selected from solders having a variety of solder compositions. For example, the same solder as the above-described first molten solder 5a may be used again or a common solder other than that may be used. For example, second molten solder 16 may be a quinary, quaternary, or ternary solder containing nickel, a quaternary, ternary, or binary solder containing no nickel, which are used in Examples described below, a ternary solder used in Comparative Example described below, or a bismuth-based low temperature solder.

Second molten solder 16 may be the same as or different from the one described in the column of the above-described "Adhesion Step". For example, a molten lead-free solder is preferably used that includes tin as a main component and arbitrarily includes, as an accessory component(s), one or two or more selected from silver, copper, zinc, bismuth, nickel, antimony, and germanium.

In addition, second molten solder 16 may be a soldering paste as in the case of the above-described first molten solder 5a. Similarly to the above, a soldering paste that is to be molten in a range of approximately 150 to 300°C is preferably used, in which a preferably used soldering paste includes tin as a main component and arbitrarily includes, as an accessory component(s), one or two or more selected from silver, copper, zinc, bismuth, nickel, antimony, and germanium. Flux is also not particularly limited as long as various ones of the public knowledge are mixed. When a soldering paste is used as second molten solder 16, the soldering paste can be printed on electrode corrosion preventing layer 4 and then heated and molten to allow it to be contacted as second molten solder 16 onto electrode corrosion preventing layer 4.

As the solder that forms second molten solder 16, there may be used a nickel-containing solder similar to first molten solder 5a described above, such as an Sn-Ni based solder, an Sn-Cu-Ni based solder, an Sn-Ge-Ni based solder, an Sn-P-Ni based solder, an Sn-Cu-Ge-Ni based solder, an Sn-Cu-Ge-P-Ni based solder, an Sn-Ag-Cu-Ni based solder, an Sn-Zn-Al-Ni based solder, an Sn-Ag-Cu-Ge-Ni based solder, or an Sn-Sb-Ni based solder. In addition, examples of the low melting point solder include an Sn-Bi-Ni based solder, an Sn-Bi-Zn-Ni based solder, an Sn-Bi-Ag-In-Ni based solder, and the like. Examples of a solder including no nickel include an Sn-Cu based solder, an Sn-Ge based solder, an Sn-P based solder, an Sn-Cu-Ge based solder, an Sn-Cu-Ge-P based solder, an Sn-Ag-Cu based solder, an Sn-Zn-Al based solder, an Sn-Ag-Cu-Ge base solder, an Sn-Sb based solder, and the like. In addition, examples of a low melting point solder containing no nickel include an Sn-Bi based solder, an Sn-Bi-Zn based solder, an Sn-Bi-Ag-In based solder, and the like.

The above-described first molten solder 5a includes nickel as an essential component for forming electrode corrosion preventing layer 4. However, second molten solder 16 may not necessarily include nickel, since electrode corrosion preventing layer 4 is already present on the electrode. In other words, as second molten solder 16, a common, versatile solder, a bismuth-based solder, an inexpensive solder, any of solders with various characteristics, or the like can be arbitrarily employed.

Particularly, preferably, second molten solder 16 does not include a component causing an electrode corrosion preventing ability (such as nickel) among ingredients forming electrode corrosion preventing layer 4,. By doing this, on previously formed electrode corrosion preventing layer 4 is provided second solder layer 8 including no component causing the electrode corrosion preventing ability. Such second solder layer 8 can suppress a phenomenon of increasing the thickness of electrode corrosion preventing layer 4 occurring when a component(s) of electrode corrosion preventing layer 4 and a component(s) of second solder layer 8 are the same. This can consequently further enhance the reliability of electrode 2 of component 10 soldered with second solder layer 8.

### (Adhesion Treatment)

Adhesion treatment can be performed by various methods. For example, as shown in FIGs. 11 and 12, an adhesion treatment may be employed in which component 10 having electrode corrosion preventing layer 4 on electrode 2 is dipped in a solder bath filled with second molten solder 16 to allow second molten solder 16 to adhere onto electrode corrosion preventing layer 4. In addition, although not shown in the drawings, there may be employed an adhesion treatment in which a soldering paste is used as second molten solder 16, printed on electrode corrosion preventing layer 4, and then heated and molten to adhere second molten solder 16 onto electrode corrosion preventing layer 4. Alternatively, any other adhesion treatment other than those may be used. By performing any of the adhesion treatments, there can be obtained component 20 having second solder layer 8 (see FIG. 13).

First, a description will be given of the case of dipping component 10 having electrode corrosion preventing layer 4 on electrode 2 in a solder bath filled with second molten solder 16.

Second molten solder 16 is, as shown in FIGs. 11 and 12, filled in a solder bath that can be heated to a predetermined temperature and can be kept heated. The temperature is arbitrarily set depending on the kind of the solder to be used. Usually, the solder is heated to a temperature range of 20 to 100°C higher than the melting point of the solder to be used, and then molten for use. The solder bath may be, as shown in FIG. 11, a bath filled only with second molten solder 16 or, as shown in FIG. 12, a bath filled with second molten solder 16 and thereon filled with organic fatty acid-containing solution 18.

In the solder bath shown in FIG. 11, component 10 having electrode corrosion preventing layer 4 on electrode 2 is dipped to allow second molten solder 16 to adhere onto electrode corrosion preventing layer 4, whereby there can be obtained component 20 having second solder layer 8 (see FIG. 13). Immediately before providing second molten solder 16, it is preferable to contact the component with an organic fatty acid-containing solution. The contact means is not particularly limited, but for example, a gas or liquid of organic fatty acid-containing solution may be ejected to component 10 or component 10 may be exposed to a gas or liquid of organic fatty acid-containing solution. The organic fatty acid-containing solution to be used here is preferably the same one as first organic fatty acid-containing solution 3a contacted before the adhesion of first molten solder 5a. The description thereof will be omitted here.

In the solder bath shown in FIG. 12, before immersing in second molten solder 16, component 10 is dipped in organic fatty acid-containing solution 18 filled on second molten solder 16 and then dipped in second molten solder 16 to adhere second molten solder 16 onto electrode corrosion preventing layer 4. Furthermore, when pulling up component 10 after that, the component having second molten solder 16 adhered thereto can be contacted again with organic fatty acid-containing solution 18. In this manner, for example, even if any impurity, oxide, or the like adheres onto electrode corrosion preventing layer 4 or first solder layer of electrode corrosion preventing layer 4 during a process of storage, transfer, or distribution, the impurity, oxide, or the like can be removed by organic fatty acid-containing solution 18, and in that state, the component can be contacted with second molten solder 16. This can suppress the presence of an impurity, an oxide, or the like between electrode corrosion preventing layer 4 and second molten solder 16. Accordingly, second molten solder 16 can be provided on electrode corrosion preventing layer 4 under high connection reliability.

In addition, as shown in FIG. 12, when pulling up the component, the component is contacted again with organic fatty acid-containing solution 18 and therefore, the organic fatty acid-containing solution can be adhered onto a surface of second molten solder 16. The adhesion of the organic fatty acid-containing solution to the surface of second molten solder 16 allows coating film 9 of organic fatty acid to be provided on second solder layer 8. Such a coating layer 9 is a so-called coating of oil component and too thin to easily estimate the thickness thereof. Providing the coating film 9 gives an advantage that makes it difficult to form any oxide or the like on second solder layer 8, even during a transfer to the sequential next step or even when distributed as it is. The organic fatty acid-containing solution 18 to be used here is preferably the same one as first organic fatty acid-containing solution 3a contacted with the component before adhesion of first molten solder 5a. A description thereof will be omitted here.

In the present invention even when the component is exposed to such a hard condition of dipping in second molten solder 16, the stable electrode corrosion preventing layer 4 provided in advance on the electrode can further suppress a difference in electrode corrosion between a first dipped (immersed) top end portion and a lastly dipped rear end portion. Accordingly, a difference in reliability of electrode 2 between the individual portions of the same component 20 can be maximally suppressed. As a result, there can be provided component 20 with good yield and high reliability. Furthermore, mounting or the like of an electronic component on component 20 having solder layer 8 formed with a predetermined thickness can be performed at low cost and with high reliability. In addition, as shown in FIGs. 11 and 12, even when the component 20 having solder layer 8 provided in the dipping step is sequentially subjected to a plurality of heat treatments (reflow furnace) in a mounting step of mounting an electronic component on the solder layer 8, electrode corrosion preventing layer 4 can suppress the corrosion of electrode 2 due to the heat treatments to maintain the reliability of component mounting at soldered joints. Additionally, as described above, solder layer 8 provided on electrode corrosion preventing layer 4 further suppresses the occurrence of voids and the occurrence of defects, so that the reliability of component mounting at the soldered joints can be maintained.

Next, a description will be given of the case in which a soldering paste is printed on component 10 having electrode corrosion preventing layer 4 on electrode 2 and then heated and molten to adhere the solder as second molten solder 16.

The soldering paste to be used here (referred to also as solder paste) is a composite paste material of solder powder and a flux. Solder paste is used as a bonding material in a printing step of a method for soldering an electronic component by surface mounting technology (SMT). In the present invention, such a solder paste can be used as second molten solder 16. The solder paste to be used is preferably a solder paste molten in the range of approximately 150 to 300°C, in which a preferably used solder paste includes tin as a main component and arbitrarily includes, as an accessory component(s), one or two or more selected from silver, copper, zinc, bismuth, nickel, antimony, and germanium. Flux is not particularly limited as long as various ones of the public knowledge are mixed. When using solder paste, the solder paste can be printed on a predetermined electrode 2 and then heated and molten to allow it to be contacted as second molten solder 16 onto electrode 2.

In the present invention, when heating treatment is performed in a reflow furnace or the like after printing of the solder paste on the electrode and mounting of an electronic component or the like on the printed solder paste, the soldering paste is molten to serve as second molten solder 16, which adheres onto electrode 2 and solders the mounted electronic component. Even through such a heat treatment, stable electrode corrosion preventing layer 4 formed in advance on the electrode can suppress the difference in electrode corrosion between individual electrode portions, which can minimize the difference in the reliability of electrode 2 between the individual portions of the same component 20. As a result, there can be provided component 20 with good yield and high reliability.

### (Second Solder Layer)

Second solder layer 8 is a layer formed by the step of adhering second molten solder 16 described above. The second solder layer 8 is, as shown in FIG. 13 to FIGs. 18, is formed in a smoothly curved, swollen shape on electrode 2 where electrode corrosion preventing layer 4 has been formed.

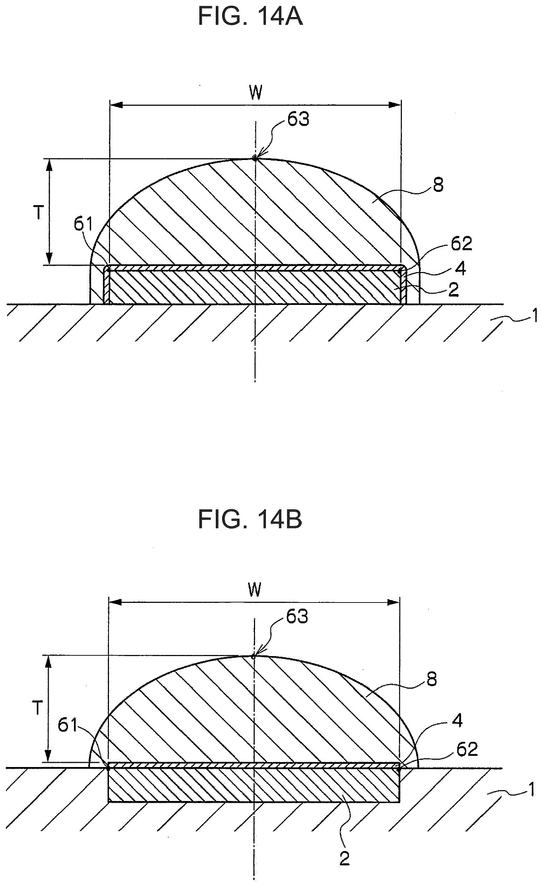

Solder layer 8 is, as shown in FIGs. 14(A) to 15(B), provided with a predetermined thickness T on electrode corrosion preventing layer 4 with a predetermined thickness. The shape thereof is a hemispherical shape or smooth curved surface shape bilaterally symmetric or point symmetric with respect to center position 63 of electrode width W. Reference numerals 61 and 62 represent edges of electrode 2 intersecting a straight line passing through center position 63 of electrode width W, and electrode width W corresponds to a length between the edges 61 and 62. Then, solder layer 8 is swollen between the edges 61 and 62 and formed in a cross-sectional shape and a planar view shape bilaterally symmetric or point symmetric with respect to center position 63. A thickness T of solder layer 8 corresponds to a height from the surface of electrode corrosion preventing layer 4 to a top portion of solder layer 8. Since solder layer 8 is provided in the cross-sectional shape and the planar view shape bilaterally symmetric or point symmetric with respect to center position 63, the top portion of solder layer 8 corresponds to center position 63. In FIGs. 14(A) to 15(B), coating film 9 is omitted.

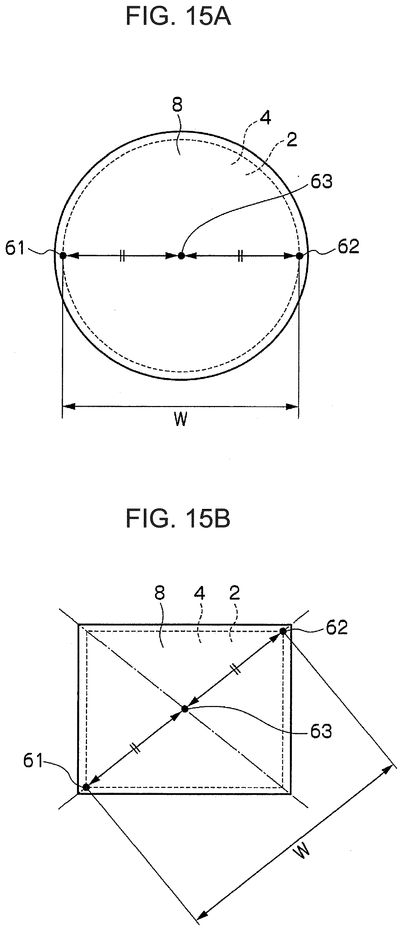

Solder layer 8 is, regardless of whether formed to cover electrode 2 provided on substrate 1 (FIG. 14(A)) or formed on electrode 2 embedded in substrate 1 (FIG. 14(B)), provided with almost the same shape and the same thickness T, with stability and good yield, as long as solder composition and soldering conditions are the same. In addition, regardless of whether formed on electrode 2 having a circular shape in a planar view (FIG. 15(A)) or formed on electrode 2 having a rectangular shape such as an oblong shape, a square shape, or a diamond shape) in a planar view (FIG. 15(B)), solder layer 8 is symmetrically provided with respect to center position 63 of electrode 2 in a planar view. For example, in FIG. 15(A), a straight line indicating a diameter of electrode 2 having a circular shape passes through center position 63 and solder layer 8 is provided point-symmetrically around center position 63. In addition, also in FIG. 15(B), a diagonal line of electrode 2 having an oblong shape passes through center position 63 and solder layer 8 is provided point-symmetrically around center position 63.

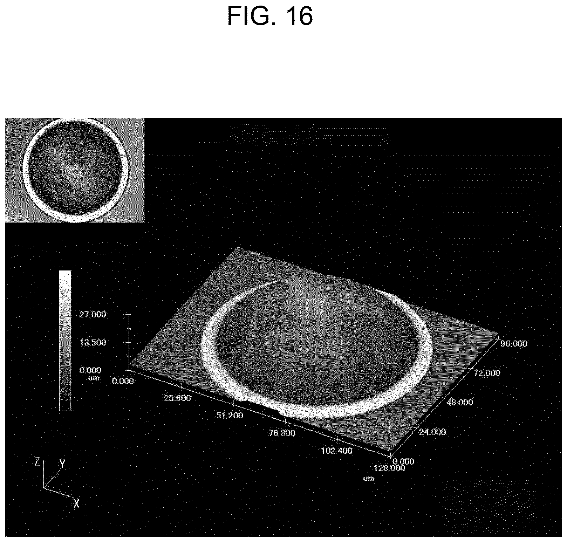

FIG. 16 is a scanning tunneling micrograph depicting an example of the shape of solder layer 8 provided on electrode corrosion preventing layer 4, and FIGs. 17(A) to (C) are scanning tunneling micrographs depicting an example of a sectional shape of solder layer 8 provided on electrode corrosion preventing layer 4. As shown in such examples, solder layer 8 is formed in a smoothly curved, swollen shape on electrode 2 where electrode corrosion preventing layer 4 has been formed.

The shape of such solder layer 8 is a shape obtained as a result of manufacturing by the manufacturing method according to the present invention described above. This seems to be due to that (i) purified first molten solder 5a was adhered onto electrode 2 treated with organic fatty acid-containing solution to provide electrode corrosion preventing layer 4 having the thickness of at least 0.5 to 3 µm and the average thickness of 1 to 2 µm, uniformly without any crack; (ii) by cooling electrode 2 to less than the melting point of first molten solder 5a, electrode corrosion preventing layer 4 having the thickness of at least 0.5 to 3 µm and the average thickness of 1 to 2 µm was further stabilized so that the layer was uniformly formed with no crack; and (iii) second molten solder 16 (preferably purified) was adhered onto electrode corrosion preventing layer 4 purified with organic fatty acid-containing solution. This phenomenon seems to be a result that the smooth second molten solder 16 having low viscosity has easily wettingly spread on highly wettable electrode corrosion preventing layer 4 to be swollen on electrode corrosion preventing layer 4 due to surface tension. Then, the swollen solder layer 8 seems to be formed as a uniform and highly reliable solder layer.

Viscosities of first molten solder 5a and second molten solder 16 can be controlled by the above-described purification treatment. For example, although each of the molten solders has an arbitrary viscosity, the present invention allows the viscosity of first molten solder 5a to be in a range of 0.002 to 0.004 Pa· s and the viscosity of second molten solder 16 to be in a range of 0.002 to 0.008 Pa·s, respectively, by the purification treatment. By setting the viscosity of first molten solder 5a in the above range, first molten solder 5a can be uniformly adhered onto each electrode 2 formed in a micropattern, and furthermore, first molten solder 5a can be easily removed. As a result, electrode corrosion preventing layer 4 can be uniformly formed on each electrode 2 formed in the micropattern, allowing the prevention of electrode corrosion.

In addition, by setting the viscosity of second molten solder 16 in the above range, second molten solder 16 having the wide viscosity range described above can be contacted with component 10 having electrode corrosion preventing layer 4 formed by contacting first molten solder 5a with electrode 2. Such a second molten solder 16 includes a versatile molten lead-free solder, so that soldering can be performed with a molten solder prepared by melting an inexpensive solder. Even in this case, electrode corrosion can be prevented.

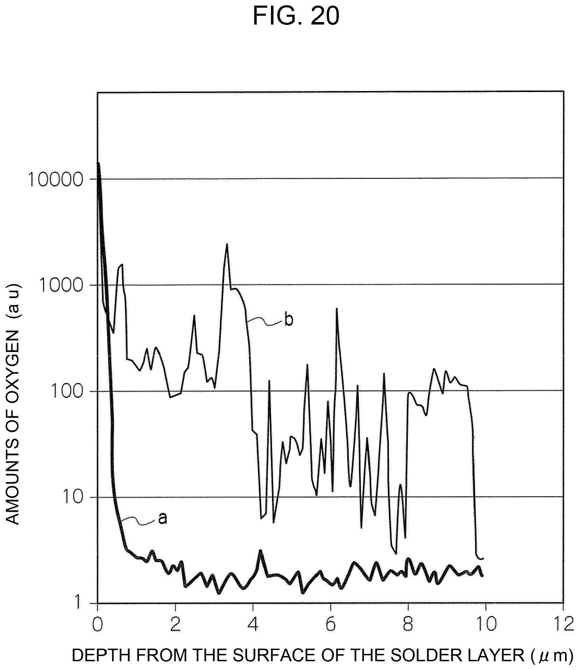

As described in Examples below, depending on the presence or absence of the purification treatment or depending on the time for purification treatment, oxides, impurities, and the like in solder can be further reduced and the viscosity of molten solder can be reduced. For example, when an unpurified molten solder with the melting point of approximately 217°C has a viscosity of 0.007 Pa·s at 250°C, the viscosity of the molten solder at 250°C can be reduced down from 0.004 Pa·s to 0.002 Pa·s by performing the purification treatment and then gradually extending the time for the treatment. Such a viscosity reduction comes from the reduction of amounts of oxides and impurities contained in the solder, and the reduction of amounts of such oxides and impurities is obvious also from results of FIG. 20. In addition, as described in Examples and the like below, the reduction of amounts of oxides and impurities improves solder wettability. In this manner, even in soldering onto microelectrode patterns, solder layer 8 with a predetermined thickness can be formed in such a manner so as to cause no bridge, uniformly and with good yield in a smoothly curved and swollen shape as mentioned above.

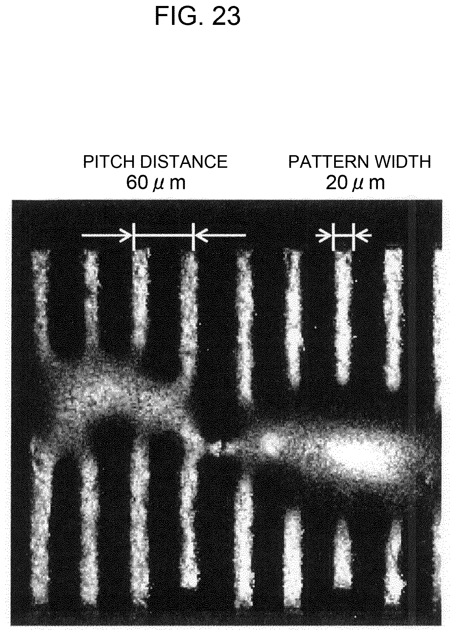

FIG. 23 is a photograph depicting a conventional example in which a solder layer has been provided on electrodes. As seen in the photograph, when the manufacturing method according to the present invention is not applied, the thickness of the solder layer is not uniform and furthermore, a bridge can be formed.

As shown in Examples below, when width W of copper electrode was 60 µm, solder layer 8 with a thickness T of approximately 25 µm was able to be formed on electrode corrosion preventing layer 4 having an average thickness of approximately 1 µm. When width W of copper electrode was 30 µm, solder layer 8 with a thickness T of approximately 15 µm was able to be formed on electrode corrosion preventing layer 4 having the average thickness of approximately 1 µm. When width W of copper electrode was 15 µm, solder layer 8 with a thickness T of approximately 10 µm was able to be formed on electrode corrosion preventing layer 4 having the average thickness of approximately 1 µm. Accordingly, it is possible to form solder layer 8 in a range of [thickness T of solder layer 8]/[width W of copper electrode] = 0.3 to 0.7.

### <Step of Contacting Organic Fatty Acid-Containing Solution>

This contact step is a step of contacting a gas or liquid of a third organic fatty acid-containing solution with second molten solder 16 after the step of adhering second molten solder 16. For example, as shown in FIG. 11, when the component has been dipped in second molten solder 16 and then pulled up as it is, the contact step is performed by ejecting a gas or liquid of the third organic fatty acid-containing solution to the component after having been pulled up (the ejection is not shown in the drawing). On the other hand, regarding this contact step, for example as shown in FIG. 12, when the component is dipped in second molten solder 16 and then contacted with organic fatty acid-containing solution 18, the contact step is the contact step referred to here.

The contact of the third organic fatty acid-containing solution with component 20 after the step of adhering second molten solder 16 may be, for example, as shown in FIG. 12, performed by dipping component 20 in third organic fatty acid-containing solution 18, or for example, as shown in FIG. 3(B) and FIG. 4(B), performed by ejecting a gas or liquid of third organic fatty acid-containing solution 18 from a nozzle to component 20. The gas of third organic fatty acid-containing solution 18 to be ejected may be a steam of the organic fatty acid-containing solution or a mixture gas with nitrogen or air. In the case of mixture gas, it is preferable to mix at least the steam of the organic fatty acid-containing solution in an amount of an extent allowing the steam to adhere uniformly onto second solder layer 8.

The third organic fatty acid-containing solution to be used here is preferably the same one as first organic fatty acid-containing solution 3a contacted before the adhesion of first molten solder 5a. A description thereof will be omitted here.

The contact step forms coating film 9 of organic fatty acid for preventing oxidation and contamination on the surface of second molten solder 16 or on second solder layer 8 formed by solidification of second molten solder 16. As a result, component 20 having second solder layer 8 can be stored or distributed without immediate treatment. In addition, there can be manufactured component 20 capable of providing a high quality connection structure that does not deteriorate the reliability of connection structure of an electronic component, even when subjected to a step of mounting a mounted component after storage or distribution.

### (Others)

In component 20 after having been contacted with the third organic fatty acid-containing solution, the third organic fatty acid-containing solution can be drained off by air, an inert gas, or the like ejected from the nozzle. The draining off allows the removal of excess third organic fatty acid-containing solution adhered onto component 2.

In addition, the adhered third organic fatty acid-containing solution may be removed. The removal of the third organic fatty acid-containing solution can be performed by dipping in a commonly used organic detergent or an inorganic detergent such as an alkaline detergent, shower cleaning, or the like using such a detergent. In this case, ultrasonic cleaning in combination with ultrasonic may be performed. After removing the third organic fatty acid-containing solution by a cleaning solvent, various treatments commonly performed on a mounting substrate, such as pure water cleaning, may be carried out.

### [Component]

Components 20, 30, and 40 are, as shown in FIGs. 13 to 19(B), those manufactured by the method for manufacturing a component according to the present invention described above. Then, the components are provided with a plurality of electrodes 2 on each of which is provided solder layer 8, and between solder layer 8 and electrode 2 is formed electrode corrosion preventing layer 4. Furthermore, solder layer 8 is formed in a smoothly curved swollen shape on electrode 2 on which electrode corrosion preventing layer 4 has been formed. In addition, preferably, coating film 9 of organic fatty acid is provided on solder layer 8.

Examples of the components include substrates such as a printed circuit board shown in FIG. 13 and electronic components such as a chip capacitor shown in FIGs. 18(A) and (B), an LGA (Land Grid Array) shown in FIG. 19(A), and a BGA (Ball Grid Array) shown in FIG. 19(B). Examples of substrate 20 include various substrates such as a printed circuit board, a wafer, and a flexible substrate. Particularly, in wafers, the width and pitch of electrodes are narrow. Thus, the manufacturing method according to the present invention is preferably applied and can form solder layer 8 with high precision on narrow-pitch microelectrodes. Additionally, also in cases of a printed circuit board or flexible substrate where a large electronic component is to be provided, the surface of solder layer 8 can be maintained in a cleaned state or treated in the subsequent step, so that the substrate can be used as reliable substrate.

In addition, examples of electronic components 30 and 40 include semiconductor chips, semiconductor modules, IC chips, IC modules, dielectric chips, dielectric modules, resistor chips, resistor modules, and the like.

In such substrates and electronic components, even when heated in a reflow furnace, a combustion furnace, or the like subsequently, electrode corrosion preventing layer 4 blocks the corrosion of electrode 2. This consequently prevents the reduction of reliability of electrically connected portions (electrode portions) in a process for mounting an electronic component performed through various steps and enables manufacturing with good yield. Therefore, highly reliable substrates and electronic components can be manufactured at low cost.

### Examples

Hereinafter, the present invention will be described in more detail with reference to Examples and a Comparative Example.

### [Example 1]

As an example, there was prepared substrate 10' where copper wiring patterns with a width W of 50 µm and a thickness of 20 µm have been formed on printed circuit board 1 with a length of 100 mm and a width of 100 mm (for example, see FIG. 3(A)). In substrate 10', among the copper wiring patterns, only copper electrodes 2 with the width W of 50 µm, which will be portions for mounting an electronic component, are exposed in great numbers, and the other copper wiring patterns are covered with an insulation layer.

As first organic fatty acid-containing solution 3a that is to be ejected in advance to copper electrodes 2, an organic fatty acid-containing solution was prepared by including 10% by mass of palmitic acid in an ester synthetic oil containing no metal salts such as nickel salt and cobalt salt, no antioxidants, and the like. The temperature of first organic fatty acid-containing solution 3a was controlled to 150°C. First molten solder 5a used was prepared using a quinary lead-free solder (melting point: approximately 217°C) consisting of Ni: 0.05% by mass, Ge: 0.005% by mass, Ag: 3% by mass, Cu: 0.5% by mass, and Sn for the rest. The quinary solder was strongly stirred in the same organic fatty acid-containing solution as the above-described first organic fatty acid-containing solution 3a under a condition of 250°C for purification. The prepared first molten solder 5a had a viscosity of 0.0035 Pa·s at 250°C.

The prepared first organic fatty acid-containing solution 3a was heated to 150°C and sprayed onto substrate 10' to provide organic fatty acid coating film 3 on copper electrodes 2 (for example, see FIG. 3(B)). The organic fatty acid coating film 3 is adhered as a result of copper surface cleaning with the first organic fatty acid-containing solution 3a. Sequentially, a liquid flow (250°C) of the prepared first molten solder 5a was sprayed to substrate 10' subjected to coating treatment (for example, see FIG. 3(C)). On copper electrodes 2 to which first molten solder 5a had been sprayed, first molten solder 5a was adhered and formed into a swollen shape (for example, see FIG. 3(D)).

Sequentially, excess first molten solder 5a swollen on the copper electrodes was removed (for example, see FIG. 3(E)). As a means for the removal, using ejection nozzle 13, second organic fatty acid-containing solution 6a having the same composition as that of the above-described first organic fatty acid-containing solution 3a and heated to 250°C was ejected from ejection nozzle 13. It took 10 seconds in total from the spraying of first molten solder 5a on the copper electrodes until the excess solder was removed with the second organic fatty acid-containing solution 6a and then first molten solder 5a was cooled down to 200°C that is less than the melting point thereof by spraying an air flow to the component. As a result, there was obtained component 10A having a shape shown in FIG. 3(F). In the component 10A, on copper electrodes 2 are provided electrode corrosion preventing layer 4, a solder layer (a solder layer remaining after removal, which is not shown), and coating film 6 in this order.

In this manner, there was obtained component 10A according to Example 1 including electrode corrosion preventing layer 4. Cross-sectional observation thereof using an electron microscope allowed confirmation that on copper electrodes 2 of component 10A was provided electrode corrosion preventing layer 4 with a thickness of approximately 1.5 µm, having no crack. In addition, it was also confirmed that on electrode corrosion preventing layer 4 was adhered first solder layer 5 with a thickness of approximately 1 µm and on the first solder layer 5 was adhered thin coating film 6. These manufacturing conditions and results were shown in Table 1 and evaluation results were shown in Table 2.

### [Example 2]

Component 10A obtained in Example 1 was dipped (immersed) in a solder bath filled with second molten solder 16 set at 250°C. As second molten solder 16, a ternary lead-free solder consisting of Ag: 3% by mass, Cu: 0.5% by mass, and Sn for the rest was used. The time for substrate immersion in the solder bath was 10 seconds in total. These manufacturing conditions and results were shown in Table 1 and evaluation results were shown in Table 2.

In this manner, there was obtained a substrate of Example 2 having second solder layer 8 provided thereon. Cross-sectional observation using an electron microscope showed that on copper electrodes 2 having the width W of 50 µm was provided electrode corrosion preventing layer 4 with the thickness of approximately 1.5 µm having no crack and on electrode corrosion preventing layer 4 was provided second solder layer 8 with a thickness T of 20 µm.

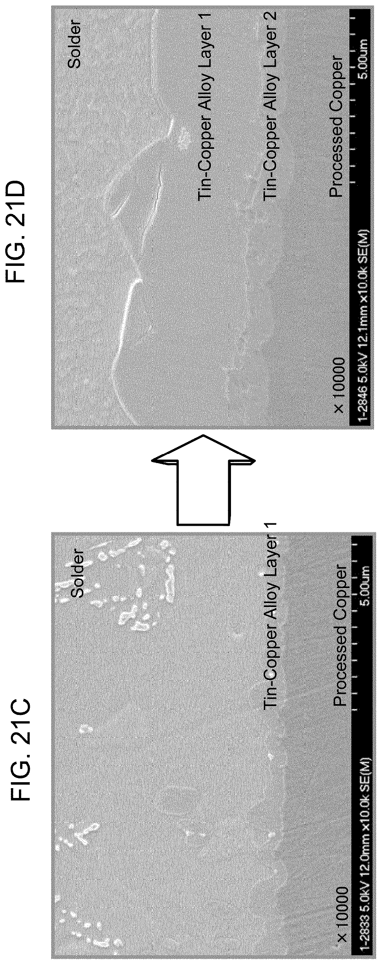

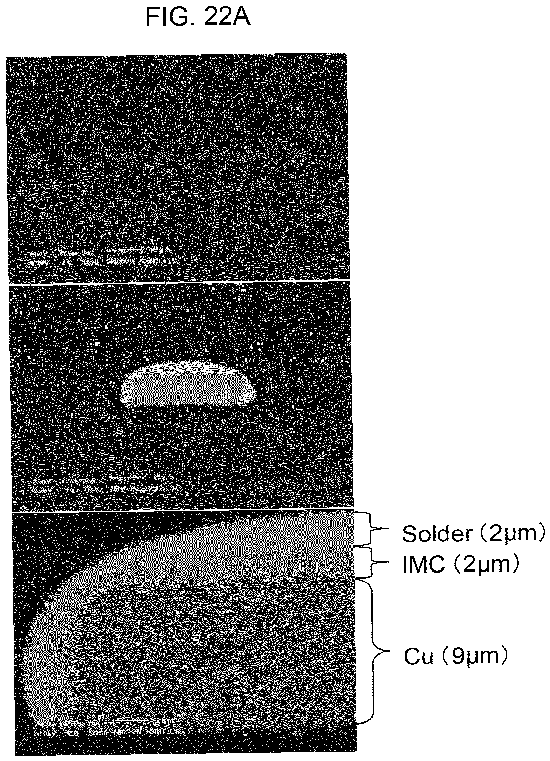

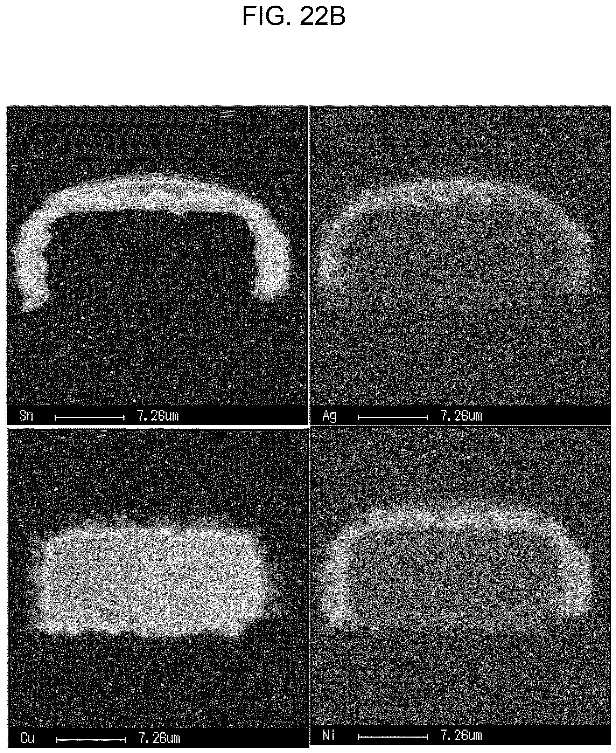

FIG. 21(C) depicts a scanning electron micrograph shape of a cross section of second solder layer 8 of the obtained substrate (for example, see FIG. 13). From the cross-sectional photograph of FIG. 21(C), the thickness of Cu-Ni-Sn intermetallic compound layer 4 was measured by the scanning electron micrograph and it was found that the layer was uniformly formed with the thickness of approximately 1.5µm. In addition, cross-sectional observation of electrodes of individual portions of the substrate showed that there was no significant difference in electrode corrosion between the electrodes of a portion first dipped in the solder bath and the electrodes of a portion lastly dipped therein. In addition, FIG. 21(D) depicts a scanning electron micrograph shape of the cross section of second solder layer 8 obtained after aging for 240 hours at 150°C. No defects such as a void occurred. Additionally, the cross-section thereof was evaluated using an element mapping produced by an X-ray microanalyzer (EPMA) and shown in FIGs. 22(A) and (B).

### [Example 3]

The palmitic content in first organic fatty acid-containing solution 3a in Example 1 was changed to 15% by mass and then the solution was heated to 250°C to be ejected to electrodes. In the step of removing excess first molten solder 5a swollen on copper electrodes, substrate 10 was placed under a steam atmosphere of second organic fatty acid-containing solution 6b set at 255°C. Then, under the atmosphere thereof, ejection nozzle 13 ejected nitrogen gas heated to 255°C (see FIG. 4(E)). The second organic fatty acid-containing solution 6b used was a steam at 255°C of an organic fatty acid-containing solution having the same composition as that of first organic fatty acid-containing solution 3a. As a result, there was obtained substrate 10B having a shape shown in FIG. 4(F). In substrate 10B, on copper electrodes 2 are provided electrode corrosion preventing layer 4, a solder layer (a solder layer remaining after removal, which is not shown), and coating film 6 in this order. These manufacturing conditions and results were shown in Table 1 and evaluation results were shown in Table 2.

In this manner, there was obtained substrate 10B according to Example 3 having electrode corrosion preventing layer 6 thereon. Cross-sectional observation using an electron microscope confirmed that on copper electrodes 2 of substrate 10B was provided electrode corrosion preventing layer 4 with the thickness of approximately 1.5 µm, then, on electrode corrosion preventing layer 4 was provided first solder layer 5 with a thickness of approximately 0.5 µm, and on the first solder layer 5 was adhered thin coating film 6. In addition, Removal of excess solder at 255°C enabled the minimization of the amount of excess solder remaining on electrode corrosion preventing layer 4.

### [Example 4]

Substrate 10B obtained in Example 3 was dipped (immersed) in a solder bath filled with second molten solder 16 set at 250°C. As second molten solder 16, a ternary lead-free solder consisting of Ag: 3% by mass, Cu: 0.5% by mass, and Sn for the rest was used. The time for substrate immersion in the solder bath was 10 seconds in total. These manufacturing conditions and the results were shown in Table 1 and evaluation results were shown in Table 2.

In this manner, there was obtained a substrate of Example 4 having second solder layer 8 provided thereon. Cross-sectional observation using an electron microscope showed that on copper electrodes 2 having the width W of 50 µm was provided electrode corrosion preventing layer 4 with the thickness of approximately 1.5 µm and on electrode corrosion preventing layer 4 was provided second solder layer 8 with the thickness T of approximately 20 µm . Similarly to Example 2, observation was made using a scanning electron micrograph shape of a cross section of second solder layer 8 of the obtained substrate (for example, see FIG. 13). The same results as those of Example 2 were obtained, where electrode corrosion preventing layer 4 was uniformly formed with the thickness of 1.5 µm, and no defects such as a void were observed in the cross section of second solder layer 8 after aging for 240 hours at 150°C.

### [Examples 5 to 10]

In Examples 5 to 10, components were manufactured in the same manner as in Examples 1 to 4 described above. The manufacturing conditions and results thereof were shown in Table 1 and evaluation results were shown in Table 2. In all cases, suppression of electrode corrosion was confirmed.

### [Comparative Example 1]

A substrate of Comparative Example 1 was obtained in the same manner as Example 1 except for using, as the solder material of first molten solder 5a in Example 1, a ternary lead-free solder consisting of Ag: 3% by mass, Cu: 0.5% by mass, and Sn for the rest. Similarly to Example 1, cross-sectional observation of scanning electron micrographs confirmed that there was no Cu-Ni-Sn intermetallic compound layer (see FIG. 21(A)), whereas on copper electrodes 2 was formed a Cu-Sn intermetallic compound layer and large electrode corrosion occurred. In addition, FIG. 21(B) depicts a scanning electron micrograph shape of the cross section of second solder layer 8 obtained after aging for 240 hours at 150°C. Defects such as voids were observed.

[Table 1] at the end of the specification

[Table 2] at the end of the specification

### [Example 11]

This Example 11 examined that it is preferable that second molten solder 16 does not include the component causing the electrode corrosion preventing ability among components forming electrode corrosion preventing layer 4. Soldering treatment means a treatment for adhering molten solder to electrodes. Regardless of the kinds of solders used below (all had the melting point of around 217°C), solder adhering treatment was performed, as shown in FIG. 3, by spraying a liquid flow of molten solder heated to 250°C and molten from nozzle 12 to allow the solder to be swollen on electrodes 2, The excess solder removal treatment after the adhesion treatment was performed in both cases, after the adhesion of first molten solder 5a and after the adhesion of second molten solder 16, since the present Example was intended to observe the formation shape of electrode corrosion preventing layer 4. The removal treatment was performed by spraying air to molten solders 5a or 16 swollen on the electrodes 2. Soldering treatment times below correspond to the time it took from the contact of the electrodes 2 with molten solder 5a or 16 to the removal of excess solder 5a or 16 swollen on the electrodes 2. During the times, the temperatures of molten solders 5a and 16 were maintained.

FIG. 24(A) is a plan view depicting copper electrode patterns before the soldering treatment; FIG. 24(B) is a cross-sectional view of the copper electrode patterns; FIG. 24(C) is an enlarged view of the cross-sectional view; and FIG. 24(D) is a cross-sectional view of copper electrode 2. As the copper electrode 2, there was prepared a copper electrode with a pattern width of 40 µm and a thickness of 22 µm, which was cleaned with pure water, dried, and then, to which a liquid flow of first organic fatty acid-containing solution 3a was ejected from nozzle 11. The copper electrode 2 was subjected to the subsequent soldering treatment.

FIGs. 25(A) to (D) are cross-sectional views of electrodes depicting an example in which, without performing a two-stage treatment (the adhesion treatment of first molten solder 5a and the adhesion treatment of second molten solder 16) on the prepared copper electrodes 2, one-time soldering treatment was performed on the electrodes and then excess solder was removed. FIG. 25(A) depicts a case of a treatment with a molten solder including no nickel (Sn-3Ag-0.5Cu) for 5 seconds, and FIG. 25(B) depicts a case of a treatment with the same molten solder for 60 seconds. In addition, FIG. 25(C) depicts a case of a treatment with a molten solder including 0.01% by mass of nickel (Sn-3Ag-0.5Cu-0.01Ni-0.006Ge) for 5 seconds, and FIG. 25(D) depicts a case of a treatment with the same molten solder for 60 seconds.

As obvious from the results, when the solder treatment time was 5 seconds, corrosion of copper electrodes 2 was small regardless of the kind of the solder. As shown in FIG. 25(C), in the case of the treatment with the nickel-containing solder, electrode corrosion preventing layer 4 with a thickness of around 1 µm was formed on the electrodes. On the other hand, when the soldering treatment time was 60 seconds, corrosion of copper electrodes 2 was confirmed regardless of the kind of the solder. The case of the treatment with the nickel-containing solder showed a minor level of corrosion and moreover maintained almost the initial electrode shape. However, from a cross-sectional observation thereof, it was confirmed that electrode corrosion preventing layer 4 was very thick (approximately around 4 µm) and the electrode shape was almost maintained by electrode corrosion preventing layer 4.

FIGs. 26(A) to (D) depict an example of treatments with molten solders including further increased nickel contents. Specifically, similarly to the above, FIGs. 26(A) to (D) are cross-sectional views of electrodes depicting the case in which, without performing the two-stage treatment (the adhesion treatment of first molten solder 5a and the adhesion treatment of second molten solder 16) on the prepared copper electrodes 2, one-time soldering treatment was performed on the electrodes and then excess solder was removed. FIG. 26(A) depicts a case of a treatment with a molten solder including 0.03% by mass of nickel (Sn-3Ag-0.5Cu-0.03Ni-0.006Ge) for 5 seconds, and FIG. 26(B) depicts a case of a treatment with the same molten solder for 60 seconds. In addition, FIG. 26(C) depicts a case of a treatment with a molten solder including 0.05% by mass of nickel (Sn-3Ag-0.5Cu-0.05Ni-0.006Ge) for 5 seconds, and FIG. 26(D) depicts a case of a treatment with the same molten solder for 60 seconds.

As obvious from the results, when the solder treatment time was 5 seconds, corrosion of copper electrodes 2 was small regardless of the kind of the solder. On the electrodes was formed electrode corrosion preventing layer 4 with a thickness of around 2 µm. On the other hand, when the soldering treatment time was 60 seconds, although corrosion of copper electrodes 2 was confirmed regardless of the kind of the solder, both cases included nickel, so that the level of the corrosion was minor, and moreover, the initial electrode shape was almost maintained. However, from a cross-sectional observation thereof, it was confirmed that electrode corrosion preventing layer 4 was very thick (approximately around 5 µm) and the electrode shape was almost maintained by electrode corrosion preventing layer 4.

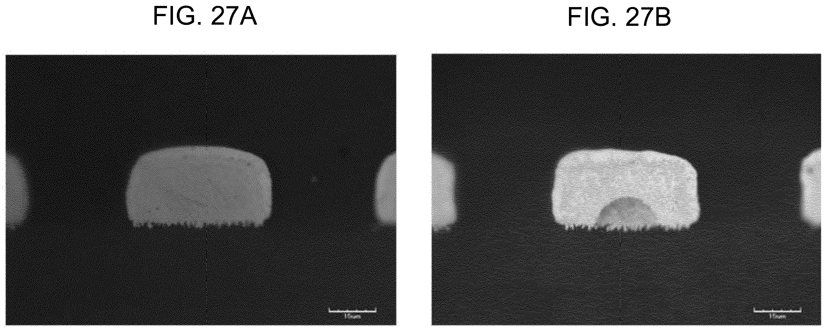

FIGs. 27(A) and (B) depict an example of treatments with molten solders including further increased nickel contents. Specifically, similarly to the above, FIGs. 27(A) and (B) are cross-sectional views of electrodes depicting the case in which, without performing the two-stage treatment (the adhesion treatment of first molten solder 5a and the adhesion treatment of second molten solder 16) on the prepared copper electrodes 2, one-time soldering treatment was performed on the electrodes and then excess solder was removed. FIG. 27(A) depicts a case of a treatment with a molten solder including 0.1% by mass of nickel (Sn-3Ag-0.5Cu-0.1Ni-0.006Ge) for 5 seconds, and FIG. 27(B) depicts a case of a treatment with the same molten solder for 60 seconds.

As obvious from the results, when the solder treatment time was 5 seconds, corrosion of copper electrodes 2 was small, and on the electrodes was formed electrode corrosion preventing layer 4 with a thickness of approximately 3 µm. On the other hand, when the soldering treatment time was 60 seconds, large corrosion of copper electrodes 2 was confirmed, although the initial electrode shape was almost maintained. A cross-sectional observation confirmed that electrode corrosion preventing layer 4 was very thick.

The results of FIGs. 25(A) to 27(C) confirmed that the adhesion treatments with molten solders including nickel allowed the formation of electrode corrosion preventing layer 4 made of a Cu-Ni-Sn intermetallic compound on copper electrodes 2, enabling the suppression of the corrosion of copper as the electrode component. However, even in that case, as the treatment time became longer, electrode corrosion preventing layer 4 was found to be thicker.

FIGs. 28(A) to FIGs. 29(D) are cross-sectional views of electrodes depicting an example in which the two-stage treatment (the adhesion treatment of first molten solder 5a and the adhesion treatment of second molten solder 16) was performed on the prepared copper electrodes 2, and each excess solder was removed after each soldering treatment. FIG. 28(A) depicts a case in which, after a treatment with a first molten solder including no nickel (Sn-3Ag-0.5Cu) for 3 seconds, a treatment with a second molten solder including 0.01% by mass of nickel (Sn-3Ag-0.5Cu-0.01Ni-0.006Ge) was performed for 5 seconds, and FIG. 28(B) depicts a case in which the treatment time for the second molten solder in FIG. 28(A) was changed to 60 seconds, In addition, FIG. 28(C) depicts a case in which, after a treatment with a first molten solder including no nickel (Sn-3Ag-0.5Cu) for 3 seconds, a treatment with a second molten solder including 0.03% by mass of nickel (Sn-3Ag-0.5Cu-0.03Ni-0.006Ge) was performed for 5 seconds, and FIG. 28(D) depicts a case in which the treatment time for the second molten solder in FIG. 28(C) was changed to 60 seconds.

FIG. 29(A) depicts a case in which after a treatment with a first molten solder including no nickel (Sn-3Ag-0.5Cu) for 3 seconds, a treatment with a second molten solder including 0.05% by mass of nickel (Sn-3Ag-0.5Cu-0.05Ni-0.006Ge) was performed for 5 seconds, and FIG. 29(B) depicts a case in which the treatment time for the second molten solder in FIG. 29(A) was changed to 60 seconds. In addition, FIG. 29(C) depicts a case in which, after a treatment with a first molten solder including no nickel (Sn-3Ag-0.5Cu) for 3 seconds, a treatment with a second molten solder including 0.1% by mass of nickel (Sn-3Ag-0.5Cu-0.1Ni-0.006Ge) was performed for 5 seconds, and FIG. 29(D) depicts a case in which the treatment time for the second molten solder in FIG. 29(C) was changed to 60 seconds.

These results obviously confirmed that even when the soldering treatment was 5 seconds, as the nickel content in the second molten solder was increased, the thickness of electrode corrosion preventing layer 4 formed on the copper electrodes became thicker and the corrosion of copper electrodes 2 became larger. Furthermore, also when the soldering treatment time was 60 seconds, the thickness of electrode corrosion preventing layer 4 formed on the copper electrodes was found to be thicker, with larger corrosion of copper electrodes 2.

FIGs. 30(A) to FIGs. 31(B) are cross-sectional views of electrodes depicting an example in which the two-stage treatment (the adhesion treatment of first molten solder 5a and the adhesion treatment of second molten solder 16) was performed on the prepared copper electrodes 2, and each excess solder was removed after each soldering treatment. FIG. 30(A) depicts a case in which, after a treatment with a first molten solder including 0.1% by mass of nickel (Sn-3Ag-0.5Cu-0.1Ni-0.006Ge) for 3 seconds, a treatment with a second molten solder including 0.01% by mass of nickel (Sn-3Ag-0.5Cu-0.01Ni-0.006Ge) was performed for 5 seconds, and FIG. 30(B) depicts a case in which the treatment time for the second molten solder in FIG. 30(A) was changed to 60 seconds. In addition, FIG. 30(C) depicts a case in which, after a treatment with a first molten solder including 0.1% by mass of nickel (Sn-3Ag-0.5Cu-0.1Ni-0.006Ge) for 3 seconds, a treatment with a second molten solder including 0.03% by mass of nickel (Sn-3Ag-0.5Cu-0.03Ni-0.006Ge) was performed for 5 seconds, and FIG. 30(D) depicts a case in which the treatment time for the second molten solder in FIG. 30(C) was changed to 60 seconds.

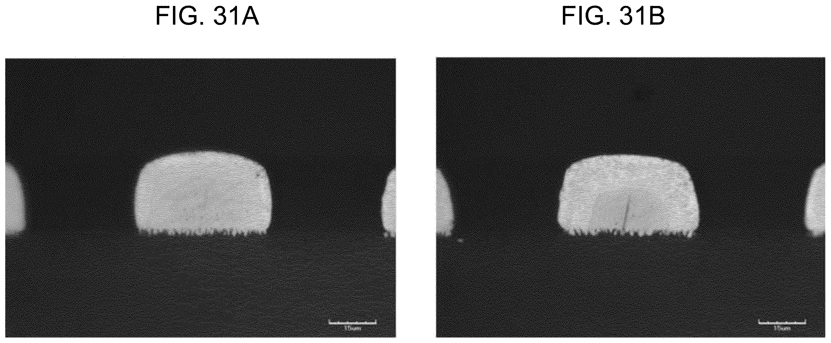

In addition, FIG. 31(A) depicts a case in which, after a treatment with a first molten solder including 0.1% by mass of nickel (Sn-3Ag-0.5Cu-0.1Ni-0.006Ge) for 3 seconds, a treatment with a second molten solder including 0.05% by mass of nickel (Sn-3Ag-0.5Cu-0.05Ni-0.006Ge) was performed for 5 seconds, and FIG. 31(B) depicts a case in which the treatment time for the second molten solder in FIG. 31(A) was changed to 60 seconds.

These results obviously confirmed that even in the case of first molten solder 5a including nickel, due to second molten solder 16 also including nickel, the thickness of electrode corrosion preventing layer 4 formed on the copper electrodes became thicker and the corrosion of copper electrodes 2 became larger. Furthermore, also when the soldering treatment time was 60 seconds, the thickness of electrode corrosion preventing layer 4 formed on the copper electrodes was found to be thicker, with larger the corrosion of copper electrodes 2.

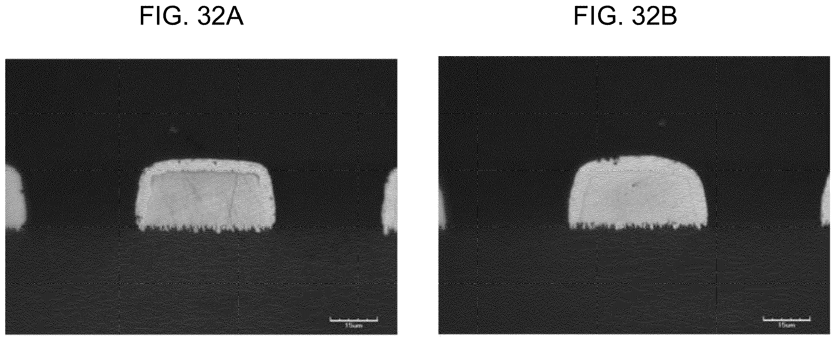

FIGs. 32(A) and (B) are cross-sectional views of electrodes depicting an example in which the two-stage treatment (the adhesion treatment of first molten solder 5a and the adhesion treatment of second molten solder 16) was performed on the prepared copper electrodes 2, and each excess solder was removed after each soldering treatment. FIG. 32(A) is a cross-sectional view of an electrode treated with a molten solder including 0.1% by mass of nickel for 3 seconds and then treated with a molten solder including no nickel for 5 seconds. FIG. 32(B) is a cross-sectional view of an electrode treated with a molten solder including 0.1% by mass of nickel for 3 seconds and then treated with a molten solder including no nickel for 60 seconds.

As obvious from these results, due to the inclusion of nickel in first molten solder 5a and the non-inclusion of nickel in second molten molder 16, regardless of whether the treatment time was 5 or 60 seconds, the thickness of electrode corrosion preventing layer 4 formed on the copper electrode was approximately 2 µm, roughly the same. In addition, corrosion of the copper electrode 2 was minimized and almost no change was seen as compared to the initial electrode shape shown in FIG. 24(D).

The results shown in FIGs. 25(A) to 27(B) indicate that in the one-stage treatment using a nickel-containing molten solder as first molten solder 5a and not using second molten solder 16, if the treatment time was short (for example, 5 seconds), the effect of the formed electrode corrosion preventing layer 4 allowed the suppression of corrosion of the copper electrodes to some extent, whereas if the treatment time was longer (for example, 60 seconds), corrosion of the copper electrodes proceeded even in the nickel-containing molten solders. In addition, the results shown in FIGs. 28(A) to 29(D) indicate that in the cases of first molten solder 5a including no nickel, even if second molten solder 16 included nickel, corrosion of the copper electrodes proceeded. Furthermore, the results shown in FIGs. 30(A) to 31(B) indicate that when both first molten solder 5a and second molten solder 16 included nickel, more effective results were obtained than those described above, but nevertheless, corrosion of the copper electrodes proceeded.

In contrast, it was shown that when first molten solder 5a included nickel (the component causing the electrode corrosion preventing ability in components forming electrode corrosion preventing layer 4) and second molten solder 16 included no nickel, the progress of copper electrode corrosion can be suppressed. The reason for this is that, by removing excess solder 5a and cooling (to less than the melting point of the solder) immediately after the adhesion of first molten solder 5a including nickel, it can be prevented that no cooling causes electrode corrosion and electrode corrosion preventing layer 4 becomes thick, so that electrode component corrosion can be stopped to allow for the formation of electrode corrosion preventing layer 4 with a predetermined thickness (0.5 to 3 µm). With the presence of such a thin electrode corrosion preventing layer 4 on electrodes, in the case of adhesion treatment with a second molten solder 16 including no nickel, progressive corrosion of the copper electrodes hardly occurs regardless of the length of the adhesion treatment time. This seems to be due to that nickel (the component causing the electrode corrosion preventing ability in components forming electrode corrosion preventing layer 4) included in electrode corrosion preventing layer 4 is stabilized and immobilized in electrode corrosion preventing layer 4. It has been shown that such a means can suppress the phenomenon of thickness increase in electrode corrosion preventing layer 4. In this Example, molten solders were used, but solder paste cases have also been found to be the same.

### [Example 12]

In the adhesion step according to the first embodiment shown in FIG. 5, first molten solder liquid flow 5a was allowed to collide with component 10' (mounting substrate) having a shape shown in FIGs. 9(A) to (D). As the first molten solder, there was used an Sn-Cu-Ni based solder having a density of approximately 7.3 g/cm³ and including 0.05% by mass of Ni. The first molten solder liquid flow 5a was stored in storage bath 58 arranged in the upper position. The molten solder liquid flow 5a in storage bath 58 was vertically dropped through pipe 57, turned to the component side at direction-changing portion 56, and then vigorously collided with electrode 2. Storage bath 58 was arranged at a height allowing the pressure of the vertically dropped molten solder liquid flow 5a to be approximately 2 Pa. At a nozzle angle *θ* of approximately 15°C upon collision and with a distance to the electrode of 30 mm, the molten solder liquid flow was allowed to collide with electrode 2 from a lateral direction. Then, a component of Example 12 was obtained in the same manner as Example 1 except for this adhesion step.

This Example allowed molten solder liquid flow 5a to be collided with electrode 2 without excessive deceleration of the speed of the molten solder liquid flow 5a. As a result, the molten solder liquid flow 5a was able to be fully contacted with the entire surface of electrode 2, consequently enabling electrode corrosion preventing layer 4 to be uniformly formed on electrode 2.

The component including electrode corrosion preventing layer 4 on the electrodes was dipped (immersed) in a solder bath filled with second molten solder 16 set at 250°C. As second molten solder 16, a lead-free solder consisting of Cu: 0.5% by mass, Ge: 0.006% by mass, and Sn for the rest was used. The second molten solder 16 including no nickel was adhered onto the electrodes provided with the thin electrode corrosion preventing layer 4 including nickel. As a result, there hardly occurred a difference in the progress of copper electrode corrosion between individual portions of the component. In addition, even in a case of using solder alloy including no silver, sufficient solder wettability was exhibited and a favorable second solder layer was able to be formed.

### [Example 13]

A component of Example 13 was obtained in the same manner as Example 12, except for using an Sn-Cu-Ge-Ni based solder having a density of approximately 7.3 g/cm³ and including 0.05% by mass of Ni. This Example allowed molten solder liquid flow 5a to be collided with electrodes 2 without excessive deceleration of the speed of the molten solder liquid flow 5a. As a result, the molten solder liquid flow 5a was able to be fully contacted with the entire surfaces of electrodes 2, consequently enabling electrode corrosion preventing layer 4 to be uniformly formed on the electrodes 2.

The component including electrode corrosion preventing layer 4 formed on electrodes was treated in the same manner as Example 12, whereby second molten solder 16 including no nickel was adhered onto the electrodes provided with the thin electrode corrosion preventing layer 4 including nickel. As a result, the difference in the progress of copper electrode corrosion between individual portions of the component hardly occurred. In addition, even in a case of using solder alloy including no silver, sufficient solder wettability was exhibited, which enabled a favorable second solder layer to be formed.

### [Example 14]

In the adhesion step according to the first embodiment shown in FIG. 6, first molten solder liquid flow 5a was collided with component 10' (mounting substrate) having the shape shown in FIGs. 9(A) to (D). As the first molten solder, there was used an Sn-Cu-Ni based solder having the density of approximately 7.3 g/cm³ and including 0.05% by mass of Ni. The first molten solder liquid flow 5a was drawn up by a pump from storage bath 58 arranged in a lower position and vigorously collided with electrode 2. An adjustment was made such that the pressure of the molten solder liquid flow 5a was approximately 2 Pa. At the nozzle angle *θ* of approximately 15°C upon collision and with the distance to the electrode of 30 mm, the molten solder liquid flow was allowed to collide with electrode 2 from the lateral direction. Then, a component of Example 14 was obtained in the same manner as Example 1 except for this adhesion step.

This Example allowed the molten solder liquid flow 5a to be collided with electrodes 2 without excessive deceleration of the speed of the molten solder liquid flow 5a. As a result, the molten solder liquid flow 5a was able to be fully contacted with the entire surfaces of the electrodes 2, consequently enabling electrode corrosion preventing layer 4 to be uniformly formed on the electrodes 2. Next, the component having electrode corrosion preventing layer 4 formed on the electrodes was treated in the same manner as Example 12, whereby second molten solder 16 including no nickel was adhered onto the electrodes provided with the thin electrode corrosion preventing layer 4 including nickel. As a result, the difference in the progress of copper electrode corrosion between the individual portions of the component hardly occurred. In addition, even in a case of using solder alloy including no silver, sufficient solder wettability was exhibited, which enabled a favorable second solder layer to be formed.

### [Example 15]

In the adhesion step according to the third embodiment shown in FIGs. 7(A) to (C), first molten solder 5a was spread over component 10' (mounting substrate) having the shape shown in FIGs. 9(A) to (D) utilizing a surface tension phenomenon. As the first molten solder, there was used an Sn-Cu-Ni based solder having the density of approximately 7.3 g/cm³ and including 0.05% by mass of Ni. First molten solder 5a was filled in solder bath 52. The component was immersed through slit 51 provided in an upper surface of the solder bath 52, and then, while pulling it up, component 10' was allowed to pass through slit 51 arranged on liquid surface 53 of first molten solder 5a. In addition, gaps g1 and g2 from the surface of component 10' to the ends of slit 51 were set to approximately 1 mm. Then, a component of Example 15 was obtained in the same manner as Example 1 except for this adhesion step.

Through the process, due to the effect of surface tension occurring when component 10' passed through slit 51, the molten solder 5a spread over the entire region of electrodes 2. This Example allowed the molten solder 5a to be fully contacted with the entire surfaces of electrodes 2, consequently enabling electrode corrosion preventing layer 4 to be uniformly formed on the electrodes 2. Next, the component including electrode corrosion preventing layer 4 formed on the electrodes was treated in the same manner as Example 12, whereby second molten solder 16 including no nickel was adhered onto the electrodes provided with the thin electrode corrosion preventing layer 4 including nickel. As a result, the difference in the progress of copper electrode corrosion between the individual portions of the component hardly occurred. In addition, even in a case of using solder alloy including no silver, sufficient solder wettability was exhibited, which enabled a favorable second solder layer to be formed.

### Description of the Reference Numerals

1 Substrate
2 Electrode
3 Coating film
3a First organic fatty acid-containing solution (gas or liquid)
4 Electrode corrosion preventing layer (Cu-Ni-Sn compound layer)
5 Solder layer (first solder layer)
5a First molten solder
6 Coating film
6a Gas or liquid of second organic fatty acid-containing solution
6b Gaseous atmosphere or liquid of second organic fatty acid-containing
7 Cu-Sn compound layer
8 Solder layer (second solder layer)
9 Coating layer
10, 10A, 10B Component having an electrode corrosion preventing layer (component before forming the solder layer)
10' Component having an electrode corrosion preventing layer
11, 12, 13 Ejecting nozzle
14 Gas flow of an inert gas or air
16 Second molten solder
18 Second organic fatty acid-containing solution
20 Mounting substrate after forming the solder layer
21 Electrode pad
30, 40, 40A, 40B Mounting substrate after forming the solder layer
51 Slit
52 First molten solder bath
53 Surface of the molten solder
55 Nozzle tip
56 Direction-changing portion for the pipe
57 Pipe for
58 Liquid flow of the molten solder
59 Storage bath
61,62 Wedge
63 Center position
80 Insulation film
W Electrode width
T Height of the solder layer
g1, g2 Gap between the component and slit
T Thickness of the slit

**Table 1-1**

| | Contact Step | | First Adhesion Step | | | Removal Step | |
|---|---|---|---|---|---|---|---|
| | component content | temperature °C | Ni % by mass | purification | temperature °C | means | temperature °C |
| Example 1 | palmitic acid 10% by mass | 150 | 0.05 | With | 250 | ejection of liquid flow | 250 |
| Example 2 | palmitic acid 10% by mass | 150 | 0.05 | With | 250 | ejection of liquid flow | 250 |
| Example 3 | palmitic acid 10% by mass | 150 | 0.05 | With | 250 | ejection of nitrogen gas | 250 |
| Example 4 | palmitic acid 10% by mass | 150 | 0.05 | With | 250 | ejection of nitrogen gas | 250 |
| Example 5 | palmitic acid 10% by mass | 100 | 0.1 | With | 250 | ejection of air | 250 |
| Example 6 | palmitic acid 10% by mass | 100 | 0.1 | With | 250 | ejection of air | 250 |
| Example 7 | palmitic acid 10% by mass | 200 | 0.01 | With | 250 | ejection of air | 250 |
| Example 8 | palmitic acid 10% by mass | 200 | 0.01 | With | 250 | ejection of air | 250 |
| Example 9 | palmitic acid 10% by mass | 200 | 0.07 | Without | 250 | ejection of air | 250 |
| Example 10 | palmitic acid 10% by mass | 200 | 0.07 | Without | 250 | ejection of air | 250 |
| Comparative Example 1 | palmitic acid 10% by mass | 150 | 0 | With | 250 | ejection of liquid flow | 250 |

**Table 1-2**

| | Cooling Step | | | First Adhesion Step | | | |
|---|---|---|---|---|---|---|---|
| | means | temperature °C | Time sec | Ni % by mass | purification | temperature °C | Time sec |
| Example 1 | spraying an air flow | 200 | 10 | - | - | - | - |
| Example 2 | spraying an air flow | 200 | 10 | 0 | With | 250 | 10 |
| Example 3 | spraying an air flow | 200 | 10 | - | - | - | - |
| Example 4 | spraying an air flow | 200 | 10 | 0 | With | 250 | 10 |
| Example 5 | spraying an air flow | 150 | 10 | - | - | - | - |
| Example 6 | spraying an air flow | 150 | 10 | 0 | With | 250 | 20 |
| Example 7 | spraying an air flow | 100 | 10 | - | - | - | - |
| Example 8 | spraying an air flow | 100 | 10 | 0 | With | 250 | 20 |
| Example 9 | spraying an air flow | 100 | 10 | - | - | - | - |
| Example 10 | spraying an air flow | 100 | 10 | 0 | With | 250 | 20 |
| Comparative Example 1 | spraying an air flow, | 200 | 10 | - | - | - | - |

**Table 2**

| | degree of electrode corrosion | thickness of electrode corrosion preventing layer | T(thickness of solder layer) / W(width of electrode) |
|---|---|---|---|
| Example 1 | small | About 1.5µm | - |
| Example 2 | small | About 1.5µm | 0.4 |
| Example 3 | small | About 1.5µm | - |
| Example 4 | small | About 1.5µm | 0.4 |
| Example 5 | small | About 3µm | - |
| Example 6 | small | About 3µm | 0.6 |
| Example 7 | small | About 1µm | - |
| Example 8 | small | About 1µm | 0.3 |
| Example 9 | small | About 2µm | - |
| Example 10 | small | About 2µm | 0.5 |
| Comparative Example 1 | large | - | - |

## Claims

1. A method for manufacturing a component (10'), comprising:
a step of preparing a component (10') having an electrode (2) that is to be soldered;
a step of contacting a first organic fatty acid-containing solution (3a) with the electrode (2);
a step of adhering a first molten solder (5a) onto the electrode (2) by contacting the first molten solder (5a) with the electrode (2);
a step of ejecting a flow (14) to the adhered first molten solder (5a) to remove an excess first molten solder (5a) in the first molten solder (5a) adhered onto the electrode (2); and
a step of cooling the electrode (2) from which the excess first molten solder (5a) has been removed to less than a melting point of the first molten solder (5a), and wherein
in the step of adhering the first molten solder (5a), the first molten solder (5a) includes a component forming an electrode corrosion preventing layer (4) made of an intermetallic compound layer comprising Cu, Ni and Sn on a surface of the electrode (2) by reacting with a component included in the electrode (2),
**characterized in that**
in the step of adhering the first molten solder (5a), the contact of the first molten solder (5a) with the electrode (2) is performed by allowing a liquid flow of the first molten solder (5a) to collide with the electrode (2), the liquid flow of the first molten solder (5a) being applied diagonally from an upper direction by a predetermined angle θ at a collision pressure of 0.5 to 4.0 Pa while moving the component (10'); and
in the step of ejecting a flow to the adhered first molten solder (5a), the flow (14) is a gas flow of an inert gas or air being heated and ejected from a nozzle (13) while placing the component (10') under a steam atmosphere containing a gas of a second organic fatty acid-containing solution (6b) that is the same solution as the first organic fatty acid-containing solution (3a).

2. The method for manufacturing a component according to claim 1, wherein the contact of the first molten solder (5a) with the electrode (2) is performed by allowing the first molten solder (5a) liquid flow to collide with the component (10') from above the component (10') at a predetermined angle, while moving the component (10') in a lateral direction.

3. The method for manufacturing a component according to claim 1 or 2, further comprising a step of contacting the component (10') with the same molten solder as or a different molten solder from the first molten solder (5a) in order to adhere a second molten solder onto the electrode (2) after the step of cooling the electrode (2) to less than the melting point of the first molten solder (5a).

4. The method for manufacturing a component according to claim 3, wherein the second molten solder does not include a component causing an electrode corrosion preventing ability among components forming the electrode corrosion preventing layer.

5. The method for manufacturing a component according to any one of claims 1 to 4, wherein the first molten solder has a viscosity of 0.002 Pa· s to 0.004 Pa·s.

6. The method for manufacturing a component according to claim 3 or 4, wherein the second molten solder has a viscosity of 0.002 Pa·s to 0.008 Pa·s.

7. The method for manufacturing a component according to any one of claims 3 to 6, wherein the first molten solder and the second molten solder are mixed with the organic fatty acid-containing solution for use.

8. The method for manufacturing a component according to any one of claims 3 to 7, further comprising a step of contacting a gas or liquid of a third organic fatty acid-containing solution with the second molten solder after the step of adhering the second molten solder.

9. The method for manufacturing a component according to any one of claims 1 to 8, wherein the component is any selected from a printed circuit board, a wafer, and a flexible substrate that have microwiring patterns or any selected from a chip, a resistor, a capacitor, and a filter.

## Patentansprüche

1. Verfahren zum Herstellen einer Komponente (10'), umfassend:
einen Schritt des Vorbereitens einer Komponente (10'), die eine Elektrode (2) aufweist, die gelötet werden soll;
einen Schritt des Kontaktierens einer ersten organischen fettsäurehaltigen Lösung (3a) mit der Elektrode (2);
einen Schritt des Anhaftens eines ersten geschmolzenen Lotes (5a) an die Elektrode (2) durch Kontaktieren des ersten geschmolzenen Lotes (5a) mit der Elektrode (2);
einen Schritt des Ausstoßens eines Stroms (14) zu dem angehafteten ersten geschmolzenen Lot (5a), um ein überschüssiges erstes geschmolzenes Lot (5a) in dem an der Elektrode (2) angehafteten ersten geschmolzenen Lot (5a) zu entfernen; und
einen Schritt des Abkühlens der Elektrode (2), von welcher das überschüssige erste geschmolzene Lot (5a) entfernt worden ist, auf weniger als einen Schmelzpunkt des ersten geschmolzenen Lotes (5a), und wobei
im Schritt des Anhaftens des ersten geschmolzenen Lotes (5a) das erste geschmolzene Lot (5a) eine Komponente beinhaltet, die eine Elektrodenkorrosionsschutzschicht (4) aus einer Cu, Ni und Sn umfassenden intermetallischen Verbundschicht auf einer Oberfläche der Elektrode (2) bildet, indem es mit einer in der Elektrode (2) enthaltenen Komponente reagiert,
**dadurch gekennzeichnet, dass**
im Schritt des Anhaftens des ersten geschmolzenen Lotes (5a) der Kontakt des ersten geschmolzenen Lotes (5a) mit der Elektrode (2) durchgeführt wird, indem es einem Flüssigkeitsstrom des ersten geschmolzenen Lotes (5a) ermöglicht wird, mit der Elektrode (2) zu kollidieren, wobei der Flüssigkeitsstrom des ersten geschmolzenen Lotes (5a) diagonal aus einer oberen Richtung in einem vorbestimmten Winkel θ bei einem Kollisionsdruck von 0,5 bis 4,0 Pa aufgebracht wird, während die Komponente (10') bewegt wird; und
im Schritt des Ausstoßens eines Stroms zu dem angehafteten ersten geschmolzenen Lot (5a) der Strom (14) ein Gasstrom eines Inertgases oder Luft ist, der erwärmt und aus einer Düse (13) ausgestoßen wird, während die Komponente (10') unter einer Dampfatmosphäre platziert wird, die ein Gas einer zweiten organischen fettsäurehaltigen Lösung (6b) enthält, die die gleiche Lösung wie die erste organische fettsäurehaltige Lösung (3a) ist.

2. Verfahren zum Herstellen einer Komponente nach Anspruch 1, wobei der Kontakt des ersten geschmolzenen Lotes (5a) mit der Elektrode (2) durchgeführt wird, indem es dem Flüssigkeitsstrom des ersten geschmolzenen Lotes (5a) ermöglicht wird, mit der Komponente (10') von oberhalb der Komponente (10') in einem vorbestimmten Winkel zu kollidieren, während die Komponente (10') in einer seitlichen Richtung bewegt wird.

3. Verfahren zum Herstellen einer Komponente nach Anspruch 1 oder 2, des Weiteren umfassend einen Schritt des Kontaktierens der Komponente (10') mit dem gleichen geschmolzenen Lot wie oder einem anderen geschmolzenen Lot als das erste geschmolzene Lot (5a), um ein zweites geschmolzenes Lot an der Elektrode (2) nach dem Schritt des Abkühlens der Elektrode (2) auf weniger als den Schmelzpunkt des ersten geschmolzenen Lotes (5a) anzuhaften.

4. Verfahren zum Herstellen einer Komponente nach Anspruch 3, wobei das zweite geschmolzene Lot keine Komponente beinhaltet, die eine Elektrodenkorrosionsschutzfähigkeit bewirkt, unter Komponenten, die die Elektrodenkorrosionsschutzschicht bilden.

5. Verfahren zum Herstellen einer Komponente nach einem der Ansprüche 1 bis 4, wobei das erste geschmolzene Lot eine Viskosität von 0,002 Pa • s bis 0,004 Pa • s aufweist.

6. Verfahren zum Herstellen einer Komponente nach Anspruch 3 oder 4,
wobei das zweite geschmolzene Lot eine Viskosität von 0,002 Pa • s bis 0,008 Pa • s aufweist.

7. Verfahren zum Herstellen einer Komponente nach einem der Ansprüche 3 bis 6, wobei das erste geschmolzene Lot und das zweite geschmolzene Lot mit der organischen fettsäurehaltigen Lösung zur Verwendung vermischt werden.

8. Verfahren zum Herstellen einer Komponente nach einem der Ansprüche 3 bis 7, des Weiteren umfassend einen Schritt des Kontaktierens eines Gases oder einer Flüssigkeit einer dritten organischen fettsäurehaltigen Lösung mit dem zweiten geschmolzenen Lot nach dem Schritt des Anhaftens des zweiten geschmolzenen Lotes.

9. Verfahren zum Herstellen einer Komponente nach einem der Ansprüche 1 bis 8, wobei die Komponente eine beliebige ausgewählt ist aus einer Leiterplatte, einem Wafer und einem flexiblen Substrat, die Mikroverdrahtungsmuster aufweisen, oder eine beliebige ausgewählt aus einem Chip, einem Widerstand, einem Kondensator und einem Filter.

## Revendications

1. Procédé de fabrication d'un composant (10'), comprenant :
une étape pour préparer un composant (10') présentant une électrode (2) laquelle doit être brasée ;
une étape de mise en contact d'une première solution contenant un acide gras organique (3a) avec l'électrode (2) ;
une étape pour faire adhérer une première brasure fondue (5a) sur l'électrode (2) par mise en contact de la première brasure fondue (5a) avec l'électrode (2) ;
une étape pour éjecter un flux (14) vers la première brasure fondue ayant adhéré (5a) pour éliminer une première brasure fondue en surplus (5a) dans la première brasure fondue (5a) ayant adhéré sur l'électrode (2), et
une étape de refroidissement de l'électrode (2) à partir de laquelle la première brasure fondue en surplus (5a) a été éliminée à une température inférieure à un point de fusion de la première brasure fondue (5a), et dans lequel
lors de l'étape pour faire adhérer la première brasure fondue (5a), la première brasure fondue (5a) inclut un composant formant une couche de prévention contre la corrosion d'électrode (4) fabriqué dans une couche de composé intermétallique comprenant du Cu, Ni et Sn sur une surface de l'électrode (2) en faisant réagir un composant inclus dans l'électrode (2),
**caractérisé en ce que**
lors de l'étape pour faire adhérer la première brasure fondue (5a), le contact de la première brasure fondue (5a) avec l'électrode (2) est réalisé en permettant à un flux liquide de la première brasure fondue (5a) d'entrer en collision avec l'électrode (2), le flux liquide de la première brasure fondue (5a) étant appliqué diagonalement à partir d'une direction supérieure par un angle prédéterminé θ à une pression de collision allant de 0,5 à 4,0 Pa tout en déplaçant le composant (10'), et
lors de l'étape d'éjection d'un flux vers la première brasure fondue ayant adhéré (5a), le flux (14) est un flux gazeux d'un gaz inerte ou de l'air chauffé et éjecté à partir d'une buse (13) tout en plaçant le composant (10') sous un atmosphère de vapeur contenant un gaz d'une deuxième solution contenant un acide gras organique (6b), laquelle est la même solution que la première solution contenant un acide gras organique (3a).

2. Procédé de fabrication d'un composant selon la revendication 1, dans lequel le contact de la première brasure fondue (5a) avec l'électrode (2) est réalisé en permettant au flux liquide de la première brasure fondue (5a) d'entrer en collision avec le composant (10') par le dessus le composant (10') suivant un angle prédéterminé, tout en déplaçant le composant (10') dans une direction latérale.

3. Procédé de fabrication d'un composant selon la revendication 1 ou 2, comprenant une étape pour mettre en contact le composant (10') avec la même brasure fondue ou une brasure fondue différente de la première brasure fondue (5a) afin de faire adhérer une seconde brasure fondue sur l'électrode (2), après l'étape de refroidissement de l'électrode (2) à une température inférieure à un point de fusion de la première brasure fondue (5a).

4. Procédé de fabrication d'un composant selon la revendication 3, dans lequel la seconde brasure fondue n'inclut pas un composant entraînant une aptitude à empêcher une corrosion d'électrode parmi les composants formant la couche de prévention contre la corrosion d'électrode.

5. Procédé de fabrication d'un composant selon l'une quelconque des revendications 1 à 4, dans lequel la première brasure fondue présente une viscosité de 0,002 Pa·s à 0,004 Pa·s.

6. Procédé de fabrication d'un composant selon la revendication 3 ou 4, dans lequel la seconde brasure fondue présente une viscosité de 0,002 Pas à 0,008 Pa·s.

7. Procédé de fabrication d'un composant selon l'une quelconque des revendications 3 à 6, dans lequel la première brasure fondue et la seconde brasure fondue sont mélangées avec la solution contenant un acide gras organique à utiliser.

8. Procédé de fabrication d'un composant selon l'une quelconque des revendications 3 à 7, comprenant en outre une étape de mise en contact d'un gaz ou liquide d'une troisième solution contenant un acide gras organique avec la seconde brasure fondue après l'étape pour faire adhérer la seconde brasure fondue.

9. Procédé de fabrication d'un composant selon l'une quelconque des revendications 1 à 8, dans lequel le composant est un élément quelconque sélectionné parmi une carte de circuit imprimé, une tranche, et un substrat flexible, lesquels présentent des motifs de microcâblage, ou un élément quelconque sélectionné parmi une puce, une résistance, un condensateur, et un filtre.
